(19) Europäisches Patentamt
European Patent Office
Office européen des brevets

(11) EP 1 801 648 A1

(12) EUROPEAN PATENT APPLICATION
published in accordance with Art. 158(3) EPC

(43) Date of publication:
**27.06.2007 Bulletin 2007/26**

(21) Application number: **05780499.9**

(22) Date of filing: **16.08.2005**

(51) Int Cl.:
***G03F 7/00*** (2006.01) ***G03F 7/11*** (2006.01)
***G03F 7/20*** (2006.01) ***G02B 5/20*** (2006.01)
***H01L 21/027*** (2006.01)

(86) International application number:
**PCT/JP2005/014937**

(87) International publication number:
**WO 2006/019089 (23.02.2006 Gazette 2006/08)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **17.08.2004 JP 2004237583**
**05.11.2004 JP 2004322984**

(71) Applicant: **FUJIFILM Corporation**
**Minato-ku**
**Tokyo 106-8620 (JP)**

(72) Inventor: **IWASAKI, Masayuki**
**Fujinomiya-shi, Shizuoka 4188666 (JP)**

(74) Representative: **HOFFMANN EITLE**
**Patent- und Rechtsanwälte**
**Arabellastrasse 4**
**81925 München (DE)**

# (54) PHOTOSENSITIVE TRANSFER MATERIAL AND PATTERN FORMING METHOD AND PATTERN

(57) The present invention aims to provide a photosensitive transfer material which allows for preventing light fog under safelight even with a highly sensitive photosensitive transfer layer, and is particularly preferably used in producing printed circuit boards and color filters for liquid crystal displays (LCDs).

For this end, the present invention provides a photosensitive layer having a support, and a cushion layer, an oxygen insulation layer, and a photosensitive layer formed on the support, at least any one of the cushion layer and the oxygen insulation layer has light absorbing properties of which absorbance at a wavelength ranging from 500 nm to 600 nm is 1 or more and absorbance at a wavelength ranging from 350 nm to 450 nm is 0.3 or less.

In the photosensitive transfer material, at least any one of the oxygen insulation layer and the cushion layer contains a dye.

FIG. 1

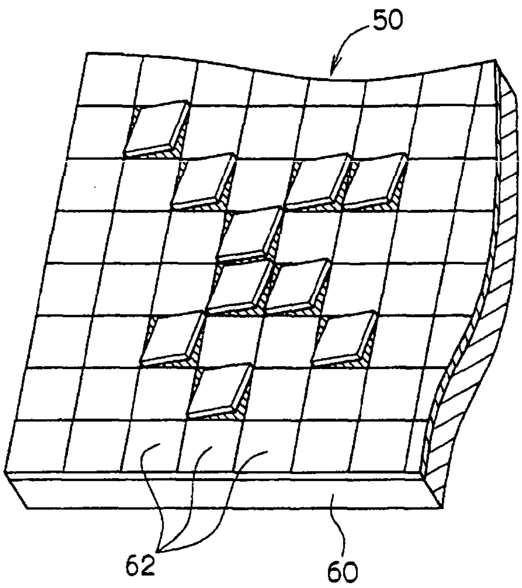


EP 1 801 648 A1

## Description

Technical Field

The present invention relates to a photosensitive transfer material which can be particularly preferably used in producing printed circuit boards and color filters for liquid crystal displays, and a pattern forming process, and patterns.

Background Art

Conventionally, photosensitive transfer materials are widely used for photo resists for forming circuits, solder resists, interlayer insulating films, and color resists for producing color filters for liquid crystal displays, and necessary patterns are formed by photolithography process.

In the meanwhile, as exposing units used to perform the photolithography process, exposing devices using a photo mask are known. With further refinement of the patterns, problems with pattern displacement which is attributable to expansion caused by temperature change and humidity change of photomask films in the course of production process become more evident. As a means to solve the problems with pattern displacement, photomasks (hereinafter, may be referred to as "glass mask") each of which are formed on a less-deformed and expensive glass support have been used.

However, even if the glass mask is used, there are still problems with decreases in process yields which are caused by contamination of photomasks in the course of photography process.

In recent years, as a means to solve problems with decreases in production yields attributable to pattern displacement and contamination of photomasks, an exposing device based on a laser direct imaging (hereinafter, may be referred to "LDI") system has been studied, which is configured to pattern a photosensitive layer by directly scanning the photosensitive layer with the use of a laser beam in ultraviolet ray regions to visible regions such as semiconductor lasers and gas lasers.

As the exposing device based on LDI system, exposing devices are known in the art (see Non-Patent Literature 1 and Patent Literature 1, for example), each of which is provided with a spacial light modulator configured to modulate a light beam from a light irradiating unit according to respective control signals by means of a light modulating unit which has "n" imaging portions which can receive the laser beam from the light irradiation unit having a laser beam light source and output the laser beam; a magnified-image forming optical system to magnify an image based on the laser beam modulated by the spacial light modulator; an microlens array having an array of microlenses corresponding to respective imaging portions of the spacial light modulator which is arranged on an image-forming surface in the magnified-image forming optical system; and an image forming optical system configured to form the light beam passed through the microlens array into an image on a pattern forming material or a screen.

According to the exposing device based on LDI system, even when the size of an image projected on a pattern forming material and a screen is magnified, light beams from respective imaging portions of the spacial light modulator are collected by respective microlenses of an microlens array, and the image size (spot size) in the projected image is retrogradely narrowed down to be kept in a small size, and thus the image sharpness can be kept higher.

As the above-noted spacial light modulator, a digital micromirror device (DMD) is known as imaging portions in which a number of micro mirrors capable of changing the angle of each reflecting surface thereof based on control signals are two-dimensionally arrayed on a semiconductor support such as a silicon (see Patent Literature 2).

Further, an exposing device is proposed, which is configured such that an aperture plate having apertures corresponding to respective microlenses of a microlens array is arranged at the rear side of the microlens array to allow passage of only the light beam passed through the corresponding microlenses through to the apertures in the above noted conventional exposing device (see Patent Literature 3).

However, since a photosensitive transfer material which can be processed with a blue-ultraviolet ray laser having a wavelength of 395 nm to 415 nm has a considerably higher sensitivity than those of conventional photosensitive transfer materials, and the sensitivity is about 10 times as high as those of the conventional ones, the photosensitive transfer material is likely to photoreact with safelight and is likely to cause troubles so-called light fog. Thus, it is desired to solve such troubles.

Patent Literature 1 Japanese Patent Application Laid-Open (JP-A) No. 2004-1244
Patent Literature 2 Japanese Patent Application Laid-Open (JP-A) No. 2001-305663
Patent Literature 3 Japanese Patent Application Laid-Open (JP-A) No. 2001-500628
Non Patent Literature 1 "Shortening Developing Time and Application of Mass Production by means of Maskless Exposure" in "Electronics Implementation Technology" No. 6 of Vol. 18 on pp. 74-79 issued by Gicho Publishing & Advertising Co., Ltd. in 2002

Disclosure of the Invention

The present invention is proposed in consideration of the current circumstances and aims to solve various problems set forth above and to achieve the following objects. Namely, the present invention aims to provide a photosensitive transfer material which has at least any one of an oxygen insulation layer and a cushion layer having light absorbing properties of which the absorbance at a wavelength ranging from 500 nm to 600 nm is 1 or more and the absorbance at a wavelength ranging from 350 nm to 450 nm is 0.3 or less, on a support, allows for preventing light fog under safelight even when the photosensitive transfer material has a highly sensitive photosensitive layer, and is particularly preferably used in producing printed circuit boards and color filters for liquid crystal displays (LCDs), and a pattern forming process, and patterns.

The means to solve the problems set forth above are as follows:

< 1 > A photosensitive transfer material which contains a support, an oxygen insulation layer, and a photosensitive layer, the oxygen insulation layer being formed on the support, and the photosensitive layer being formed on the oxygen insulation layer, wherein the oxygen insulation layer has light absorbing properties of which the absorbance at a wavelength ranging from 500 nm to 600 nm is 1 or more and the absorbance at a wavelength ranging from 350 nm to 450 nm is 0.3 or less.

Since the photosensitive transfer material according to the item < 1 > has an oxygen insulation layer having light absorbing properties of which the absorbance at a wavelength ranging from 500 nm to 450 nm is 1 or more and the absorbance at a wavelength ranging from 350 nm to 450 nm is 0.3 or less, the photosensitive transfer material can prevent light fog under safelight even when it has a highly sensitive photosensitive layer.

< 2 > A photosensitive transfer material which contains a support, a cushion layer, and a photosensitive layer, the cushion layer being formed on the support, and the photosensitive layer being formed on the photosensitive layer, wherein the cushion layer has light absorbing properties of which the absorbance at a wavelength ranging from 500 nm to 600 nm is 1 or more and the absorbance at a wavelength ranging from 350 nm to 450 nm is 0.3 or less.

Since the photosensitive transfer material according to the item < 2 > has a cushion layer having light absorbing properties of which the absorbance at a wavelength ranging from 500 nm to 600 nm is 1 or more and the absorbance at a wavelength ranging from 350 nm to 450 nm is 0.3 or less, the photosensitive transfer material can prevent light fog under safelight even when it has a highly sensitive photosensitive layer.

< 3 > A photosensitive transfer material which contains a support, a cushion layer, an oxygen insulation layer, and a photosensitive layer, the cushion layer, oxygen insulation layer, and photosensitive layer being disposed on or above the support in this order, wherein at least any one of the cushion layer and the oxygen insulation layer has light absorbing properties of which the absorbance at a wavelength ranging from 500 nm to 600 nm is 1 or more and the absorbance at a wavelength ranging from 350 nm to 450 nm is 0.3 or less.

< 4 > The photosensitive transfer material according to any one of the items < 1 > and < 3 >, wherein the oxygen insulation layer contains a water soluble polymer and a dye.

< 5 > The photosensitive transfer material according to any one of the items < 2 > and < 3 >, wherein the cushion layer contains a dye.

< 6 > The photosensitive transfer material according to any one of the items < 1 > to < 5 > being formed in a roll configuration such that the photosensitive layer faces inward.

< 7 > The photosensitive transfer material according to any one of the items < 1 > to < 5 > being formed in a laminate sheet configuration.

< 8 > The photosensitive transfer material according to any one of the items < 1 > to < 7 >, wherein after a light beam from a light irradiation unit is modulated by a light modulating unit having "n" imaging portions which can receive the laser beam from the light irradiating unit and can output the laser beam, the photosensitive layer is exposed with the light beam passed through a microlens array having an array of microlenses each having a non-spherical surface capable of compensating the aberration due to distortion at irradiating surfaces of the imaging portions in the light modulating unit.

< 9 > A pattern forming process which includes forming a photosensitive layer by transferring a photosensitive transfer material according to any one of the items < 1 > to < 8 > onto a surface of a substrate under at least any one of heating and pressurizing conditions and laminating the photosensitive transfer material on the substrate surface, and exposing and developing the photosensitive layer.

< 10 > The pattern forming process according to the item < 9 > used for forming an interconnection pattern.

< 11 > The pattern forming process according to the item < 9 > used for forming a solder resist pattern.

< 12 > The pattern forming process according to the item < 9 > used for forming an interlayer insulation film pattern.

< 13 > The pattern forming process according to the item < 9 >, wherein photosensitive compositions respectively colored in at least primary three colors of R, G, and B are used at a predetermined configuration on the substrate surface, and the photosensitive compositions are respectively subjected to formation of a photosensitive layer,

exposing, and developing sequentially in a repeated manner for each color to thereby form a color filter.

< 14 > The pattern forming process according to any one of the items < 9 > to < 13 >, wherein the photosensitive layer is exposed using a light irradiation unit configured to irradiate a target with a light beam, and a light modulating unit configured to modulate the light beam emitted from the light irradiation unit.

< 15 > The pattern forming process according to the item <14 >, wherein the light modulating unit is further equipped with a pattern signal generating unit configured to generate control signals based on the information of a pattern to be formed to thereby modulate the light beam emitted from the light irradiating unit according to the control signals generated by the pattern signal generating unit.

< 16 > The pattern forming process according to any one of the items < 14 > to < 15 >, wherein the light modulating unit is able to control any imaging portions of less than arbitrarily selected "n" imaging portions disposed successively from among the "n" imaging portions depending on the information of a pattern to be formed.

< 17 > The pattern forming process according to any one of the items < 14 > to < 16 >, wherein the light modulating unit is a spatial light modulator.

< 18 > The pattern forming process according to the item < 17 >, wherein the spatial light modulator is a digital micromirror device (DMD).

< 19 > A pattern, formed by a pattern forming process according to any one of the items < 9 > to <18 >.

The present invention can solve the conventional problems and provide a photosensitive transfer material which allows for preventing light fog under safelight even when it has a highly sensitive photosensitive layer by providing with at least a support, and a cushion layer, an oxygen insulation layer, and a photosensitive layer formed in this order on or above the support, and providing with light absorbing properties of which the absorbance at a wavelength ranging from 500 nm to 600 nm is 1 or more and the absorbance at a wavelength ranging from 350 run to 450 nm is 0.3 or less.

Brief Description of Drawings

FIG. 1 is a partially enlarged view that shows exemplarily a construction of a digital micromirror device (DMD).

FIG. 2A is a view that explains exemplarily the motion of the DMD.

FIG. 2B is a view that explains exemplarily the motion of the DMD, similarly as shown in FIG. 2A.

FIG. 3A is an exemplary plan view that shows the exposing beam and the scanning line in the case where the DMD is not inclined, as compared to the exposing beam and the scanning line in the case where the DMD is inclined.

FIG. 3B is an exemplary plan view that shows the exposing beam and the scanning line in the case where a DMD similar to that shown in FIG. 3A is not inclined, as compared to the exposing beam and the scanning line in the case where the DVD is inclined.

FIG. 4A is an exemplary view that shows an available region of the DMD.

FIG. 4B is an exemplary view that shows another available region of the DMD, which is similar to that shown in FIG. 4A.

FIG. 5 is an exemplary plan view that explains a way to expose a pattern forming material in one scanning by means of a scanner.

FIG. 6A is an exemplary plan view that explains a way to expose a pattern forming material in plural scannings by means of a scanner.

FIG. 6B is another exemplary plan view that explains a way to expose a pattern forming material in plural scannings by means of a scanner, similarly as shown in FIG. 6A.

FIG. 7 is a schematic perspective view that shows exemplarily appearance of a pattern forming apparatus.

FIG. 8 is a schematic perspective view that shows exemplarily a scanner construction of a pattern forming apparatus.

FIG. 9A is an exemplary plan view that shows exposed regions formed on a pattern forming material.

FIG. 9B is an exemplary plan view that shows an alignment of regions exposed by respective exposing heads.

FIG. 10 is a schematic perspective view that shows exemplarily an exposing head including a light modulating unit.

FIG. 11 is an exemplary cross sectional view that shows the construction of the exposing head shown in FIG. 10 in the sub-scanning direction along the optical axis.

FIG.12 shows an exemplary controller configured to control the DMD based on pattern information.

FIG. 13A is an exemplary cross sectional view that shows a construction of another exposing head in other connecting optical system along the optical axis.

FIG. 13B is an exemplary plan view that shows an optical image projected on an exposed surface when a microlens array is not employed.

FIG. 13C is an exemplary plan view that shows an optical image projected on an exposed surface when a microlens array is employed.

FIG. 14 is an exemplary view that shows distortion of a reflective surface of a micromirror that constitutes a DMD

by means of contour lines.

FIG. 15A is an exemplary graph that shows the distortion of the reflective surface of the micromirror along two diagonal lines of the micromirror.

FIG. 15B is an exemplary graph that shows the distortion of the reflective surface of the micromirror as shown in FIG. 15A along two diagonal lines of the micromirror.

FIG. 16A is an exemplary front view that shows a microlens array employed in a pattern forming apparatus in the present invention.

FIG. 16B is an exemplary side view that shows a microlens array employed in a pattern forming apparatus in the present invention.

FIG. 17A is an exemplary front view that shows a microlens constituting a microlens array.

FIG. 17B is an exemplary side view that shows a microlens constituting a microlens array.

FIG. 18A is an exemplary view that schematically shows a laser collecting condition in a cross section of a microlens.

FIG. 18B is an exemplary view that schematically shows a laser collecting condition in another cross section of a microlens.

FIG. 19A is an exemplary view that shows a simulation of beam diameters near the focal point of a microlens in accordance with the present invention.

FIG. 19B is an exemplary view that shows another simulation similar to FIG. 19A in terms of other sites in accordance with the present invention.

FIG. 19C is an exemplary view that shows still another simulation similar to FIG. 19A in terms of other sites in accordance with the present invention.

FIG. 19D is an exemplary view that shows still another simulation similar to FIG. 19A in terms of other sites in accordance with the present invention.

FIG. 20A is an exemplary view that shows a simulation of beam diameters near the focal point of a microlens in a conventional pattern forming process.

FIG. 20B is an exemplary view that shows another simulation similar to FIG. 20A in terms of other sites.

FIG. 20C is an exemplary view that shows still another simulation similar to FIG. 20A in terms of other sites.

FIG. 20D is an exemplary view that shows still another simulation similar to FIG. 20A in terms of other sites.

FIG. 21 is an exemplary plan view that shows another construction of a combined laser source.

FIG. 22A is an exemplary front view that shows a microlens of a microlens array.

FIG. 22B is an exemplary side view that shows a microlens of a microlens array.

FIG. 23A is an exemplary view that schematically shows a laser collecting condition in the cross section of the microlens shown in FIGS. 22A and 22B.

FIG. 23B is an exemplary view that schematically shows a laser collecting condition in another cross section of the microlens shown in FIG. 23A.

FIG. 24A is an exemplary view that explains the concept of compensation by an optical system of optical quantity distribution compensation.

FIG. 24B is another exemplary view that explains the concept of compensation by an optical system of optical quantity distribution compensation.

FIG. 24C is another exemplary view that explains the concept of compensation by an optical system of optical quantity distribution compensation.

FIG. 25 is an exemplary graph that shows an optical quantity distribution of Gaussian distribution without compensation of optical quantity.

FIG. 26 is an exemplary graph that shows a compensated optical quantity distribution by an optical system of optical quantity distribution compensation.

FIG. 27A (A) is an exemplary perspective view that shows a constitution of a fiber array laser source.

FIG. 27A (B) is a partially enlarged view of FIG. 27A (A).

FIG. 27A (C) is an exemplary plan view that shows an arrangement of emitting sites of laser output.

FIG. 27A (D) is an exemplary plan view that shows another arrangement of laser emitting sites.

FIG. 27B is an exemplary front view that shows an arrangement of laser emitting sites in the laser emitting part in a fiber array laser source.

FIG. 28 is an exemplary view that shows a construction of a multimode optical fiber.

FIG. 29 is an exemplary plan view that shows a construction of a combined laser source.

FIG. 30 is an exemplary plan view that shows a construction of a laser module.

FIG. 31 is an exemplary side view that shows a construction of the laser module shown in FIG. 30.

FIG. 32 is a partial side view that shows a construction of the laser module shown in FIG. 30.

FIG. 33 is an exemplary perspective view that shows a construction of a laser array.

FIG. 34A is an exemplary perspective view that shows a construction of a multi cavity laser.

FIG. 34B is an exemplary perspective view that shows a multi cavity laser array in which the multi cavity lasers

shown in FIG. 34A are arranged in an array.

FIG. 35 is an exemplary plan view that shows another construction of a combined laser source.

FIG. 36A is an exemplary plan view that shows still another construction of a combined laser source.

FIG. 36B is an exemplary cross sectional view of FIG. 36A along the optical axis.

FIG. 37A is an exemplary cross sectional view of an exposing device that shows focal depth along the optical axis in the pattern forming process of the prior art.

FIG. 37B is an exemplary cross sectional view of an exposing device that shows focal depth along the optical axis in the pattern forming process according to the present invention.

FIG. 38 is a graph exemplarily showing a spectral sensitivity curve of a photosensitive layer.

FIG. 39 is a graph exemplarily showing a spectral distribution of a safelight source.

Best Mode for Carrying Out the Invention

(Photosensitive Transfer Material)

A photosensitive transfer material according to a first aspect of the present invention has a support, an oxygen insulation layer formed on the support, a photosensitive layer formed on the oxygen insulation layer, and has other layers such as a cushion layer and a protective film in accordance with the necessity, wherein the oxygen insulation layer has light absorbing properties of which the absorbance at a wavelength ranging from 500 nm to 600 nm is 1 or more, and the absorbance at a wavelength ranging from 350 nm to 450 nm is 0.3 or less.

A photosensitive transfer material according to a second aspect of the present invention has a support, a cushion layer formed on the support, a photosensitive layer formed on the cushion layer, and has other layers such as an oxygen insulation layer and a protective film in accordance with the necessity, wherein the cushion layer has light absorbing properties of which the absorbance at a wavelength ranging from 500 nm to 600 nm is 1 or more, and the absorbance at a wavelength ranging from 350 nm to 450 nm is 0.3 or less.

A photosensitive transfer material according to a third aspect of the present invention has a support, a cushion layer, an oxygen insulation layer, and a photosensitive layer formed in this order on or above the support, and has other layers such as a protective layer in accordance with the necessity. In this case, at least any one of the cushion layer and the oxygen insulating layer has light absorbing properties of which the absorbance at a wavelength ranging from 500 nm to 600 nm is 1 or more, and the absorbance at a wavelength ranging from 350 nm to 450 nm is 0.3 or less.

In the photosensitive transfer materials according to the first aspect to the third aspect of the present invention, even when the photosensitive transfer materials have a highly sensitive photosensitive layer, it is possible to prevent light fog under safelight by providing at least any one of the oxygen insulation layer and the cushion layer which is provided between the support and the photosensitive layer with light absorbing properties of which the absorbance at a wavelength ranging from 500 nm to 600 nm is 1 or more, and the absorbance at a wavelength ranging from 350 nm to 450 nm is 0.3 or less. In other words, as shown in FIG. 38, with the higher photosensitivity, a photosensitive transfer material having a photosensitive layer having a spectral sensitivity near a wavelength of 400 nm (395 nm to 415 nm) is more likely to photoreact with a yellow safelight having a maximum absorption spectral distribution near a wavelength of 580 nm as shown in FIG. 39, and then causing so-called light fog has become problematic. As described above, by providing with at least any one of the oxygen insulation layer and the cushion layer having light absorbing properties of which the absorbance at a wavelength ranging from 500 nm to 600 nm is 1 or more, and the absorbance at a wavelength ranging from 350 nm to 450 nm is 0.3 or less under a photosensitive layer, light fog can be surely prevented under safelight even when a highly sensitive photosensitive layer is employed, and an excellent photosensitivity can be achieved.

[Support]

Material of the support is not particularly limited and may be suitably selected in accordance with the intended use, however, a material having excellent light transmission is preferably used, and a material further having surface planality is more preferably used.

The support is preferably made of a synthetic resin and is transparent. Examples thereof include various plastic films made of polyethylene terephthalates, polyethylene naphthalates, polypropylenes, polyethylenes, cellulose triacetates, cellulose diacetates, poly(meth)acrylic acid alkyl esters, poly(meth)acrylic ester copolymers, polyvinyl chlorides, polyvinyl alcohols, polycarbonates, polystyrenes, cellophanes, polyvinylidene chloride copolymers, polyamides, polyimides, copolymers between vinyl chloride and vinyl acetate, polytetraphloroethylene, polytriphloroethylene, cellulose-based films, nylon films and the like. Each of these materials may be used alone or in combination with two or more.

For the support, the supports described in Japanese Patent Application Laid-Open (JP-A) Nos. 4-208940, 5-80503, 5-173320, 5-72724, and the like may also be used.

The thickness of the support is not particularly limited and may be suitably adjusted in accordance with the

intended use, however, it is preferably 4 μm to 300 μm, more preferably 5 μm to 75 μm, and still more preferably 10 μm to 100 μm.

The shape of the support is not particularly limited and may be suitably selected in accordance with the intended use, however, the support is preferably formed in an elongated shape. The length of the elongated support is not particularly limited, and the ones elongated to 10 m to 20,000 m are exemplified.

[Oxygen Insulation Layer]

Photosensitive transfer materials according to the first aspect to the third aspect of the present invention respectively have an oxygen insulating layer on the support.

The oxygen insulating layer has light absorbing properties of which the absorbance at a wavelength ranging from 500 nm to 600 nm is 1 or more, and the absorbance at a wavelength ranging from 350 nm to 450 nm is 0.3 or less. For the reason, in a photosensitive transfer material according to the first aspect of the present invention, the oxygen insulating layer preferably contains a water soluble polymer and a dye. In a photosensitive transfer material according to the third aspect, at least any one of the cushion layer and the oxygen insulation layer preferably contains a dye.

As for the dye, a water soluble dye is preferable, and examples thereof include cationic dyes, reactive dyes, acidic dyes, and direct dyes. Specific examples thereof include Nitroso dyes (such as naphthol green), Nitro dyes (such as Naphthol Yellow S, Polar Yellow Brown), azo dyes (such as Diachron Scarlet RN, Diamira Red B, Diamira Brilliant Red BB, Diamira Brilliant Violet 5R, Diamira Brilliant Red GG, Diamira Brilliant Orange FR, Diamira Brilliant Orange 3R, Diacryl Brilliant Red GTL-N, Diacryl Red GL-N, Diacryl Brilliant Red GRL-N, Victoria Scarlet 3R, Sulfone Acid Blue R, Supramin Red GG, Supramin Red B, Supramin Blue R, Polar Red G, Polar Orange R, Metachrome Red 5G, Metachrome Brilliant Blue BL, Supranol Orange RR, and Supranol Brilliant Red); thiazole dyes (such as Diacryl Red CS-N, Thiazine Red R, Sirius Scarlet B, and Thioflabin T); diphenylmethane dyes (such as auramine); triphenylmethane dyes (such as Victoria Pure Blue BOH, Crystal Violet, Methl Violet, Ethyl Violet, Spirit Blue, Brilliant Blue R, Acid Violet 6B, Acid Fuchsine, and Malachite Green); xanthene dyes (such as Pyronine G, Rhodamine S, Eosine G, Eosine Y, Erythrocin, Rose Bengale B, Rhodamine B, and Rhodamine 3GO); acridine dyes (such as Acridine Orange 2G and Euchrysine 2GNX; azine dyes (such as Neutral Violet, Neutral Red, Azocarmine G, Safranine T and Indocyanine B); oxazine dyes (such as Meldola's Blue, Nile Blue A and Gallocyanine); dioxazine dyes (such as Sirius Light Blue FFRL, and Sirius Light Blue F3GL); thiazine dyes (such as Methylene Blue, Methylene Green B and Azulene C); anthraquinone dyes (such as Diacid Light Blue BR, Alizarine Direct Violet EFF, Supracen Violet 4BF, Alizarine Sky Blue B, Alizarine Cyanine Green G, Carbolan Green G, Alizarine Saphirol B, Alizarine Cyanine Green 5G, Alizarine Brilliant Pure Blue R, Alizarine Brilliant Light Red 4B and Alizarine Uranol 2B); phthalocyanine dyes (such as Heliogen Blue SBP); and cyanine dyes (such as Diacryl Brilliant Red 3GN, Diacryl Brilliant Pink GN, Diacryl Brilliant Pink RN, and Diacryl Brilliant Red 6BN).

Of these, preferred dyes are those having high water solubility (30 mg/mL or more) and light absorbing properties of which the absorbance at a wavelength ranging from 500 nm to 600 nm is 1 or more, and the absorbance in the wavelength ranging from 350 nm to 450 nm is 0.3 or less. As such dyes, xanthene dyes such as Rhodamine B and Rose Bengale; and triphenylmethane dyes such as Methyl Violet 2B and Brilliant Blue R can be exemplified.

The above-noted dyes can be selected in accordance with various purposes, however, it is preferable that any of these dyes are soluble in aqueous solutions of the (co)polymer constituting the main component of the oxygen insulation layer composition, and the absorbance in the wavelength region of from 20 nm to 540 nm of the absorption spectra of dyes in the oxygen insulation layer is 1.0 or more, and the absorbance in the wavelength region of the exposure light source is 0.3 or less. A desired absorbance may be obtained by combining two or more dyes. The absorption spectra of colorants show an absorbance in the wavelength region of from 520 nm to 540 nm of preferably 2.0 or more, more preferably 2.5 or more, and the absorbance in the wavelength region of the exposure light source of preferably 0.2 or less, more preferably 0.1 or less. Excellent sensitivity can be obtained without generating safelight fog when these conditions are satisfied.

The dyes may be added in an amount of from 0.1 % by mass to 20 % by mass based on the water soluble polymer constituting the main component of the oxygen insulation layer composition, however, the optimal amount is such an amount that the oxygen insulation layer formed on the support has sufficient visibility, i.e., such an amount that the optical density of the photosensitive transfer material surface with the oxygen insulation layer formed therein is preferably 0.5 to 3.0, and more preferably 0.8 to 1.5. Thus, the preferred addition amount of dyes required for coloring the oxygen insulation layer based on the water soluble polymer is 0.5 % by mass to 10 % by mass.

Examples of the water soluble resin include polyvinyl alcohols, polyvinyl pyrolidones, and celluloses such as water soluble salts of ethyl cellulose, hydroxyethyl cellulose, hydroxypropyl cellulose, hydroxypropyl methyl cellulose, carboxy ethyl cellulose, and carboxy propyl cellulose; acidic celluloses, water soluble salts of carboxyalkyl starch, polyacrylic amides, water soluble polyamides, water soluble salts of polyacrylic acids, polyvinyl ether/maleic acid anhydride polymers, ethylene oxide polymers, copolymers of styrene/ maleic acid, maleate resins, gelatins, and Arabian rubbers. Of these, from the perspective of oxygen insulation property and developer removability, polyvinyl alcohols are preferably

exemplified, and from the perspective of improving adhesive properties with the photosensitive layer, a combination of polyvinyl alcohol with polyvinyl pyrolidone is preferably exemplified.

For the oxygen insulation layer, a single water soluble resin or a combination of two or more water soluble resins can be selected from the above noted water soluble resins.

For the above-noted polyvinyl alcohol, those having a mass average molecular mass of 300 to 2,400 are preferable, and those that can be hydrolyzed at 71 mol% to 100 mol% are preferable.

Specific examples of the polyvinyl alcohol include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-220, PVA-224, PVA-217 EE, PVA-217E, PVA-220E, PVA-224E, PVA-405, PVA-420, PVA-613, L-8, PVA-R-1130, PVA-R-2105, and PVA-R-2130 (all of them are trade names, manufactured by KURARAY Co., Ltd.).

The content of the polyvinyl alcohol in the materials for forming the oxygen insulation layer is not particularly limited and may be suitably adjusted in accordance with the intended use, however, it is preferably 50 % by mass to 99 % by mass, more preferably 55 % by mass to 90 % by mass, and still more preferably 60 % by mass to 80 % by mass.

The content of the polyvinyl pyrolidone relative to the polyvinyl alcohol is not particularly limited and may be suitably adjusted in accordance with the intended use, however, it is preferably 5 % by mass to 50 % by mass.

When the content of the polyvinyl pyrolidone is less than 5 % by mass, the adhesive properties with the photosensitive layer may be insufficient. When the content is more than 50% by mass, the oxygen insulation ability may degrade.

The oxygen insulation layer may also contain a colorant such as a water soluble dye capable of absorbing light having a wavelength of 500 nm or less.

Further, a surfactant may be added to the materials for forming the oxygen insulation layer for enhancement of coating properties of the oxygen insulation layer, and enhancement of adhesive properties between the photosensitive layer and the oxygen insulation layer.

The content of the surfactant in the case where the surfactant is added to the materials for forming the oxygen insulation layer is preferable 1 % by mass to 20 % by mass based on the solid content of the oxygen insulation layer, more preferably 1 % by mass to 10 % by mass, and still more preferably 1 % by mass to 5 % by mass.

For the surfactant, an amphoteric surfactant such as alkyl carboxy betaine, and perfluoroalkyl betaine described in Japanese Patent Application Laid-Open (JP-A) No. 61-285444 may be used, for example.

The material, shape, structure, etc. of the oxygen insulation layer are not particularly limited and may be suitably selected in accordance with the intended use as long as polymerization reactions of the photosensitive layer are not inhibited due to influence of oxygen during exposure, and the photosensitivity of the photosensitive layer can be kept high, however, it is preferable that the oxygen insulation layer preferably has low oxygen permeability and does not virtually inhibit light transmission used for exposure.

The oxygen permeability of the oxygen insulation layer is preferably $5 \times 10^{-12}$ cc · cm/cm$^2$·sec·cmHg or less, and more preferably $1 \times 10^{-12}$ cc·cm/cm$^2$· sec·cmHg or less.

The oxygen permeability is more than $5 \times 10^{-12}$ cc·cm/cm$^2$·sec·cmHg or less, the photosensitivity of the photosensitive transfer material may degrade due to insufficient insulation of oxygen.

Here, the oxygen permeability can be measured in accordance with the method described in ASTM standards D-1434-82 (1986).

Further, it is preferable that the oxygen insulation layer more strongly adheres or sticks tightly to the photosensitive layer than to the support.

It is also preferable that the oxygen insulation layer has small tucking property at the surface thereof from the perspective of handleability and prevention of defects due to dust adhesion.

The materials for forming the oxygen insulation layer are not particularly limited and may be suitably selected in accordance with the intended use, however, the material is preferably soluble in aqueous solutions and more preferably soluble in weak alkaline aqueous solutions which are developers.

Further, a surfactant may be added to the materials for forming the oxygen insulation layer for enhancement of coating properties of the oxygen insulation layer, and enhancement of adhesive properties between the photosensitive layer and the oxygen insulation layer.

The content of the surfactant in the case where the surfactant is added to the materials for forming the oxygen insulation layer is preferable 1 % by mass to 20 % by mass based on the solid content of the oxygen insulation layer, more preferably 1 % by mass to 10 % by mass, and still more preferably 1 % by mass to 5 % by mass.

For the surfactant, an amphoteric surfactant such as alkyl carboxy betaine, and perfluoroalkyl betaine described in Japanese Patent Application Laid-Open (JP-A) No. 61-285444 may be used, for example.

The method of forming the oxygen insulation layer is not particularly limited and may be suitably selected in accordance with the intended use, however, the oxygen insulation layer can be formed by dissolving a single component or two or more components of the materials for forming the oxygen insulation layer in water or a mixture solution of a water-miscible solvent, applying the solution over a surface of the support, and drying the support surface with the

solution applied thereon.

Examples of the water-miscible solvent include methanol, ethanol, ethylene glycol monomethyl ether, and propylene glycol monomethyl ether.

The content of the water-miscible solvent in the total amount of solvents is preferably 1 % by mass to 80 % by mass, more preferably 2 % by mass to 70 % by mass, and still more preferably 5 % by mass to 60 % by mass.

The mixture ratio of water and the solvent is not particularly limited and may be suitably adjusted in accordance with the intended use, however, the mixture ratio of water : solvent is preferably 100 : 0 to 80 : 20, more preferably 70 : 30, and still more preferably 60 : 40.

When the oxygen insulation layer is formed using a coating solution containing the materials for forming the oxygen insulation layer, the solid content concentration in the coating solution of the materials for forming the oxygen insulation layer is preferably 1 % by mass to 30 % by mass, more preferably 2 % by mass to 20 % by mass, and still more preferably 3 % by mass to 10 % by mass.

When the solid content concentration is less than 1 % by mass or more than 30 % by mass, the oxygen insulation layer after drying may not have a predetermined thickness.

The thickness of the oxygen insulation layer is not particularly limited and may be suitably adjusted in accordance with the intended use, however, the thickness is preferably one half or less of the thickness of the support. Specifically, the thickness of the oxygen insulation layer is preferably 0.1 μm to 10 μm, more preferably 0.5 μm to 5 μm, and still more preferably 1 μm to 3 μm. When the thickness of the oxygen insulation layer is less than 0.1 μm, the oxygen insulation ability may degrade due to excessively high oxygen permeability. When the thickness of the oxygen insulation layer is more than 10 μm, image blur occurs in an image to be formed on the photosensitive layer due to influences of light scattering and refraction of light from the oxygen insulation layer, and a high resolution may not be obtained. Further, it may take time in developing and removing a photosensitive layer.

[Cushion Layer]

Photosensitive transfer materials according to the second and third aspects of the present invention respectively have a cushion layer on a support or an oxygen insulation layer.

The cushion layer has light absorbing properties of which the absorbance at a wavelength ranging from 500 nm to 600 nm is 1 or more, and the absorbance at a wavelength ranging from 350 nm to 450 nm is 0.3 or less. For the reason, a photosensitive transfer material according to the first aspect of the present invention preferably contains a dye. In a photosensitive transfer material according to the third aspect of the present invention, any one of the cushion layer and the oxygen insulation layer preferably contains a dye.

For the dye (particularly a water soluble dye is preferable), the same dyes as used for the oxygen insulation layer may be used.

For the dyes other than the water soluble dyes set forth, known dyes that are soluble in organic solvents can be used. Examples of the dyes that are soluble in organic solvents include Brilliant Green (the sulfate salts thereof, for example), Eosine, Ethyl Violet, Erythrocin B, Methyl Green, Crystal Violet, basic Fuchsine, phenolphthalein, 1,3-diphenyltriazine, Alizarin Red S, Thymolphthalein, Methyl Violet 2B, Quinaldine Red, Rose Bengale, Metanil Yellow, Thymolsulfophthalin, Xylenol Blue, Methyl Orange, Orange IV, diphenylthiocarbazone, 2,7-dichlorofluorescein, Paramethyl Red, Congo Red, Benzopurpurin 4B, .alpha.-Naphthyl Red, Nile Blue, Phenacetalin, Methyl Violet, Malachite Green, Parafuchsine, Oil Blue #603 (produced by Orient Kagaku Kogyo Co.), Oil Pink #312 (produced by Orient Kagaku Kogyo Co.), Rhodamine B, Rhodamine 6G, and Victoria Pure Blue BOH.

Counter anions of the cationic dyes may be suitably selected as long as the counter anions are residues of organic acids or inorganic acids, and examples thereof include residues (anions) of bromic acids, iodine acids, sulfuric acids, phosphoric acid, oxalic acid, methanesulfonic acid, and toluene sulfonic acid. Preferred dyes are cationic dyes, and examples thereof include Malachite G oxalate, and Malachite Green sulfate salt.

Preferred examples of organic solvents used for these dyes include alcohols and ketones. Examples of the alcohols include methanol, ethanol, n-propanol, isopropanol, n-butanol, sec-butanol, methoxy ethanol, ethoxy ethanol, methoxy propanol, ethoxy propanol, acetone, and methyl ethyl ketone.

The addition amount of the dyes is preferably 0.001 % by mass to 10 % by mass relative to the total amount of the cushion layer composition, more preferably 0.01 % by mass to 5 % by mass, and still more preferably 0.1 % by mass to 2 % by mass.

The cushion layer is preferably alkali soluble from the perspective of allowing for alkali developing and allowing for preventing a transfer target from being contaminated by the alkali soluble thermoplastic resin layer protruded during transferring. It is also preferable that when the photosensitive transfer material is transferred onto a transfer target, the cushion layer serves as a cushion material to effectively prevent transfer defects caused by convexoconcaves residing on the transfer target surface. It is more preferable that when the photosensitive transfer material is heated and made to adhere on the transfer target, the cushion layer can be deformed depending on the convexoconcaves residing on the

transfer target surface. For the cushion layer, it is also possible to use those prepared by using alkali insoluble thermoplastic resins described in Japanese Patent Application Laid-Open (JP-A) Nos. 7-20309, 11-72908, 11-109124, 11-174220, 11-338133, 2000-250222, 2000-250221, 2000-266925, 2001-142223, and 2003-5364.

Besides the water soluble polymers set forth above, the cushion layer may contain organic polymer materials described in Japanese Patent Application Laid-Open (JP-A) No. 5-72724, for example, and it is particularly preferable to selected from organic polymer materials each having a softening point of about 80°C or less measured by the Vicat method (specifically, the method of measuring a softening point of a polymer based on ASTM D 1235 (ISO 306) of the testing method of materials in the U.S.). Specific examples of such an organic polymer material include polyolefins of polyethylene, polypropylene, etc; ethylene copolymers between ethylene and vinyl acetate or saponified products thereof; copolymers of ethylene and acrylic ester or saponified products thereof; polyvinyl chlorides, vinyl chloride copolymers like copolymers between vinyl chloride and vinyl acetate or saponified products thereof; polyvinylidene chloride; vinylidene chloride copolymers, polystyrene; styrene copolymers like copolymers between styrene and (meth)acrylic acid ester or saponified products thereof; polyvinyl toluene; vinyl toluene copolymers like copolymers between vinyl toluene and (meth)acrylic acid ester or saponified products thereof; poly(meth)acrylic esters; (meth)acrylic ester copolymers such as butyl (meth)acrylate and vinyl acetate; and organic polymers such as polyamide resins like nylons of vinyl acetate copolymers, nylon copolymers, N-alkoxymethylated nylons, and N-dimethylaminated nylons. Each of these organic polymers may be used alone or in combination with two or more.

The dry thickness of the cushion layer is preferably 2 $\mu$m to 30 $\mu$m, more preferably 5 $\mu$m to 20 $\mu$m, and still more preferably 7 $\mu$m to 16 $\mu$m. [Photosensitive Layer]

Material of the photosensitive layer is not particularly limited and may be suitably selected in accordance with the intended use, however, the photosensitive layer is composed on a photosensitive composition containing at least (A) a copolymer which can be obtained by reacting a primary amine compound with an anhydride group of a maleic acid anhydride copolymer (hereinafter, may be referred to as "binder"), (B) a polymerizable compound, and (C) a photopolymerization initiator, and further containing other components suitably selected in accordance with the necessity.

- (A) Binder -

The binder is preferably swellable to alkaline solutions and is more preferably soluble in alkaline solutions.

For a binder which is swellable to or soluble in alkaline solutions, those having an acidic group are preferably exemplified, for example.

The acidic group is not particularly limited and may be suitably selected in accordance with the intended use. Examples thereof include carboxyl group, sulfonate group, and phosphate group. Of these, carboxyl group is preferable.

Examples of a binder having a carboxyl group include vinyl copolymers, polyurethane resins, polyamide acid resins, and modified epoxy resins each having a carboxyl group. Of these, vinyl copolymers each having a carboxyl group are preferable from the perspective of solubility in coating solvents, solubility in alkaline developers, synthesis applicability, and easy control of film physical properties. From the perspective of developing ability, copolymers of any one of a styrene and a styrene derivative are also preferable.

The vinyl copolymer having a carboxyl group can be obtained by copolymerization between at least (1) a vinyl monomer having a carboxyl group, and (2) a monomer copolymerizable with the vinyl monomer (1).

Examples of the vinyl monomer having a carboxyl group include (meth)acrylic acids, vinyl benzoates, maleic acids, monoalkyl ester maleates, fumaric acids, itaconic acids, crotonic acids, cinnamic acids, acrylic acid dimers, addition reaction products between a monomer having a hydroxyl group (such as 2-hydroxyethyl (meth)acrylate) and a cyclic anhydride (such as maleic acid anhydride, phthalic acid anhydride, and cyclohexane carboxylic acid); and $\omega$-carboxy-polycaprolactone mono(meth)acrylates. Of these, (meth)acrylic acids are particularly preferable from the perspective of copolymerizability, cost, and solubility.

As a precursor of carboxyl group, a monomer containing an anhydride such as maleic acid anhydride, itaconic acid anhydride, and citraconic acid anhydride may be used.

Other copolymerizable monomers besides those mentioned above are not particularly limited and may be suitably selected in accordance with the intended use. Examples thereof include (meth)acrylic acid esters, crotonic acid esters, vinyl esters, maleic acid diesters, fumaric acid diesters, itaconic acid diesters, (meth)acrylic amides, vinyl ethers, esters of vinyl alcohols, styrenes (such as styrene, and styrene derivatives), (meth)acrylonitrile, heterocyclic groups substituted by a vinyl group (such as vinyl pyridine, vinyl pyrolidone, and vinyl carbazole), N-vinylformamide, N-vinylacetoamide, N-vinylimidazole, vinylcaprolactone, 2-acrylamide-2-methylpropane sulfonate, phthalic acid mono(2-acryloyl oxy ethyl ester), phthalic acid (1-methyl-2-acryloyl oxy ethyl ester), and vinyl monomers each having a functional group (such as urethane group, urea group, sulfonamide group, phenol group, and imide group). Of these, styrenes are preferable.

Examples of the (meth)acrylic acid esters include methyl (meth)acrylates, ethyl (meth)acrylates, n-propyl (meth) acrylates, isopropyl (meth)acrylates, n-butyl (meth)acrylates, isobutyl (meth)acrylates, t-butyl (meth)acrylates, n-hexyl

(meth)acrylates, cyclohexyl (meth)acrylates, t-butyl cyclohexyl (meth)acrylates, 2-ethylhexyl (meth)acrylates, t-octyl (meth)acrylates, dodecyl (meth)acrylates, octadecyl (meth)acrylates, acetoxy ethyl (meth)acrylates, phenyl (meth)acrylates, 2-hydroxyethyl (meth)acrylates, 2-methoxyethyl (meth)acrylates, 2-ethoxyethyl (meth)acrylates, 2-(2-methoxyethyl)ethyl (meth)acrylates, 3-phenoxy-2-hydroxypropyl (meth)acrylates, benzyl (meth)acrylates, diethyleneglycol monomethylether (meth)acrylates, diethyleneglycol monoethylether (meth)acrylates, diethylene glycol monophenylether (meth)acrylates, triethyleneglycol monomethylether (meth)acrylates, triethyleneglycol monoethylether (meth)acrylates, polyethyleneglycol monomethylether (meth)acrylates, polyethyleneglycol monoethylether (meth)acrylates, β-phenoxyethoxyethyl acrylates, nonylphenoxypolyethyleneglycol (meth)acrylates, dicyclopentanyl (meth)acrylates, dicyclopentenyl (meth)acrylates, dicyclopentenyloxyethyl (meth)acrylates, trifluoroethyl (meth)acrylates, octafluoropentyl (meth) acrylates, perfluorooctylethyl (meth)acrylates, tribromophenyl (meth)acrylates, and tribromophenyloxyethyl (meth)acrylates.

Examples of the crotonic acid esters include butyl crotonate, and hexyl crotonate.

Examples of the vinyl esters include vinyl acetate, vinyl propionate, vinyl butylate, vinyl methoxy acetate, and vinyl benzoate.

Examples of the maleic acid diesters include dimethyl maleate, diethyl maleate, and dibutyl maleate.

Examples of the fumaric acid diesters include dimethyl fumarate, diethyl fumarate, and dibutyl fumarate.

Examples of the itaconic acid diesters include dimethyl itaconate, diethyl itaconate, and dibutyl itaconate.

Examples of the (meth)acrylamides include acrylamide, N-methyl (meth)acrylamide, N-ethyl (meth)acrylamide, N-propyl (methacrylamide, N0isopropyl (meth)acrylamide, N-n-butylacryl (meth)amide, N-t-butyl (meth)acrylamide, N-cyclohexyl (meth)acrylamide, N-(2-methoxyethyl) (meth)acrylamide, N, N-dimethyl (meth)acrylamide, N, N-diethyl (meth) acrylamide, N-phenyl (meth)acrylamide, N-benzyl (meth)acrylamide, (meth)acryloylinorpholine, and diacetone acrylamide.

Examples of the styrenes include styrene, methyl styrene, dimethyl styrene, trimethyl styrene, ethyl styrene, isopropyl styrene, butyl styrene, hydroxy styrene, methoxy styrene, buthoxy styrene, acetoxy styrene, chloro styrene, dichloro styrene, bromo-styrene, chloromethyl styrene, hydroxy styrene protected by a group which can be deprotected by an acidic material (t-Boc, for example), vinyl methyl benzoate, and α-methyl styrene.

Examples of the vinyl ethers include vinyl methyl ether, vinyl butyl ether, vinyl hexyl ether, and vinyl methoxymethyl ether.

For a method of synthesizing a vinyl monomer having the above-noted functional group, addition reactions between an isocyanato group and a hydroxyl group or an amino group are exemplified, for example. Specific examples thereof include addition reactions between a monomer having an isocyanato group and a compound having one hydroxyl group or a compound having one primary or secondary amino group, and addition reactions between a monomer having a hydroxyl group or a monomer having a primary or secondary amino group and a monoisocyanate.

As the monomer having an isocyanato group, the compounds represented by the following Structural Formulas (1) to (3) are exemplified.

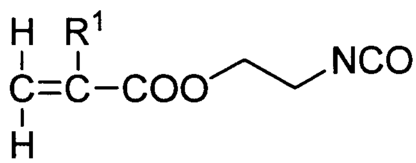

Structural Formula (1)

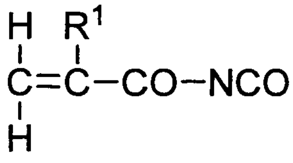

Structural Formula (2)

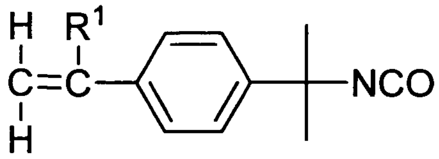

Structural Formula (3)

In Structural Formulas (1) to (3), "$R^1$" represents a hydrogen atom or a methyl group.

Examples of the monoisocyanate include cyclohexyl isocyanate, n-butyl isocyanate, toluyl isocyanate, benzyl isocyanate, and phenyl isocyanate.

As the monomer having a hydroxyl group, the compounds represented by the following Structural Formulas (4) to (12) are exemplified.

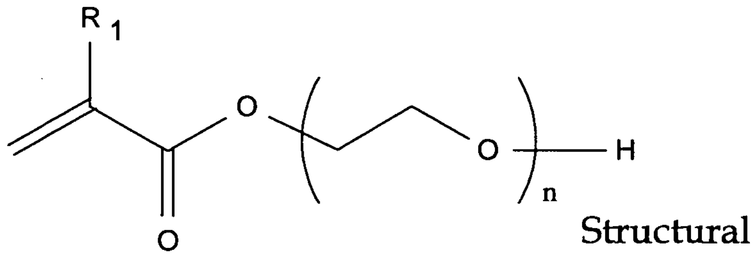

Structural Formula (4)

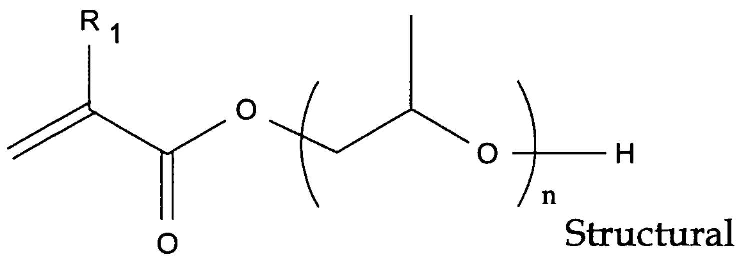

Structural Formula (5)

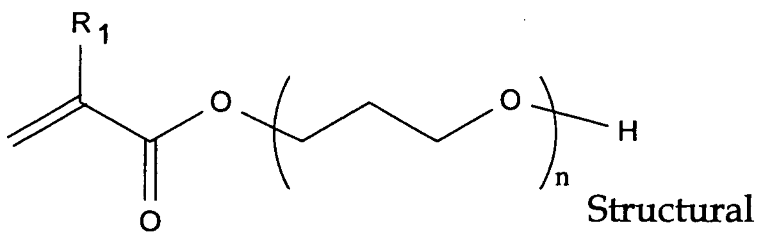

Structural Formula (6)

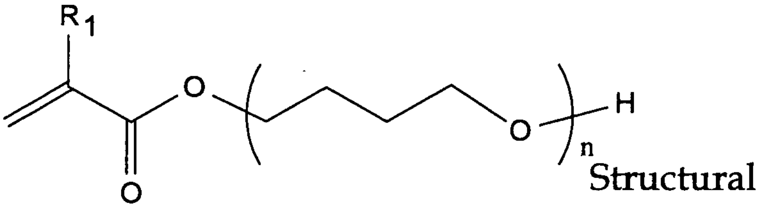

Structural Formula (7)

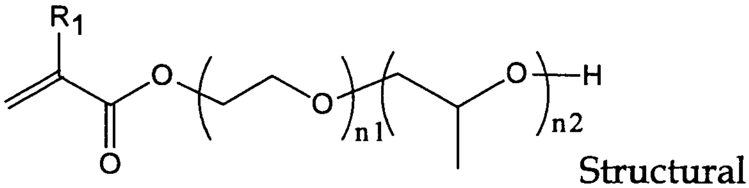

Structural Formula (8)

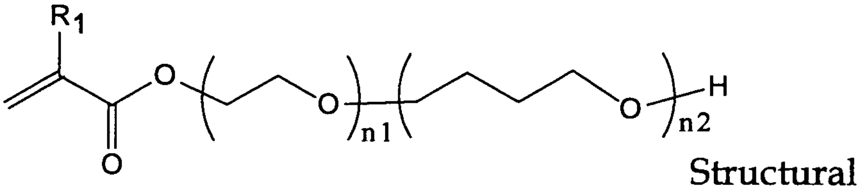

Structural Formula (9)

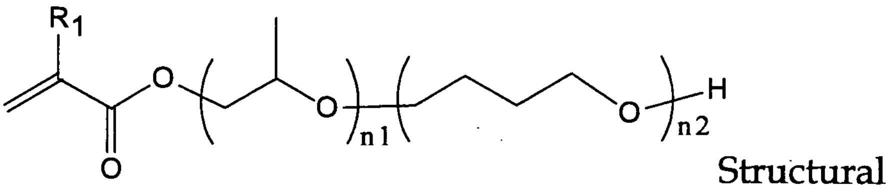

Structural Formula (10)

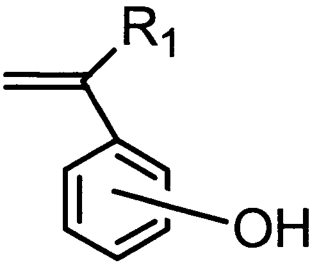

Structural Formula (11)

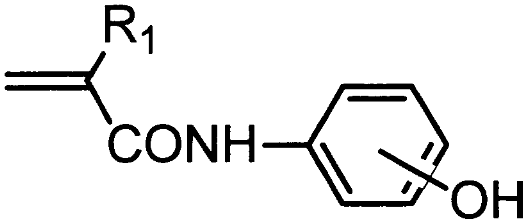

Structural Formula (12)

In Structural Formulas (4) to (12), "$R^1$" represents a hydrogen atom or a methyl group, and "n" is an integer of 1 or more.

Examples of the compound having one hydroxyl group includes alcohols (such as methanol, ethanol, n-propanol, i-propanol, n-butanol, sec-butanol, t-butanol, n-hexanol, 2-ethyl hexanol, n-decanol, n-dodecanol, n-octadecanol, cyclopentanol, benzyl alcohol, and phenyl ethyl alcohol); phenols (such as phenol, cresol, and naphthol); further, as those containing substituted group, fluoro-ethanol, trifluoro-ethanol, methoxy ethanol, phenoxy ethanol, chlorophenol, dichlorophenol, methoxyphenol, and acetoxyphenol.

Examples of the monomer having a primary or secondary amino group include vinylbenzylamine.

Examples of the compound having one primary or secondary amino group include alkyl amines (such as methylamine, ethylamine, n-propylamine, i-propylamine, n-butylamine, sec-butylamine, t-butylamine, hexylamine, 2-ethyl hexylamine, decylamine, dodecylamine, octadecylamine, dimethylamine, diethylamine, dibutylamine, and dioctylamine); cyclic alkylamines (such as cyclopentylamine, and cyclohexylamine); alkylamines (such as benzylamine, and phenethylamine), arylamines (such as aniline, toluylamine, xylylamine, and naphthylamine); combinations thereof (such as N-methyl-N-benzylamine); amines containing a substituted group (such as trifluoroethylamine, hexafluoroisopropylamine, methoxyaniline, and methoxypropylamine).

As polymerizable monomers other than those stated above, methyl (meth)acrylate, ethyl (meth)acrylate, butyl (meth)acrylate, benzyl (meth)acrylate, 2-ethylhexyl (meth)acrylate, styrene, chlorostyrene, bromostyrene, and hydroxy styrene.

Each of the other copolymerizable monomers may be used alone or in combination with two or more.

The above-noted vinyl copolymers can be prepared by copolymerizing a corresponding monomer in accordance with a common procedure of the conventional methods. For example, a vinyl copolymer can be prepared by utilizing a method (solution polymerization) in which the monomer is dissolved in a proper solvent, and a radical polymerization initiator is added to the solution to thereby polymerize the monomer in the solution. A vinyl copolymer can also be prepared by means of polymerization reaction so-called emulsification reaction, etc. in a condition where the monomer is dispersed in an aqueous medium.

The proper solvent used in the solution polymerization is not particularly limited and may be suitably selected depending on the solubility, etc. of the copolymer to be prepared. Examples thereof include methanol, ethanol, - propanol, isopropanol, 1-methoxy-2-propanol, acetone, methylethylketone, methylisobutylketone, methoxypropylacetate, ethyl lactate, ethyl lactate, acetonitrile, tetrahydrofuran, dimethylformamide, chloroform, and toluene. Each of these solvents may be used alone or in combination with two or more.

The radical polymerization initiator is not particularly limited, and examples thereof include azobis compounds such as 2,2'-azobis (isobutylonitrile) (AIBN), and 2,2'-azobis-(2,4'-dimethylvaleronitrile); peroxides such as benzoyl peroxides; and persulphates such as potassium persulphate, and ammonium persulphate.

The content rate of the polymerizable compound having a carboxyl group in the vinyl copolymer having a carboxyl group is not particularly limited and may be suitably adjusted in accordance with the intended use, however, the content rate is preferably 5 mol% to 50 mol%, more preferably 10 mol% to 40 mol%, and still more preferably 15 mol% to 35 mol%.

When the content rate is less than 5 mol%, the developing ability to alkali liquids may be insufficient, and when the content rate is more than 50 mol%, the resistance of the hardened regions (image regions) to developers may be insufficient.

The molecular mass of the binder having a carboxyl group is not particularly limited and may be suitably adjusted in accordance with the intended use, however, the mass average molecular mass is preferably 2,000 to 300,000, and more preferably 4,000 to 150,000.

When the mass average molecular mass is less than 2,000, the film strength may be insufficient, and it may be difficult to stably produce a photosensitive transfer material. When the mass average molecular mass is more than 300,000, the developing ability may degrade.

Each of these binders each having a carboxyl group may be used alone or in combination with two or more.

When two or more binders are used in combination, combinations of two or more binders each having a different polymerization component, combinations of two or more binders each having a different mass average molecular mass, and combinations of two or more binders each having a different degree of dispersion are exemplified, for example.

The binder having a carboxyl group may be partially or entirely neutralized with a basic material. For the binder having a carboxyl group, a resin having a different structure such as a polyester resin, a polyamide resin, a polyurethane resin, an epoxy resin, a polyvinyl alcohol, and gelatin may be further used.

For the above-noted binders, the resins which are soluble in alkaline solutions described in Japanese Patent (JP-B) No. 2873889 and the like can be used.

Further, the following binders can also be preferably used. The epoxyacrylates compounds each having an acidic group described in Japanese Patent Application Laid-Open (JP-A) Nos. 51-131706, 52-94388, 61-243869, 64-62375, 2-97513, 3-289656, 2002-296776, and the like are exemplified, for example.

Specific examples are phenol novolac epoxy acrylate monotetrahydrophthalate, or cresol novolac epoxy acrylate monotetrahydrophthalate, and a bisphenol A epoxy acrylate monotetrahydrophthalate. Those prepared by reacting a monomer containing a carboxyl group such as (meth)acrylic acid with an epoxy resin or a polyfunctional epoxy compound, and further adding a dibasic anhydride such as phthalic acid anhydride thereto are exemplified, for example.

The molecular mass of the epoxy acrylate compound is preferably 1,000 to 200,000, and more preferably 2,000 to 100,000. When the molecular mass is less than 1,000, the tucking property of the photosensitive layer surface may be sometimes strong, and thus the film quality of the hardened photosensitive layer may be brittle, of the surface strength of the photosensitive layer may degrade. When the molecular mass of the epoxy acrylate compound is more than 200,000, the developing ability may degrade.

In addition, an acrylic resin having at least a group polymerizable with an acidic group or by a double bond described in Japanese Patent Application Laid-Open (JP-A) No. 6-295060 can also be used for the binder.

Specifically, it is possible to use at least one polymerizable double bond in a molecule, for example, various polymerizable double bonds of (meth)acrylate group or acrylic group such as (meth)acrylamide group, vinyl esters of carboxylic acids, vinyl ethers, and allyl ethers can be used.

More specifically, the following compounds are exemplified: Compounds which can be obtained by adding a polymerizable compound containing an epoxy group like glycydyl ester of unsaturated fatty acid such as glycydyl acrylate, glycydyl methacrylate, and cinnamic acid or a compound having an epoxy group such as cyclohexene oxide and a (meth)acryloyl group in the same molecule to an acrylic resin containing a carboxyl group as an acidic group; compounds which can be obtained by adding a polymerizable compound containing an isocyanate group such as isocyanate ethyl (meth)acrylate to an acrylic resin containing an acidic group and a hydroxyl group; and compounds which can be obtained by adding a polymerizable compound containing a hydroxyl group such as hydroxylalkyl (meth)acrylate to an acrylic resin containing an anhydride group.

Examples of commercially available products thereof include KANEKA RESIN AXE (manufactured by Kaneka Corportion), CYCLOMER A-200 (manufactured by DAICEL CHEMICAL INDUSTRIES, LTD.), and CYCLOMER M-220 (manufactured by DAICEL CHEMICAL INDUSTRIES, LTD.).

Further, reaction products between hydroxylalkyl acrylate or hydroxylalkyl methacrylate and any one of polycarboxylic acid anhydride and epihalohydrin, which are described in Japanese Patent Application Laid-Open (JP-A) No. 50-59315 can also be used for the binder.

In addition, compounds which can be obtained by adding an acid anhydride to an epoxyacrylates each having a fluorene skeleton described in Japanese Patent Application Laid-Open (JP-A) No. 5-70528; polyamide(imide) resins described in JP-A No. 11-288087; copolymers between styrene or a styrene derivative containing an amide group described in JP-A Nos. 2-97502 and 2003-20310; and polyimide precursors described in JP-A No. 11-282155, and the like can also be used for the binder.

The molecular mass of the binder containing the acrylic resin, or the epoxyacrylates each having a fluorene skeleton, or polyamide (imide), or styrene/acid anhydride copolymer containing an amide group, or polyimide precursor is preferably 3,000 to 500,000, and more preferably 5,000 to 100,000. When the molecular mass is less than 3,000, the tucking property of the photosensitive layer surface may be sometimes strong, and thus the film quality of the hardened photosensitive layer may be brittle, or the surface strength of the photosensitive layer may degrade. When the molecular mass is more than 500,000, the developing ability may degrade.

Each of these binders may also be used alone or in combination with two or more.

The content of the binder in the photosensitive layer is not particularly limited and may be suitably adjusted in accordance with the intended use. For example, it is preferably 10 % by mass to 90 % by mass, more preferably 20 % by mass to 80 % by mass, and still more preferably 40 % by mass to 80 % by mass.

When the content of the binder is less than 10 % by mass, the alkali-developing ability and adhesion property of the photosensitive transfer material with substrates for printed circuit boards (for example, copper clad laminate) may degrade. When the content of the binder is more than 90 % by mass, the stability relative to developing time, and the strength of strength of hardened film (tent film) may degrade. The content may be a total content of the binder and a

polymer binder in combination with the binder in accordance with the necessity.

The acid value of the binder is not particularly limited and may be suitably selected in accordance with the intended use, however, it is preferably 70 mgKOH/ g to 250 mgKOH/ g, more preferably 90 mgKOH/ g to 200 mgKOH/ g, and still more preferably 100 mgKOH/ g to 180 mgKOH/ g.

When the acid value is less than 70 mgKOH/ g, the developing ability of the photosensitive transfer material may be insufficient, the resolution may degrade, and thus a permanent pattern such interconnection pattern may not be finely and precisely obtained. When the acid value is more than 250 mgKOH/g, at least any one of resistance to developers and adhesion property of the pattern may degrade, and thus a permanent pattern such interconnection pattern may not be finely and precisely obtained.

- (B) Polymerizable Compound -

The polymerizable compound is not particularly limited and may be suitably selected in accordance with the intended use, however, a compound having at least one addition-polymerizable group in the molecule thereof and having a boiling point of 100°C or more under normal pressure is preferable, and at least one selected from monomers each having a (meth)acrylic group is more preferable.

The monomer having a (meth)acrylic group is not particularly limited and may be suitably selected in accordance with the intended use. Examples thereof include monofunctional acrylates and monofunctional methacrylates (such as polyethylene glycol mono(meth)acrylate, polypropylene glycol mono(meth)acrylate, and phenoxyethyl (meth)acrylate); compounds prepared by addition-reacting ethylene oxide or propylene oxide with a polyfunctional alcohol and (meth) acrylating the addition reaction product (such as polyethylene glycol di(meth)acrylate, polypropylene glycol di(meth) acrylate, trimethylolethane triacrylate, trimethylol propane triacrylate, trimethylol propane diacrylate, neopentylglycol di (meth)acrylate, pentaerythritol tetra(meth)acrylate, pentaerythritol tri(meth)acrylate, dipentaerythritol hexa(meth)acrylate, dipentaerythritol penta(meth)acrylate, hexanediol di(meth)acrylate, trimethylol propane tri(acryloyloxypropyl)ether, tri(acryloyloxyethyl) isocyanurate, tri(acryloyloxyethyl)cyanurate, glycerine tri(meth)acrylate, trimethylol propane, glycerine, and bisphenol); polyester acrylates described in Japanese Patent Application Publication (JP-B) Nos. 48-41708 and50-6034, and Japanese Patent Application Laid-Open (JP-A) No. 51-37193; and polyfunctional acrylates and methacrylates (such as epoxy acrylates which are reaction products between an epoxy resin and (meth)acrylic acid). Of these, trimethylol propane tri (meth)acrylate, pentaerythritol tetra(meth)acrylate, dipentaerythritol hexa(meth)acrylate, and dipentaerythritol penta(meth)acrylate are particularly preferable.

The content of solids in the photosensitive composition in the polymerizable compound is preferably 2 % by mass to 50 % by mass, more preferably 4 % by mass to 40 % by mass, and still more preferably 5 % by mass to 30 % by mass. When the content of solids is less than 2 % by mass, it may cause problems with degradations of developing ability and exposure sensitivity. When the content of solids is more than 50 % by mass, it is unfavorable because the viscosity of the photosensitive layer may be sometimes excessively strong.

- (C) Photopolymerization Initiator -

The photopolymerization initiator is not particularly limited and may be suitably selected from among those known in the art as long as the photopolymerization initiator has an ability to initiate polymerization of the polymerizable compound. The photopolymerization initiator may be an activator which exerts some effects with a photoexcited photosensitizer and generates an active radical or may be an initiator capable of initiating cation polymerization depending on the type of monomer. However, the photopolymerization initiator preferably has photosensitivity to light beams in the regions of ultraviolet rays to visible lights, more preferably has high sensitivity relative to exposure light of a laser beam having a wavelength of 395 nm to 415 nm, and still more preferably contains at least one selected from halogenated hydrocarbon derivatives, phosphine oxides, hexaarylbiimidazole, oxime derivatives, organic peroxides, thio compounds, ketone compounds, aromatic onium salts, and ketoxime ethers.

In addition, it is preferable that the photopolymerization initiator contains at least one component having a molecular extinction coefficient of at least around 50 in the wavelength region of about 300 nm to 800 nm (more preferably in the wavelength region of 330 nm to 500 nm).

Examples of the photopolymerization initiator include halogenated hydrocarbon derivatives (such as halogenated hydrocarbon derivative having a triazine skeleton having a triazine skeleton, halogenated hydrocarbon derivative having a triazine skeleton having oxadiazole skeleton, and halogenated hydrocarbon derivative having a triazine skeleton having oxadiazole skeleton); phosphine oxides, hexaarylbiimidazole, oxime derivatives, organic peroxides, thio compounds, ketone compounds, aromatic onium salts, and ketoxime ethers.

Examples of the halogenated hydrocarbon compound having a triazine skeleton include the compounds described in Bulletin of the Chemical Society of Japan, 42, 2924 (1969) reported by Wakabayashi et at.; compounds described in Great Britain Patent No. 1388492; compounds described in Japanese Patent Application Laid-Open (JP-A) No. 53-133428; compounds described in Germany Patent No. 3337024; compounds described in the Journal of Organic Chemistry reported by F.C. Schaefer et al., 29,1527 (1964); compounds described in Japanese Patent Application Laid-Open (JP-A) No. 62-58241; compounds described in Japanese Patent Application Laid-Open (JP-A) No. 5-281728; compounds described in Japanese Patent Application Laid-Open (JP-A) No. 5-34920; and compounds described in U.S Patent No. 4212976.

Examples of the compounds described in Bulletin of the Chemical Society of Japan, 42, 2924 (1969) reported by Wakabayashi et at include 2-phenyl-4,6-bis (trichlormethyl)-1,3,5-triazine, 2-(4-chlorphenyl)-4,6-bis (trichlormethyl)-1,3,5-triazine, 2-(4-tolyl)-4,6-bis(trichlormethyl)-1,3,5-triazine, 2-(4-methoxyphenyl)-4,6-bis (trichloromethyl)-1,3,5-triazine, 2-(2,4-dichlorphenyl)-4,6-bis (trichloromethyl)-1,3,5-triazine, 2,4,6-tris(trichloromethyl)-1,3,5-triazine, 2-methyl-4,6-bis(trichloromethyl)-1,3,5-triazine, 2-n-nonyl-4,6-bis(trichloromethyl)-1,3,5-triazine, and 2-(α,α, β-trichlorethyl)-4,6-bis (trichloromethyl)-1,3,5-triazine.

Examples of the compounds described in Great Britain Patent No. 1388492 include 2-styryl-4,6-bis (trichloromethyl)-1,3,5-triazine, 2-(4-methylstyryl)-4,6-bis(trichloromethyl)-1,3,5-triazine, 2-(4-methoxystyryl)-4,6-bis (trichloromethyl)-1,3,5-triazine, and 2-(4-methoxystyryl)-4-amino-6-trichlormethyl-1,3,5-triazine.

Examples of the compounds described in Japanese Patent Application Laid-Open (JP-A) No. 53-133428 include 2-(4-methoxy-naphtho-1-yl)-4,6-bis (trichloromethyl)-1,3,5-triazine, 2-(4-ethoxy-naphtho-1-yl)-4,6-bis(trichloromethyl)-1,3,5-triazine, 2-[4-(2-ethoxyethyl)-1,3,5-triazine, 2-[4-(2-ethoxyethyl)-naphtho-1-yl]-4,6-bis(trichloromethyl)-1,3,5-triazine, 2-(4,7-dimethoxy-naphtho-1-yl)-4,6-bis (trichloromethyl)-1,3,5-triazine, and 2-(acenaphtho-5-yl)-4,6-bis (trichloromethyl)-1,3,5-triazine.

Examples of the compounds described in Germany Patent No. 3337024 include 2-(4-styrylphenyl)-4,6-bis (trichloromethyl)-1,3,5-triazine, 2-(4-(4-methoxystyryl) phenyl)-4,6-bis (trichloromethyl)-1,3,5-triazine, 2-(1-naphtylvinylenephenyl)-4,6-bis (trichloromethyl)-1,3,5-triazine, 2-chlorostyrylphenyl-4,6-bis (trichloromethyl)-1,3,5-triazine, 2-chlorostyrylphenyl-4,6-bis (trichloromethyl)-1,3,5-triazine, 2-(4-thiophene-2-vinylenephenyl)-4,6-bis (trichloromethyl)-1,3,5-triazine, 2-(4-thiophene-3-vinylenephenyl)-4,6-bis (trichloromethyl)-1,3,5-triazine, 2-(4-furan-2-binylenephenyl)-4,6-bis (trichloromethyl)-1,3,5-triazine, and 2-(4-benzofuran-2-vinylenephenyl)-4,6-bis(trichloromethyl)-1,3,5-triazine. Examples of the compounds described in the Journal of Organic Chemistry reported by F.C. Schaefer et al., 29,1527 (1964) include 2-methyl-4,6-bis (tribromomethyl)-1,3,5-triazine, 2,4,6-tris (tribromomethyl)-1,3,5-triazine, 2,4,6-tris (dibromomethyl)-1,3,5-triazine, 2-amino-4-methyl-6-tri (bromomethyl)-1,3,5-triazine, and 2-methoxy-4-methyl-6-trichloromethyl-1,3,5-triazine.

Examples of the compounds described in Japanese Patent Application Laid-Open (JP-A) No. 62-58241 include 2-(4-phenylethynylphenyl)-4,6-bis (trichloromethyl)-1,3,5-triazine, 2-(4-naphthyl-1-ethynylphenyl-4,6-bis (trichloromethyl)-1,3,5-triazine, 2-(4-(4-trylethynyl) phenyl)-4,6-bis (trichloromethyl)-1,3,5-triazine, 2-(4-(4-methoxyphenyl)ethynylphenyl)-4,6-bis (trichloromethyl)-1,3,5-triazine, 2-(4-(4-isopropylphenylethynyl) phenyl)-4,6-bis (trichloromethyl)-1,3,5-triazine, and 2-(4-(4-ethylphenylethynyl) phenyl)-4,6-bis (trichloromethyl)-1,3,5-triazine.

Examples of the compounds described in Japanese Patent Application Laid-Open (JP-A) No. 5-281728 include 2-(4-trifluoromethylphenyl)-4,6-bis (trichloromethyl)-1,3,5-triazine, 2-(2,6-difluorophenyl)-4,6-bis (trichloromethyl)-1,3,5-triazine, 2-(2,6-dichlorophenyl)-4,6-bis (trichloromethyl)-1,3,5-triazine, and 2-(2,6-dibromophenyl)-4,6-bis (trichloromethyl)-1,3,5-triazine.

Examples of the compounds described in Japanese Patent Application Laid-Open (JP-A) No. 5-34920 include 2,4-bis(trichloromethyl)-6-[4-(N,N-diethoxycarbonylmethylamine)-3-bromophenyl]-1,3,5-triazine, trihalomethyl-s-triazine compounds described in U.S Patent No. 4239850; and 2,4,6-tris(trichloromethyl)-s-triazine, and 2-(4-chlorophenyl)-4,6-bis (tribromomethyl)-s-triazine.

Examples of the compounds described in U.S Patent No. 4212976 include compounds each having an oxadiazole skeleton (such as 2-trichloromethyl-5-phenyl-1,3,4-oxadiazole, 2-trichloromethyl-5-(4-chlorophenyl)-1,3,4-oxadiazole, 2-trichloromethyl-5-(1-naphthyl)-1,3,4-oxadiazoke, 2-trichloromethyl-5-(2-naphthyl)-1,3,4-oxadiazole, 2-tribromomethyl-5-phenyl-1,3,4-oxadiazole, 2-tribromomethyl-5-(2-naphthyl)-1,3,4-oxadiazole; 2-trichloromethyl-5-styryl-1,3,4-oxadiazole, 2-trichloromethyl-5-(4-chlorstyryl)-1,3,4-oxadiazole, 2-trichloromethyl-5-(4-methoxystyryl)-1,3,4-oxadiazole, 2-trichloromethyl-5-(1-naphthyl)-1,3,4-oxadiazole, 2-trichloromethyl-5-(4-n-buthoxystyryl)-1,3,4-oxadiazole, and 2-tripromemethyl-5-styryl-1,3,4-oxadiazole).

Examples of oxime derivatives preferably used in the present invention include 3-benzoyloxyiminobutane-2-one, 3-acetoxyiminobutane-2-one, 3-propyolyloxyiminobutane-2-one, 2-acetoxyiminopenatane-3-one, 2-acetoxyimino-1-phenylpropane-1-one, 2-benzoyloxyimino-1-phenylpropane-1-one, 3-(4-toluenesulfonyloxy) iminobutane-2-one, and 2-ethoxycarbonyloxyimino-1-phenylpropane-1-one.

Examples of photopolymerization initiators other than those described above include acridine derivatives (such as 9-phenylacidine, 1,7-bis (9,9'-acridinyl) heptane), and N-phenylglycine; polyhalogen compounds (such as carbon tetrabromide, phenyltribromomethylsulfone, and phenyltrichloromethylketone); coumarins (such as 3-(2-benzofuroyl)-7-diethylaminocoumarin, 3-(2-benzofuroyl)-7-(1-pyrrolydinyl) coumarin, 3-benzoyl-7-diethylaminocoumarin, 3-(2-methoxybenzoyl)-7-diethylaminocoumarin, 3-(4-dimethylaminobenzoyl)-7-diethylaminocoumarin, 3,3'-carbonylbis (5,7-di-n-propoxycoumarin), 3,3'-carbonylbis (7-diethylaminocoumarin), 3-benzoyl-7-methoxycoumarin, 3-(2-furoyl)-7-diethylaminocoumarin, 3-(4-diethylaminocinnamoyl)-7-diethylaminocoumarin, 7-methoxy-3-(3-pyrizylcarbonyl) coumarin, 3-benzoyl-5,7-dipropoxycoumarin, 7-benzotriazole-2-ylcoumarin, and coumarins described in Japanese Patent Application Laid-Open (JP-A) Nos. 5-19475, 7-271028, 2002-363206, 2002-363207, 2002-363208, and 2002-363209; amines (such as ethyl 4-dimethylaminobenzoate, n-butyl 4-dimethylaminobenzoate, phenethyl 4-dimethylaminobenzoate, 2-phthalimideethyl 4-dimethylaminobenzoate, 2-methacryloyloxyethyl 4-dimethylaminobenzoate, pentamethylenebis (4-dimethylaminobenzoate), phenethyl of 3-dimethylaminobenzoate, pentamethylene esters, 3-dimethylaminobenzaldehyde, 2-chlor-4-dimethylaminobenzmodehyde, 4-dimethylaminobenzylalcohol, ethyl(e-dimethylaminebenzoyl)acetate, 4-pyperidinoacetophenone, 4-dimethylaminobenzoin, N,N-dimethyl-4-toluidine, N,N-diethyl-3-phenetidine, tribenzylamine, dibenzylphenylamine, N-methyl-N-phenylbenzylamine, 4-brom-N,N-dimethylaniline, tridodecylamine, aminofluorans (ODB, ODBII, etc.), crystal violet lactone, and leucocrystal violet); acylphosphine oxides (such as bis (2,4,6-trimethylbenzoyl)-phenylphosphine oxide, bis (2,6-dimethoxybenzoyl)-2,4,4-trimethyl-pentylphenylphosphine oxide, and LucirinTPO); metallocenes (such as bis (η5-2,4-chyclopentadiene-1-yl)-bis(2,6-diphloro-3-(1H-pyrrol-1-yl)-phenyl) titanium, η5-cyclopentadiethyl-η6-chlomenyl-iron (1+)-hexafluorophosphate (1-)); and compounds described in Japanese Patent Application Laid-Open (JP-A) No. 53-133428, Japanese Patent Application Publication (JP-B) Nos 57-1819, and 096, and U.S. Patent No. 3615455.

Examples of the ketone compound include benzophenone, 2-methylbenzophenone, 3-methylbenzophenone, 4-methylbenzophenone, 4-methoxybenzophenone, 2-chlorobenzophenone, 4-chlorobenzophenone, 4-bromobenzophenone, 2-carboxybenzophenone, 2-ethoxy carbonylbenzophenone, benzophenone tetracarboxylic acids or tetramethyl esters thereof; 4,4'-bis (dialkylamino)benzophenones (such as 4,4'-bis (dimethylamine)benzophenone, 4,4'-bisdicyclohexylamine) benzophenone, 4,4'-bis (diethylamine) benzophenone, 4,4'-bis (dihydroxyethylamine) benzophenone, 4-methoxy-4'-dimethylaminobenzophenone, 4,4'-dimethoxybenzophenone, 4-dimethylaminobenzophenone, 4-dimethylaminoacetophenone, benzyl, anthraquinone, 2-t-butylanthraquinone, 2-methylanthraquinone, phenanthraquinone, xanthone, thioxanthone, 2-chlor-thioxanthone, 2,4-diethylthioxanthone, fluorenone, 2-benzyl-dimethylamino-1-(4-morphorinophenyl)-1-butanone, 2-methyl-1-[4-(methylthio) phenyl]-2-morphorino-1-propanone, 2-hydroxy-2-methyl-[4-(1-methylvinyl) phenyl] propanol oligomer, benzoin, benzoin ethers (such as benzoin methyl ether, benzoin ethyl ether, benzoin propyl ether, benzoin isopropyl ether, benzoin phenyl ether, and benzyldimethyl ketal), acridone, chloroacridone, N-methylacridone, N-butylacridone, and N-butyl-chloroacridone.

The content of solid components of the photopolymerization initiator in the solid content of the photosensitive composition is preferably 0.1 % by mass to 30% by mass, more preferably 0.5 % by mass to 20% by mass, and still more preferably 0.5% by mass to 15% by mass. When the content of the solid components is less than 0.1% by mass, the sensitivity of the photosensitive transfer material may be insufficient, and the film hardness of the hardened photosensitive transfer material may be reduced. When the content of the solid components is more than 30% by mass, the solid components may be likely to precipitate from the photosensitive layer.

To control the exposure sensitivity and sensitivity wavelength during exposure of the photosensitive layer, a photosensitizer may be added in addition to the photopolymerization initiator.
The photosensitizer may be suitably selected depending on the type of visible light, ultraviolet ray, and visible laser as a light irradiation unit, which will be hereinafter described.

The photosensitizer may be excited by active energy ray, and may generate a radical, an available acidic group and the like through interaction with other substances such as radical generators and acid generators by transferring energy or electrons.

The photosensitizer is not particularly limited and may be suitably selected from among photosensitizers known in the art. Examples thereof include conventional polynucleic aromatic series such as pyrene, perylene, and triphenylene; xanthenes such as fluorescein, eosine, erythrosine, Rhodamine B, rose bengal; cyanines such as indocarbocyanine, thiacarbocyanine, and oxacarbocyanine); merocyanines such as merocyanine, and carbomerocyanine; thiazines such as thionine, methylene blue, Toluidine blue; acridines such as acridine orange, chloroflavin, and acryflavin; anthraquinones such as anthraquinon; squaryliums such as squarylium, acridones such as acridone, chloroacridone, N-methylacridone, N-butylacridone, and N-butyl-chloroacridone; coumarins such as 3-(2-benzofuroyl)-7-diethylaminocoumarin, 3-(2-benzofuroyl)-7-(1-pyrrolidinyl) coumarin, 3-benzoyl-7-diethylaminocoumarin, 3-(2-methoxybenzoyl)-7-diethylaminocoumarin, 3-(4-dimethylaminobenzoyl)-7-diethylaminocoumarin, 3,3'-carbonylbis(5,7-di-n-propoxycoumarin), 3,3'-carbonylbis (7-diethylaminocoumarin), 3-benzoyl-7-methoxycoumarin, 3-(2-furoyl)-7-diethylaminocoumarin, 3-(4-diethylaminocinnamoyl)-7-diethylaminocoumarin, 7-methoxy-3-(3-pyridylcarbonyl) coumarin, 3-benzoyl-5,7-dipropoxycoumarin, and coumarin compounds described in Japanese Patent Application Laid-Open (JP-A) Nos. 05-19475, 07-271028, 2002-363206, 2002-363207, 2002-363208, and 2002-263209.

As for the combination of the photopolymerization initiator and the photosensitizer, the initiating mechanism that involves electron transfer may be exemplified such as combinations of (1) an electron donating initiator and a photosensitizer dye, (2) an electron accepting initiator and a photosensitizer dye, and (3) an electron donating initiator, a photosensitizer dye, and an electron accepting initiator (ternary initiating mechanism) as described in JP-A No.

2001-305734.

The content of the photosensitizer is preferably 0.05 % by mass to 30 % by mass relative to the total components of the photosensitive resin composition, more preferably 0.1 % by mass to 20 % by mass, and still more preferably 0.2 % by mass to 10 % by mass.

When the content of the photosensitizer is less than 0.05 % by mass, the photosensitivity to active energy ray may decrease, and the exposing process may take time, resulting in decreased productivity. When the content of the photosensitizer is more than 30 % by mass, the photosensitizer may be precipitated from the photosensitive layer.

Each of the photopolymerization initiators may be used alone or in combination with two or more.

Particularly preferred examples of the photopolymerization initiator include combined photopolymerization initiators of any one of the phosphine oxides, the α-aminoalkylkeones, and halogenated hydrocarbon compounds each having a triazine skeleton which are available for laser beam having a wavelength of 405 nm in the exposure which will be hereinafter described with any one of amine compounds which will be hereinafter described, as a photosensitizer; hexaarylbiimidazole compounds; or titanocenes.

The content of the photopolymerization initiator in the photosensitive composition is preferably 0.1% by mass to 30% by mass, more preferably 0.5% by mass to 20% by mass, and still more preferably 0.5% by mass to 15% by mass.

- Other Components -

As for the other components, thermocrosslinker, thermopolymerization inhibitor, plasticizer, colorant (color pigment or dye), and extender pigment are exemplified; in addition, adhesion promoter for substrate surface, thermosetting promoter, and the other auxiliaries such as conductive particles, filler, defoamer, fire retardant, leveling agent, peeling promoter, antioxidant, perfume, adjustor of surface tension, chain transfer agent may be utilized together with the photopolymerization initiators set forth above. By suitably containing these components in the components of a photosensitive transfer material, properties such as stability, photographic property, image-developing property, and film property of the photosensitive transfer material can be controlled.

- Thermocrosslinker -

The photosensitive composition preferably contains a thermocrosslinker. The thermocrosslinker is not particularly limited and may be suitably selected in accordance with the intended use, however, the thermocrosslinker is preferably an alkylated methylol melamine.

As the thermocrosslinker, in order to increase the strength of the surface of the photosensitive layer to be formed using the photosensitive composition, a polymer which is insoluble in alkaline aqueous solutions such as epoxy resin, and melamine resins may be added in an amount where the addition of the polymer does not adversely affect the developing property. Each of these thermocrosslinkers may be used alone or in combination with two or more. Of these, alkylated methylol melamine is preferable in terms that the storage stability is excellent, and it is effective in improving the surface hardness of the photosensitive layer and the film strength of the hardened film itself.

The content of solid components of the thermocrosslinker in the solid content of the photosensitive composition is preferably 1% by mass to 40% by mass, more preferably 3% by mass to 30% by mass, and still more preferably 5% by mass to 25% by mass. When the content of the solid components is less than 1 % by mass, enhancement of the film strength may not be observed in the hardened film. When the content of the solid components is more than 40% by mass, the developing property and the exposure sensitivity may degrade.

- Thermopolymerization Inhibitor -

The thermopolymerization inhibitor may be added to prevent thermal polymerization or temporal polymerization of the polymerizable compound contained in the photosensitive layer.

Examples of the polymerization inhibitor include 4-methoxyphenol, hydroquinone, alkyl or aryl group-substituted hydroquinone, t-butyl catechol, pyrogallol, 2-hydroxybenzophenone, 4-methoxy-2-hydroxybenzophenone, cuprous chloride, phenothiazine, chloranil, naphthylamine, β-naphthol, 2,6-di-t-butyl-4-cresol, 2,2'-methylenbis (4-methyl-6-t-butylphenol), pyridine, nitrobenzene, dinitrobenzene, picric acid, 4-toluidine, methylene blue, reactants between copper and organic chelate agent, methyl salicylate, phenothiazine, nitroso compounds, and chelates between nitroso compound and Al.

The content of the thermopolymerization inhibitor relative to the polymerizable compound of the photosensitive layer is preferably 0.001 % by mass to 5 % by mass, more preferably 0.005 % by mass to 2 % by mass, and still more preferably 0.01 % by mass to 1 % by mass.

When the content of the thermopolymerization inhibitor is less than 0.001 % by mass, the storage stability of the pattern forming material may degrade. When the content of the thermopolymerization inhibitor is more than 5 % by

mass, the photosensitivity to active energy ray may decrease.

The photosensitive composition containing the thermopolymerization inhibitor can prevent thermal polymerization or temporal polymerization of the polymerizable compound (B).

The color pigment is not particularly limited and may be suitably selected in accordance with the intended use, and examples thereof include Victoria Pure Blue BO (C.I. 42595), auramine (C.I. 41000), Fat Black HB (C.I. 26150), Monolight Yellow GT (C.I. Pigment Yellow 12), Permanent Yellow GR (C.I. Pigment Yellow 17), Permanent Yellow HR (C.I. Pigment Yellow 83), Permanent Carmine FBB (C.I. Pigment Red 146), Hoster Balm Red ESB (C.I. Pigment Violet 19), Permanent Ruby FBH (C.I. Pigment Red 11), Fastel Pink B Spura (C.I. Pigment Red 81), Monastral Fast Blue (C.I. Pigment Blue 15), Monolight Fast Black B (C.I. Pigment Black 1), and carbon, C.I. Pigment Red 97, C.I. Pigment Red 122, C.I. Pigment Red 149, C.I. Pigment Red168, C.I. Pigment Red 177, C.I. Pigment Red 180, C.I. Pigment Red 192, C.I. Pigment Red 215, C.I. Pigment Green 7, C.I. Pigment Green 36, C.I. Pigment Blue 15:1, C.I. Pigment Blue 15:4, C.I. Pigment Blue 15:6, C.I. Pigment Blue 22, C.I. Pigment Blue 60, and C.I. Pigment Blue 64. Each of these color pigments may be used alone or in combination with two or more.

The content of solid components of the color pigment in the solid content of the photosensitive composition may be determined in view of the exposure sensitivity and resolution of the photosensitive layer when forming a pattern and varies depending on the type of the color pigment, however, typically, the content of the solid components is preferably 0.05% by mass to 10% by mass, more preferably 0.075 % by mass to 8 % by mass, and still more preferably 0.1 % by mass to 5 % by mass.

The extender pigment is not particularly limited and may be suitably selected from among those known in the art, and examples thereof include organic or inorganic fine particles of kaolin, barium sulfate, silicon oxide powder, finely powdered silicone oxide, amorphous silica, crystalline silica, molten silica, spherically shaped silica, talc, clay, magnesium carbonate, calcium carbonate, aluminum oxide, aluminum hydroxide, mica, and the like.

The average particle diameter of the extender pigment is preferably less than 10 μm, and more preferably 3 μm or less. When the average particle diameter of the extender pigment is more than 10 μm, the resolution of the photosensitive transfer material may degrade due to light scattering.

The organic fine particles are not particularly limited and may be suitably selected in accordance with the intended use, and examples thereof melamine resins, benzoguanamine resins, and crosslinkable polystyrene resins. In addition, spherically shaped porous fine particles composed of a silica or a crosslinkable resin having an average particle diameter of 1 μm to 5 μm and an oil absorption of 100 $m^2/g$ to 200 $m^2/g$ and or the like can be used.

The addition amount of the extender pigment is preferably 5% by mass to 60 % by mass, more preferably 10 % by mass to 50 % by mass, and still more preferably 15 % by mass to 45 % by mass. When the addition amount of the extender pigment is less than 5 % by mass, the coefficient of linear expansion may not be sufficiently reduced. When the addition amount is more than 60 % by mass, when a hardened film is formed on the surface of the photosensitive layer, the hardened film may be brittle, and when an interconnection pattern is formed using a pattern, the function of the interconnection serving as a protective film may be impaired.

The photosensitive composition containing the extender pigment can improve the surface hardness of a pattern or keep the coefficient of linear expansion low or keep the dielectric constant and dielectric tangent of the hardened film itself.

Preferred examples of the adhesion promoter set forth above include adhesion promoters described in Japanese Patent Application Laid-Open (JP-A) Nos. 5-11439, 5-341532, and 6-43638. Specific examples of the adhesion promoters are benzimidazole, benzoxazole, benzthiazole, 2-mercaptobenzimidazole, 2-mercaptobenzoxazole, 2-mercaptobenzthiazole, 3-morpholinomethyl-l-phenyl-triazole-2-thion, 3-morpholinomethyl-5-phenyl-oxadiazole-2-thion, 5-amino-3-morpholinomethyl-thiadiazole-2-thion, 2-mercapto-5-methylthio-thiadiazole, triazole, tetrazole, benzotriazole, carboxybenzotriazole, benzotriazole containing an amino group, and silane coupling agents.

The content of the adhesion promoter is preferably 0.001 % by mass to 20 % by mass relative to the total components of the photosensitive composition, more preferably 0.01 % by mass to 10 % by mass, and still more preferably 0.1% by mass to 5 % by mass.

The photosensitive composition containing the adhesion promoter can improve the adhesion between respective layers or the adhesion between a photosensitive layer and a substrate.

The photosensitive composition may further contain a thermosetting promoter.

The content of the thermosetting promoter is preferably 0.005 % by mass to 20 % by mass relative to the total components of the photosensitive composition, more preferably 0.01 % by mass to 15 % by mass, and still more preferably 0.025% by mass to 12 % by mass.

The thickness of the photosensitive layer in the photosensitive transfer material is not particularly limited and may be suitably adjusted in accordance with the intended use, however, it is preferably 3 μm to 100 μm, more preferably 5 μm to 70 μm, and still more preferably 10 μm to 50 μm.

The method of preparing the photosensitive transfer material is not particularly limited and may be suitably selected in accordance with the intended use, and examples thereof include a method in which at least any one of a

composition constituting the oxygen insulation layer and a composition constituting the cushion layer is dissolved, emulsified, or dispersed in water or a solvent to prepare a solution, the solution is directly applied over a surface of the support, and the support surface is dried to form at least any one of the oxygen insulation layer and the cushion layer on the support, then a solution for the photosensitive composition is prepared in a similar manner to the solution set forth above, the photosensitive composition solution is applied over a surface of at least any one of the oxygen insulation layer and the cushion layer, the surface thereof is dried to thereby form the layers in a laminar structure on the support; and a method in which the photosensitive composition solution is applied over a surface of a provisional support, the support surface is dried to form a photosensitive layer, and the photosensitive layer is transferred onto at least any one of the oxygen insulation layer and the cushion layer formed on the above noted support.

The solvent is not particularly limited and may be suitably selected in accordance with the intended use. Examples thereof include alcohols such as methanol, ethanol, n-propanol, isopropanol, n-butanol, sec-butanol, and n-hexanol; ketones such as acetone, methylethylketone, methylisobutylketone, cyclohexanon, and diisobutylketone; esters such as ethyl acetate, butyl acetate, n-amyl acetate, methyl sulfate, ethyl propionate, dimethyl phthalate, ethyl benzoate, and methoxy propyl acetate; aromatic hydrocarbons such as toluene, xylene, benzene, ethyl benzene; halogenated hydrocarbons such as carbon tetrachloride, trichloroethylene, chloroform, 1,2,1-trichloroethane, methylene chloride, and monochlorobenzene; ethers such as tetrahydrofuran, diethyl ether, ethyleneglycol monomethyl ether, ethyleneglycol monoethyl ether, 1-methoxy-2-propanol; dimethylformamide, dimethylacetoamide, dimethylsulfoxide, and sulfolane. Each of these solvents may be used alone or in combination with two or more. Further, a surfactant known in the art may be added to the solvent.

The method of applying the solution is not particularly limited and may be suitably selected in accordance with the intended use, and examples thereof include a method in which the solution is directly applied over a surface of the support using a spin-coater, a slit spin coater, a roll coater, a die coater, or a curtain coater.

The conditions of the drying the surfaces vary depending on the respective components, the type of the solvent, the used component ratio, and the like, however, typically, the surfaces are dried at a temperature of 60°C to 110°C for 30 seconds to 15 minutes.

In the photosensitive transfer material, for example, it is preferable that the photosensitive layer is coated with a protective film before the photosensitive transfer material is laminated on a substrate. The protective film is attached to the photosensitive layer surface to prevent contamination and damages of the photosensitive layer during conveyance thereof and is peeled off from the photosensitive layer when the photosensitive transfer layer is laminated on a substrate.

Examples of materials of the protective film include the same materials as used for the support, silicone papers, polyethylene, papers laminated with polypropylene, and polyolefin or polytetrafluoroethylene sheets. Of these, polyethylene films and polypropylene films are preferable.

The thickness of the protective film is not particularly limited and may be suitably adjusted in accordance with the intended use, however, it is preferably 5 $\mu$m to 100 $\mu$m, 8 $\mu$m to 50 $\mu$m, and still more preferably 10 $\mu$m to 40 $\mu$m.

When the protective film is used, it is preferable that an adhesive force A between the oxygen insulation layer and the support, an adhesive force B between the oxygen insulation layer and the photosensitive layer, and an adhesive forth C between the photosensitive layer and the protective film satisfy the relation, adhesive force B > adhesive forth A > adhesive forth C.

Examples of material combinations of the support and the protective film (support/protective film) include polyethylene terephthalate/polypropylene, polyethylene terephthalate/polyethylene, polyvinylchloride/cellophane, polyimide/polypropylene, and polyethylene terephthalate/ polyethylene terephthalate. The relation of adhesive forces set forth above can be satisfied by subjecting at lest any one of the support and the protective film to a surface treatment. The surface treatment of the support may be provided to increase the adhesive force with the photosensitive layer. Examples of the surface treatment include forming an undercoat layer on the support, corona discharge treatment, flame treatment, ultraviolet ray irradiation treatment, radiofrequency irradiation treatment, glow discharge treatment, active plasma irradiation treatment, and laser beam irradiation treatment.

The coefficient of static friction between the support and the protective film is preferably 0.3 to 1.4, and more preferably 0.5 to 1.2.

When the coefficient of static friction is less than 0.3, rolling displacement may be caused due to excessive slippage, and when the coefficient of static friction is more than 1.4, it may be difficult to roll the photosensitive transfer material in an excellent roll configuration.

The protective film may be subjected to a surface treatment to control the adhesive force between the protective film and the photosensitive layer. The surface treatment may be performed, for example, by forming an undercoat layer made of a polymer such as polyorganosiloxane, fluorinated polyolefin, polyfluoroethylene, and polyvinyl alcohol on a surface of the protective film. The undercoat layer can be formed by applying a coating solution of the polymer over a surface of the protective film, and drying the protective film surface at a temperature ranging from 30°C to 15030°C (particularly, at 50°C to 120°C) for 1 minute to 30 minutes.

For the configuration of the photosensitive transfer material, both a roll configuration and a laminated sheet

configuration are preferable. For example, it is preferable that the photosensitive transfer material is formed in an elongated sheet and rolled in a roll configuration for storage. The length of the elongated photosensitive transfer material is not particularly limited and may be suitably selected from 10 m to 20,000 m, for example. The photosensitive transfer material may be subjected to slit processing in a user-friendly manner such that the elongated photosensitive transfer material of 100 m to 1,000 m is formed in a roll configuration. In this case, it is preferable that the photosensitive transfer material is wound to a cylindrical core tube such that the support appears at the outermost. Further, the rolled photosensitive transfer material may be slit in sheet-like shape. During storage period, preferably a separator which is moisture proof and contains a drying agent is arranged at the end faces from the perspective of protection of the end faces and preventing edge fusion; and a material of lower moisture vapor permeability is preferably used for packaging.

The photosensitive transfer material of the present invention can prevent light fog under safelight, has small surface tucking property, is excellent in laminating property, handleability, and storage stability, and has a photosensitive layer on which a photosensitive composition is laminated, the photosensitive composition can exert excellent chemical resistance, surface hardness, heat resistance, and the like after the photosensitive transfer material is developed. For the reasons, the photosensitive transfer material can be widely used in forming patterns such as for printed wiring boards, display members such as column members, rib members, spacers, and partition members, hologram, micromachine, and proof. The photosensitive transfer material can be preferably used in the pattern forming process of the present invention and other pattern forming processes.

Particularly, since the film thickness of the photosensitive transfer material of the present invention is uniform, the photosensitive transfer material can be more finely laminated on a surface of a substrate.

(Pattern)

A pattern of the present invention can be obtained by laminating the photosensitive transfer material of the present invention on a surface of a substrate under at least any one of heating and pressurizing conditions according to the pattern forming process of the present invention, and then exposing and developing the photosensitive transfer material surface.

The pattern of the present invention can be preferably used in forming various patterns such as for printed wiring boards, color filters, display members such as column members, rib members, spacers, and partitions, holograms, micromachine, and proofs, and can be particularly preferably used as a color filter for printed substrate or liquid crystal display (LCD).

(Pattern Forming Process)

The pattern forming process of the present invention includes at least a lamination step, an exposure step, and a developing step, and further includes other suitably selected steps.

Preferred examples of the pattern forming process of the present invention include a pattern forming process which includes laminating a photosensitive layer on a surface of a substrate to cover the substrate surface with a photo solder resist, exposing the photosensitive layer surface, and developing the photosensitive layer surface to leave the photosensitive layer in a predetermined pattern on the substrate surface, thereby forming the predetermined pattern on the substrate.

For the pattern forming process of the present invention, it is preferable that a pattern formed after developing forms at least any one of a protective film and an interlayer insulation film.

[Lamination Step ]

The lamination step is a step in which a photosensitive transfer material is laminated on a surface of a substrate under at least any one of heating and pressurizing conditions such that the photosensitive layer exists on the surface of the substrate.

When the photosensitive transfer material has a protective film which will be hereinafter described, it is preferable that the protective film is peeled off from the photosensitive transfer material and the photosensitive transfer material is laminated on the substrate such that the photosensitive layer laps over the substrate.

The pressure of the pressurizing is not particularly limited and may be suitably selected in accordance with the intended use. For example, the pressure is preferably 0.01 MPa to 1.0 MPa, and more preferably 0.05 MPa to 1.0 MPa.

An apparatus used for performing at least any one of the heating and pressurizing is not particularly limited and may be suitably selected in accordance with the intended use. Preferred examples thereof include heat pressers, heat roll laminators (for example, VP-II manufactured by Taisei Laminator Co., Ltd.), vacuum laminators (for example, MVLP500 manufactured by MEIKI CO., LTD.).

< Substrate >

Material of the substrate used in the step of forming a photosensitive layer is not particularly limited and may be suitably selected from among materials known in the art ranging from those having high surface smoothness to those each having convexoconcave thereon. However, a plate-like base material (substrate) is preferable, and specific examples thereof include known substrates for forming printed wiring boards (such as copper clad laminate), glass plates (such as soda glass plate), synthetic resin films, papers, and metal plates.

[Exposure Step]

The exposure step is a step in which the support is peeled off from the photosensitive transfer material and then the photosensitive layer is exposed.

By peeling off the support from the photosensitive transfer material, it is possible to prevent light scattering, refraction, and the like generated from the support from affecting an image to be formed on the photosensitive composition layer and prevent to cause a blur image, and then a predetermined pattern can be obtained with high resolution.

The exposure step preferably includes a step in which light beam from the light irradiation unit is modulated by means of a light modulating unit having "n" imaging portions which can receive the laser beam from the light irradiating unit and can output the light beam, and then the photosensitive layer laminated on the substrate in the lamination step is exposed through the oxygen insulation layer with the light beam passed through a microlens array having an array of microlenses each having a non-spherical surface capable of compensating the aberration due to distortion at irradiating surfaces of the imaging portions in the light modulating unit.

In the exposure step, the light beam applied from the light irradiation unit is not particularly limited and may be suitably selected in accordance with the intended use. Examples thereof include electromagnetic rays which activate photopolymerization initiators and sensitizers, lights ranging from ultraviolet rays to visible lights, electron beams, X rays, and laser beams. Of these, a laser beam allowing for performing on/ off control of light for a short time and easy light interference control.

The wavelength of the lights ranging from ultraviolet rays to visible lights is not particularly limited and may be suitably selected in accordance with the intended use, however, it is preferably 330 nm to 650 nm, more preferably 395 nm to 415 nm, and still more preferably 405 nm for the purpose of shortening the exposing time of the photosensitive composition.

The light irradiation unit using the light irradiation unit is not particularly limited and may be suitably selected in accordance with the intended use. Examples thereof include a method in which the photosensitive composition is irradiated with a conventional light source such as high pressure mercury lamp, xenon lamp, carbon arc lamp, halogen lamp, cold- cathode tube, LED, and semiconductor laser. It is preferable two or more types of light from these light sources are combined to irradiate the photosensitive composition with the light, and it is more preferable to irradiate the photosensitive composition with those containing two or more types of light (hereinafter, sometimes referred to as "combined laser").

The method of applying the combined laser is not particularly limited and may be suitably selected in accordance with the intended use, however, a method is preferably exemplified in which a combined laser is constituted with plural laser light sources, a multimode optical fiber, and a collecting optical system that collects respective laser beams emitted from the plural laser light sources and connect them to the multimode optical fiber to irradiate the photosensitive composition.

In the exposure step, the method of modulating the light beam is not particularly limited and may be suitably selected in accordance with the intended use as long as the light beam can be modulated by a light modulating unit having "n" imaging portions which can receive the laser beam from the light irradiation unit and output the laser beam, however, a method is preferably exemplified in which any imaging portions of less than arbitrarily selected "n" imaging portions disposed successively from among the "n" imaging portions are controlled depending on the information of a pattern to be formed.

The number of imaging portions ("n") contained in the light modulating unit may be properly selected in accordance with the intended use.

The alignment of imaging portions in the light modulating unit may be properly selected in accordance with the intended use; preferably, the imaging portions are arranged two dimensionally, more preferably are arranged into a lattice pattern.

The method of modulating a light beam is not particularly limited and may be suitably selected in accordance with the intended use, however, a method is preferably exemplified in which the light modulating unit is a spatial light modulator.

The spatial light modulator is not particularly limited and may be suitably selected in accordance with the intended use, however, preferred examples thereof include digital micromirror devices (DMDs), spatial light modulators

(SLM) of micro electro mechanical system type (MEMS), PLZT elements or optical elements which modulate transmitted light by the effect of electrooptics, and liquid crystal shatters (FLC). Of these, the DMDs are preferable.

In the exposure step, the light beam modulated by the light modulation unit is made to pass thorough a microlens array having an array of microlenses each having a non-spherical surface capable of compensating the aberration due to distortion at irradiating surfaces of the imaging portions.

The microlenses arranged in the microlens array are not particularly limited and may be suitably selected in accordance with the intended use as long as each of the microlenses has a non-spherical surface, however, it is preferable that the non-spherical surface is a toric surface.

Further, in the exposure step, the light beam modulated by the light modulating unit is preferably made to pass through an aperture array, a combined optical system, and other suitably selected optical system.

In the exposure step, the method of exposing the photosensitive layer is not particularly limited and may be suitably selected in accordance with the intended use. Examples thereof include digital exposure, and analog exposure; of these, digital exposure is preferable.

The method of performing the digital exposure is not particularly limited and may be suitably selected in accordance with the intended use. For example, it is preferable that the photosensitive layer is digitally exposed using a modulated laser beam according to control signals generated based on the information of a predetermined pattern.

Further, in the exposure step, the method of exposing the photosensitive layer is not particularly limited and may be suitably selected in accordance with the intended use, however, from the perspective of allowing for high-speed exposure for a short time, it is preferable to expose the photosensitive layer while relatively moving the exposure light and the photosensitive layer, and it is particularly preferable to expose the photosensitive layer with the digital micromirror device (DMD) set forth above.

A pattern forming apparatus including the light modulating unit will be exemplarily explained with reference to figures in the following.

FIG. 7 is a schematic perspective view that shows exemplarily appearance of a pattern forming apparatus.

The pattern forming apparatus containing the light modulating unit is equipped with flat stage 152 that absorbs and sustains sheet-like pattern forming material 150 on the surface. On the upper surface of thick plate table 156 supported by four legs 154, two guides 158 are disposed that extend along the stage moving direction. Stage 152 is disposed such that the elongated direction faces the stage moving direction, and supported by guide 158 in reciprocally movable manner. A driving device is equipped with the pattern forming apparatus (not shown) so as to drive stage 152 along guide 158.

At the middle of the table 156, gate 160 is provided such that gate 160 strides the path of stage 152. The respective ends of the gate 160 are fixed to both sides of the table 156. Scanner 162 is provided at one side of gate 160, plural (e.g. two) detecting sensors 164 are provided at the opposite side of gate 160 in order to detect the front and rear ends of pattern forming material 150. Scanner 162 and detecting sensor 164 are mounted on gate 160 respectively and disposed stationarily above the path of stage 152. Scanner 162 and detecting sensor 164 are connected to a controller (not shown) that controls them.

FIG. 8 is a schematic perspective view that shows exemplarily a scanner construction of a pattern forming apparatus. FIG. 9A is an exemplary plan view that shows exposed regions formed on a pattern forming material. FIG. 9B is an exemplary plan view that shows an alignment of regions exposed by respective exposing heads.

As shown in FIGS. 8 and 9B, scanner 162 contains plural (e.g. fourteen) exposing heads 166 that are arrayed in substantially matrix of "m rows $\times$ n lines" (e:g. three $\times$ five). In this example, four exposing heads 166 are disposed at the third line considering the width of pattern forming material 150. The specific exposing head at "m" th row and "n" th line is expressed as exposing head $166_{mn}$ hereinafter.

The exposing area 168 formed by exposing head 166 is rectangular having the shorter side in the sub-scanning direction. Therefore, exposed areas 170 are formed on pattern forming material 150 of a band shape that corresponds to the respective exposing heads 166 along with the movement of stage 152. The specific exposing area corresponding to the exposing head at "m" th row and "n" th line is expressed as exposing area $168_{mn}$ hereinafter.

As shown in FIGS. 9A and 9B, each of the exposing heads at each line is disposed with a space in the line direction so that exposed regions 170 of band shape are arranged without space in the perpendicular direction to the sub-scanning direction (space: (longer side of exposing area) $\times$ natural number; two times in this example). Therefore, the non-exposing area between exposing areas $168_{11}$ and $168_{12}$ at the first raw can be exposed by exposing area $168_{21}$ of the second raw and exposing area $168_{31}$ of the third raw.

FIG. 10 is a schematic perspective view that shows exemplarily an exposing head including a light modulating unit.

Each of exposing heads $166_{11}$ to $166_{mn}$ is, as shown in FIG. 10, provided with a digital micromirror device (may be referred to as "DMD") 50 (manufactured by US Texas Instruments Inc.) as a light modulating unit (or spatial light modulator configured to modulate light beam on a pixel to pixel basis) that modulates the incident light beam depending on the pattern information; at the incident laser side of DMD 50, fiber array laser source 66 that is equipped with a laser

irradiating part where irradiating ends or emitting sites of optical fibers are arranged in an array along the direction corresponding with the longer side of exposing area 168, lens system 67 that compensates the laser beam emitted from fiber array laser source 66 and collects it on the DMD, mirrors 69 that reflect laser beam through lens system 67 toward DMD 50, imaging optical system 51 configured to form an image on the pattern forming material 150. FIG. 10 schematically shows lens system 67.

FIG. 12 shows an exemplary controller configured to control the DMD based on pattern information.

Each DMD 50 is connected to controller 302 that contains a data processing part and a mirror controlling part as shown in FIG.12. The data processing part of controller 302 generates controlling signals to control and drive the respective micromirrors in the areas to be controlled for the respective exposing heads 166 based on the input pattern information. The area to be controlled will be explained later. The mirror driving-controlling part controls the reflective surface angle of each micromirror of DMD 50 per each exposing head 166 based on the control signals generated at the pattern information processing part.

FIG. 1 is a partially enlarged view that shows exemplarily a construction of a digital micromirror device (DMD) as the light modulating unit set forth above.

As shown in FIG. 1, DMD 50 is a mirror device that has lattice arrays of many micromirrors 62, e.g. 1024 × 768, on SRAM cell or memory cell 60 as shown in FIG. 1, wherein each of the micromirrors serves as an imaging portion. At the upper most portion of the each imaging portion, micromirror 62 is supported by a pillar. A material having a higher reflectivity such as aluminum is vapor deposited on the surface of the micromirror. The reflectivity of the micromirrors 62 is 90 % or more; the array pitches in longitudinal and width directions are respectively 13.7 μm, for example. Further, SRAM cell 60 of a silicon gate CMOS produced by conventional semiconductor memory production processes is disposed just below each micromirror 62 through a pillar containing a hinge and yoke. The mirror device is entirely constructed as a monolithic body.

FIGS. 2A and 2B are respectively a view that exemplarily explains the motion of the DMD.

When a digital signal is written into SRAM cell 60 of DMD 50, micromirror 62 supported by a pillar is inclined toward the substrate, on which DMD 50 is disposed, within ± alpha degrees e.g. 12 degrees around the diagonal as the rotating axis. FIG. 2A indicates the condition that micromirror 62 is inclined + alpha degrees at on state, FIG. 2B indicates the condition that micromirror 62 is inclined - alpha degrees at off state.

Therefore, each incident laser beam B on DMD 50 is reflected depending on each inclined direction of micromirrors 62 by controlling each inclined angle of micromirrors 62 in imaging portions of DMD 50 depending on pattern information as shown in FIG.1.

FIG.1 exemplarily shows a condition where the micromirrors 62 are controlled to be inclined + alpha degrees or - alpha degrees. The on/ off control of the respective micromirrors 62 is performed by the controller 302 connected to the DMD 50. In the direction where the laser beam B reflected by the micromirrors 62 in off state, a not shown light absorber is arranged.

Preferably, the DMD 50 is slightly inclined such that the shorter side thereof is arranged with the sub-scanning direction at a given angle 6 (for example, 0.1° to 5°).

FIG. 3A shows a scanning track of reflected light beam image (exposure beam) 53 based on the respective micromirrors in the case where the DMD is not inclined, and FIG. 3B shows a scanning track of the exposure beam 53 in the case where the DMD is inclined.

As shown in FIG. 3B, in DMD 50, many micromirrors, e.g. 1024, are disposed in the longer direction to form one array, and many arrays, e.g. 756, are disposed in the shorter direction. Thus, by means of inclining DMD 50 as shown in FIG. 3B, the pitch Pi of scanning traces or lines of exposing beam 53 from each micromirror may be reduced than the pitch $P_2$ of scanning traces or lines of exposing beam 53 without inclining DMD 50, thereby the resolution may be improved remarkably. In contrast; the inclined angle of DMD 50 is small, therefore, the scanning direction $W_2$ when DMD 50 is inclined and the scanning direction $W_1$ when DMD 50 is not inclined are approximately the same.

The high rate modulation will be explained in the following.

When laser beam B is applied from fiber array laser source 66 to DMD 50, the reflected laser beam, at the micromirrors of DMD 50 being on state, is imaged on pattern forming material 150 by lens systems 54 and 58. In this way, the laser beam applied from the fiber array laser source is turned into on or off for each imaging portion, and the pattern forming material 150 is exposed in approximately the same number of imaging portion units or exposing areas 168 as the imaging portions utilized in DMD 50. In addition, when the pattern forming material 150 is conveyed with stage 152 at a constant rate, the pattern forming material 150 is sub-scanned to the direction opposite to the stage moving direction by scanner 162, thus exposed regions 170 of band shape are formed correspondingly to the respective exposing heads 166.

Since there exist a limit in the data processing rate of DMD 50 and the modulation rate per one line is defined in proportion to the utilized imaging portion number, partial utilization of micromirror arrays leads to higher modulation rate per one line. Further, when exposing is carried out by moving continuously the exposing head relative to the exposing surface, the entire imaging portions are not necessarily required for use in the sub-scanning direction.

In this example, micromirrors are disposed on DMD 50 as 1,024 arrays in the main-scanning direction and 768 arrays in the sub-scanning direction as shown in FIGS. 4A and 4B. Among these micromirrors, a part of micromirrors, e.g. 1,024 × 256, may be controlled and driven by the controller 302.

FIGS. 4A and 4B are respectively an exemplary view that shows an available region of the DMD.

As shown in FIG. 4A, the micromirror arrays disposed at the central area of DMD 50 may be employed as shown in FIG. 4A; alternatively, the micromirror arrays disposed at the edge portion of DMD 50 may be employed as shown in FIG. 4B. In addition, when micromirrors are partly damaged, the utilized micromirrors may be properly altered depending on the situations such that micromirrors with no damage are utilized.

For example, when 384 arrays are utilized among the 768 arrays of micromirrors, the modulation rate may be enhanced two times per one line as compared to the modulation rate when utilizing all of 768 arrays; further, when 256 arrays are utilized among the 768 arrays of micromirrors, the modulation rate may be enhanced three times as compared to the modulation rate when utilizing all of 768 arrays.

As explained above, according to the pattern forming process of the present invention, when DMD 50 is provided with 1,024 micromirror arrays in the main-scanning direction and 768 micromirror arrays in the sub-scanning direction, controlling and driving of partial micromirror arrays may lead to higher modulation rate per one line compared to the modulation rate in the case of controlling and driving of entire micromirror arrays.

In addition to the controlling and driving of partial micromirror arrays, with the use of an elongated DMD on which many micromirrors are disposed on a substrate in planar arrays may similarly increase the modulation rate when the each angle of reflected surface is changeable depending on the various controlling signals, and the substrate is longer in a specific direction than its perpendicular direction because the number of micromirrors whose angles of the reflected surfaces should be controlled is reduced.

For the above-noted exposing method, as shown in FIG. 5, pattern forming material 150 may be exposed on the entire surface by one scanning of scanner 162 in X direction; alternatively, as shown in FIGS. 6A and 6B, pattern forming material 150 may be exposed on the entire surface by repeated plural exposing such that pattern forming material 150 is scanned in X direction by scanner 162, then the scanner 162 is moved one step in Y direction, followed by scanning in X direction. In this example, scanner 162 is provided with eighteen exposing heads 166; each exposing head contains a laser source and the light modulating unit.

The exposure is performed on a partial region of the photosensitive layer, thereby the partial region is hardened, followed by unhardened regions other than the partial hardened region are removed in developing step as set forth later, thus a pattern is formed.

Next, the lens system 67 and the imaging optical system 51 will be explained below.

FIG. 11 is an exemplary cross sectional view that shows the construction of the exposing head shown in FIG. 10 in the sub-scanning direction along the optical axis.

As shown in FIG. 11, lens system 67 is provided with collective lens 71 that collects laser beam B for illumination from fiber array laser source 66, rod-like optical integrator 72 (hereinafter, referred to as "rod integrator") inserted on the optical path of the laser passed through collective lens 71, and image lens 74 disposed in front of rod integrator 72 or the side of mirror 69, as shown FIG. 11. Collective lens 71, rod integrator 72, and image lens 74 make the laser beam applied from fiber array laser source 66 enter into DMD 50 as a luminous flux of approximately parallel beam with uniform intensity in the cross section.

Laser beam B irradiated from lens system 67 is reflected by mirror 69, and is irradiated to DMD 50 through a total internal reflection prism 70. The total internal reflection prism 70 is not shown in FIG.10.

Imaging optical system 51 is disposed which images laser beam B reflected by DMD 50 onto pattern forming material 150. The imaging optical system 51 is equipped with the first imaging optical system of lens systems 52, 54, the second imaging optical system of lens systems 57, 58, and microlens array 55 and aperture array 59 interposed between these imaging systems as shown in FIG. 11.

Arranging two-dimensionally many microlenses 55a each corresponding to the respective imaging portions of DMD 50 forms microlens array 55. In this example, micromirrors of 1,024 rows × 256 lines among 1,024 rows × 768 lines of DMD 50 are driven, therefore, 1,024 rows × 256 lines of microlenses are disposed correspondingly. The pitch of disposed microlenses 55a is 41 μm in both of raw and line directions. Microlenses 55a have a focal length of 0.19 mm and a numerical aperture (NA) of 0.11 for example, and are formed of optical glass BK7. The shape of microlenses will be explained later. The beam diameter of laser beam B is 41 μm at the site of microlens 55a.

Aperture array 59 is formed of many apertures 59a each corresponding to the respective microlenses 55a of microlens array 55. The diameter of aperture 59a is 10 μm, for example.

The first imaging system forms the image of DMD 50 on microlens array 55 as a three times magnified image.

The second imaging system forms and projects the image through microlens array 55 on pattern forming material 150 as a 1.6 times magnified image.

Therefore, the image by DMD 50 is formed and projected on pattern forming material 150 as a 4.8 times magnified image.

Prism pair 73 is installed between the second imaging system and pattern forming material 150; through the operation to move up and down the prism pair 73 in FIG. 11, the image pint may be adjusted on the image forming material 150, pattern forming material 150 is fed to the direction of arrow F as sub-scanning.

Next, the microlens array, the aperture array, the imaging optical system and the like will be explained with reference to figures in the following.

FIG. 13A is an exemplary cross sectional view that shows a construction of another exposing head along the optical axis.

As shown in FIG. 13A, the exposing head is equipped with DMD 50, laser source 144 to irradiate laser beam onto DMD 50, lens systems or imaging optical systems 454 and 458 that magnify and image the laser beam reflected by DMD 50, microlens array 472 in which many microlenses 474 corresponding to the respective imaging portions of DMD 50 are arranged, aperture array 476 that aligns many apertures 478 corresponding to the respective microlenses of microlens array 472, and lens systems or imaging systems 480 and 482 that image laser beam through the apertures onto exposed surface 56.

FIG. 14 shows the flatness data as to the reflective surface of micromirrors 62 constituting the DMD 50.

In FIG. 14, contour lines express the respective same heights of the reflective surface; the pitch of the contour lines is 5 nm. In FIG. 14, X direction and Y direction are two diagonal directions of micromirror 62, and the micromirror 62 rotates around the rotation axis extending in Y direction. FIGS. 15A and 15B show the height displacements of micromirrors 62 along the X and Y directions respectively.

As shown in FIGS.14, 15A and 15B, there exist distortions on the reflective surface of micromirror 62, the distortions of one diagonal direction (Y direction) is larger than another diagonal direction (X direction) at the central region of the mirror in particular. Accordingly, a problem may arise in which the shape is distorted at the site that collects laser beam B by microlenses 55a of microlens array 55.

FIGS. 16A and 16B show the front shape and side shape of the entire microlens array 55 in detail. In FIGS. 16A and 16B, various parts of the microlens array are indicated as the unit of mm (millimeter). In the pattern forming process according to the present invention, micromirrors of 1,024 rows $\times$ 256 lines of DMD 50 are driven as explained above; microlens arrays 55 are correspondingly constructed as 1,024 arrays in length direction and 256 arrays in width direction. In FIG. 16A, the site of each microlens is expressed as "j" th line and "k" th row.

FIGS. 17A and 17B respectively show the front shape and side shape of one microlens 55a of microlens array 55. FIG. 17A also shows the contour lines of microlens 55a.

As shown in FIGS.17A and 17B, the end surface of each microlens 55a of irradiating side is of a non-spherical shape to compensate the distortion aberration of reflective surface of micromirrors 62.

Specifically, microlens 55a is a toric lens; the curvature radius of optical X direction Rx is - 0.125 mm, and the curvature radius of optical Y direction Ry is - 0.1 mm.

FIG. 18A is an exemplary view that schematically shows a laser collecting condition in a cross section of a microlens, and FIG. 18B is an exemplary view that schematically shows a laser collecting condition in another cross section of a microlens.

As shown in FIGS. 18A and 18B, since a toric lens of which the end surface at the light outputting side is formed in a non-spherical surface shape is used as microlens 55a constituting the microlens array,

As shown in FIGS. 18A and 18B, a toric lens whose end surface at the light irradiating side is formed in a non-spherical shape is used as microlens 55a constituting the microlens array, when comparing the laser beam B within the cross section parallel to the X direction and the laser beam B within the cross section parallel to the Y direction, the curvature radius of microlens 55a is shorter, and the focal length is also shorter in the Y direction.

In the pattern forming process according to the present invention, the microlenses 55a may be non-spherical shape of secondary or higher order such as fourth or sixth. The employment of higher order non-spherical surface may lead to higher accuracy of beam shape.

In the mode set forth above, the end surface of irradiating side of microlens 55a is non-spherical or toric; alternatively, substantially the same effect may be derived by constructing one of the end surface as a spherical surface and the other surface as a cylindrical surface and thus providing the microlens.

FIGS. 19A, 19B, 19C, and 19D show the simulations of beam diameter near the focal point of microlens 55a in the above noted shape by means of a computer.

For the reference, FIGS. 20A, 20B, 20C, and 20D show the similar simulations for microlens in a spherical shape of Rx = Ry = - 0.1 mm. The values of "z" in the figures are expressed as the evaluation sites in the focus direction of microlens 55a by the distance from the beam irradiating surface of microlens 55a.

The surface shape of microlens 55a in the simulation may be calculated by the following equation.

$$Z = \frac{C_x{}^2 X^2 + C_y{}^2 Y^2}{1 + SQRT\ (1 - C_x{}^2 X^2 - C_y{}^2 Y^2)}$$

In the above equation, Cx means the curvature (=1/Rx) in X direction, Cy means the curvature (=1/Ry) in Y direction, X means the distance from optical axis O in X direction, and Y means the distance from optical axis O in Y direction.

From the comparison of FIGS. 19A to 19D, and FIGS. 20A to 20D, it is apparent in the pattern forming process according to the present invention that the employment of the toric lens for the microlens 55a that has a shorter focal length in the cross section parallel to Y direction than the focal length in the cross section parallel to X direction may reduce the distortion of the beam shape near the collecting site. Accordingly, images can be exposed on pattern forming material 150 with more clearness and without distortion.

When the larger or smaller distortion at the central region appears at the central region of micromirror 62 inversely with those set forth above, the employment of microlenses having a shorter focal length in the cross section parallel to X direction than the focal length in the cross section parallel to Y direction may make possible to expose images on pattern forming material 150 with more clearness and without distortion or distortion.

The aperture array 59 disposed near the focal point of the microlens array 55 is arranged such that only light beams passes through the microlenses 55a corresponding to respective apertures 59a are incident into the respective apertures 59a. In other words, by setting the aperture array 59, it is possible to prevent light beams from adjacent microlenses 55a which are not corresponding to the respective apertures 59a from being incident into the respective apertures 59a and to enhance the extinction ratio.

Essentially, smaller diameter of apertures 59a may afford the effect to reduce the distortion of beam shape at the collecting site of microlens 55a. However, such a construction inevitably increases the optical quantity interrupted by the aperture array 59, resulting in lower efficiency of optical quantity. On the contrary, the non-spherical shape of microlenses 55a does not bring about the light interruption, thus the higher efficiency of optical quantity can be maintained.

In the embodiment described above, the microlens array 55 and the aperture array 59 are used to compensate aberration due to distortion at the irradiating surface of the micromirror 62 constituting DMD 50, however, in the pattern forming process of the present invention in which a spatial light modulator other than DMD is used, when distortion exists on surfaces of imaging portions in the spacial light modulator, it is also possible to apply the present invention and compensate the aberration due to distortion to thereby prevent occurrences of distortion in the beam shape.

As shown in FIG. 13A, the imaging optical system is equipped with lenses 480 and 482, and the light beam passed through the aperture array 59 is formed in an image on exposed surface 56.

As explained above, in the pattern forming apparatus, the laser beam reflected by DMD 50 is magnified into several times by magnifying lenses 454, 458, and is projected onto exposed surface 56, therefore, the entire image region is enlarged. When microlens array 472 and aperture array 476 are not disposed, one drawing size or spot size of each beam spot BS projected on exposed surface 56 is enlarged depending on the size of exposed area 468, thus MTF (modulation transfer function) property that is a measure of sharpness at exposing area 468 is decreased, as shown in FIG.13B.

On the other hand, when microlens array 472 and aperture array 476 are disposed, the laser beam reflected by DMD 50 is collected correspondingly with each imaging portion of DMD 50 by each microlens of microlens array 472. Thereby, the spot size of each beam spot BS may be reduced into the desired size, e.g.10 $\mu$m $\times$ 10 $\mu$m even when the exposing area is magnified, as shown in FIG. 13C, and the decrease of MFT property may be prevented and the exposure may be carried out with higher accuracy.

Inclination of exposing area 468 is caused by the DMD 50 that is disposed with inclination in order to eliminate the spaces between imaging portions.

Further, even when beam thickening exists due to aberration of microlenses, the beam shape may be arranged by the aperture array so as to form spots on exposed surface 56 with a constant size, and interference or cross talk between the adjacent imaging portions may be prevented by passing the beam through the aperture array provided correspondingly to each imaging portion.

In addition, employment of higher luminance laser source as laser source 144 may lead to prevention of partial entrance of luminous flux from adjacent imaging portions, since the angle of incident luminous flux that enters into each microlens of microlens array 472 from lens 458 is narrowed; namely, higher extinction ratio may be achieved.

FIGS. 22A and 22B respectively show the front shape and side shape of microlens 155a.

As shown in FIGS. 22A and 22B, with respect to another microlens array, each of these microlenses has a refractive index distribution to compensate the aberration due to distortion at the reflective surface of the micromirror 62.

As shown in the figures, the external shape of the other microlens 155a is parallel flat. The X and Y directions in the figures are the same as mentioned above.

FIGS. 23A and 23B schematically show the condition to collect laser beam B by microlens 155a in the cross section parallel with X and Y directions in FIGS. 22A and 22B. As shown in FIGS. 23A and 23B, the microlens 155a exhibits a refractive index distribution that the refractive index gradually increases from the optical axis O to outward direction; the broken lines in FIGS. 23A and 23B indicate the positions where the refractive index decreases a certain level from that of optical axis O. As shown in FIGS. 23A and 23B, comparing the cross section parallel to the X direction and the cross section parallel to the Y direction, the latter represents a rapid change in the refractive index distribution, and shorter focal length. Thus, the microlens array having such a refractive index distribution may provide the similar effect as the microlens array 55 set forth above.

In addition, the microlens having a non-spherical surface as shown in FIGS. 17A, 17B, 18A and 18B may be provided with such a refractive index distribution, and both of the surface shape and the refractive index distribution may compensate the aberration due to distortion of the reflective surface of micromirror 62.

In the pattern forming process according to the present invention, another optical system suitably selected from among conventional optical systems may be combined, for example, an optical system to compensate the optical quantity distribution may be employed additionally.

The optical system to compensate the optical quantity distribution alters the luminous flux width at each output site such that the ratio of the luminous flux width at the periphery region to the luminous flux width at the central region near the optical axis is higher in the output side than the input side, thus the optical quantity distribution at the exposed surface is compensated to be approximately constant when the parallel luminous flux from the light irradiation unit is irradiated to DMD. The optical system to compensate the optical quantity distribution will be explained with reference to figures in the following.

FIGS. 24A, 24B, and 24C are respectively a view explaining the concept of compensation by an optical system of optical quantity distribution compensation.

Initially, the optical system will be explained as for the case where the entire luminous flux widths H0 and H1 are the same between the input luminous flux and the output luminous flux, as shown in FIG. 24A. The portions denoted by reference numbers 51, 52 in FIG. 24A indicate imaginarily the input surface and output surface of the optical system to compensate the optical quantity distribution.

In the optical system to compensate the optical quantity distribution, it is assumed that the luminous flux width h0 of the luminous flux entered at central region near the optical axis Z1 and luminous flux width h1 of the luminous flux entered at peripheral region near are the same (h0 = h1). The optical system to compensate the optical quantity distribution affects the laser beam that has the same luminous fluxes h0, h1 at the input side, and acts to magnify the luminous flux width h0 for the input luminous flux at the central region, and acts to reduce the luminous flux width h1 for the input luminous flux at the periphery region conversely. Namely, the optical system affects the output luminous flux width h10 at the central region and the output luminous flux width h11 at the periphery region to turn into h11 < h10. In other words concerning the ratio of luminous flux width, (output luminous flux width at periphery region) / (output luminous flux width at central region) is smaller than the ratio of input, namely [h11/h10] is smaller than (h1/h0 = 1) or (h11/h10 < 1).

Owing to alternation of the luminous flux width, the luminous flux at the central region representing higher optical quantity may be supplied to the periphery region where the optical quantity is insufficient; thereby the optical quantity distribution is approximately uniformed at the exposed surface without decreasing the utilization efficiency. The level for uniformity is controlled such that the nonuniformity of optical quantity is 30 % or less in the effective region for example, preferably is 20 % or less.

When the luminous flux width is entirely altered for the input side and the output side, the operation and effect due to the optical system to compensate the optical quantity distribution are similar to those shown in FIGS. 24B, and 24C.

FIG. 24B shows the case that the entire optical flux bundle H0 is reduced and outputted as optical flux bundle H2 (H0 > H2). In such a case, the optical system to compensate the optical quantity distribution also tends to process the laser beam, in which luminous flux width h0 is the same as h1 at input side, into that the luminous flux width h10 at the central region is larger than that of the periphery region and the luminous flux width h11 is smaller than that of the central region in the output side. Considering the reduction ratio of the luminous flux, the optical system affects to decrease the reduction ratio of input luminous flux at the central region compared to the peripheral region, and affects to increase the reduction ratio of input luminous flux at the peripheral region compared to the central region. In the case, (output luminous flux width at periphery region) / (output luminous flux width at central region) is also smaller than the ratio of input, namely [H11/H10] is smaller than (h1/h0 =1) or (h11/h10 < 1).

FIG. 24C explains the case where the entire luminous flux width H0 at input side is magnified and output into width H3 (H0 < H3). In such a case, the optical system to compensate the optical quantity distribution also tends to process the laser beam, in which luminous flux width h0 is the same as h1 at input side, into that the luminous flux width h10 at the central region is larger than that of the periphery region and the luminous flux width h11 is smaller than that of the central region in the output side. Considering the magnification ratio of the luminous flux, the optical system acts

to increase the magnification ratio of input luminous flux at the central region compared to the peripheral region, and acts to decrease the magnification ratio of input luminous flux at the peripheral region compared to that at the central region. In the case, (output luminous flux width at periphery region) / (output luminous flux width at central region) is also smaller than the ratio of input, namely [H11/H10] is smaller than (h1/h0 = 1) or (h11/h10 < 1).

As such, the optical system to compensate the optical quantity distribution alters the luminous flux width at each output site, and lowers the ratio (output luminous flux width at periphery region) / (output luminous flux width at central region) at output side compared to the input side; therefore, the laser beam having the same luminous flux turns into the laser beam at output side that the luminous flux width at central region is larger than that at the peripheral region and the luminous flux at the peripheral region is smaller than that at the central region. Owing to such effect, the luminous flux at the central region may be supplied to the periphery region, thereby the optical quantity distribution is approximately uniformed at the luminous flux cross section without decreasing the utilization efficiency of the entire optical system.

Next, specific lens data of a pair of combined lenses to be utilized for the optical system to compensate the optical quantity distribution will be exemplarily set forth. In this discussion, the lens data will be explained in the case that the optical quantity distribution shows Gaussian distribution at the cross section of the output luminous flux, such as the case that the laser source is a laser array as set forth above. In a case that one semiconductor laser is connected to an input end of single mode optical fiber, the optical quantity distribution of output luminous flux from the optical fiber shows Gaussian distribution. The pattern forming process according to the present invention may be applied, in addition, to such a case that the optical quantity near the central region is significantly larger than the optical quantity at the peripheral region as in the case where the core diameter of multimode optical fiber is reduced and constructed similarly to a single mode optical fiber, for example.

The essential data for the lens are summarized in Table 1 below.

Table 1

| Basic Lens Data | | | |
|---|---|---|---|
| S i (surface No.) | r i (curvature radius) | d i (surface distance) | N i (refractive index) |
| 0 1 | non-spherical | 5. 000 | 1.52811 |
| 0 2 | ∞ | 50.000 | |
| 0 3 | ∞ | 7.000 | 1. 52811 |
| 0 4 | non-spherical | | |

As demonstrated in Table 1, a pair of combined lenses is constructed from two non-spherical lenses of rotational symmetry. The surfaces of the lenses are defined that the surface of input side of the first lens disposed at the light input side is the first surface; the opposite surface at light output side is the second surface; the surface of input side of the second lens disposed at the light input side is the third surface; and the opposite surface at light output side is the fourth surface. The first and the fourth surfaces are non-spherical.

In Table 1, 'Si (surface No.)' indicates "i" th surface (i =1 to 4), 'ri (curvature radius)' indicates the curvature radius of the "i" th surface, di (surface distance) means the surface distance between "i" th surface and "i+1" surface. The unit of di (surface distance) is millimeter (mm). Ni (refractive index) means the refractive index of the optical element containing "i" th surface for the light of wavelength 405 nm.

In Table 2 below, the non-spherical data of the first and the fourth surface is summarized.

Table 2

| non-spherical data | | |
|---|---|---|
| | first surface | fourth surface |
| C | $-1.4098 \times 10^{-2}$ | $-9.8506 \times 10^{-3}$ |
| K | $-4.2192$ | $-3.6253 \times 10$ |
| a3 | $-1.0027 \times 10^{-4}$ | $-8.9980 \times 10^{-5}$ |
| a4 | $3.0591 \times 10^{-5}$ | $2.3060 \times 10^{-5}$ |
| a5 | $-4.5115 \times 10^{-7}$ | $-2.2860 \times 10^{-6}$ |
| a6 | $-8.2819 \times 10^{-9}$ | $8.7661 \times 10^{-8}$ |
| a7 | $4.1020 \times 10^{-12}$ | $4.4028 \times 10^{-10}$ |
| a8 | $1.2231 \times 10^{-13}$ | $1.3624 \times 10^{-12}$ |
| a9 | $5.3753 \times 10^{-16}$ | $3.3965 \times 10^{-15}$ |

(continued)

| non-spherical data | | |
|---|---|---|
| | first surface | fourth surface |
| a10 | $1.6315 \times 10^{-18}$ | $7.4823 \times 10^{-18}$ |

The non-spherical data set forth above may be expressed by means of the coefficients of the following equation (A) that represent the non-spherical shape.

$$Z = \frac{C \cdot \rho^2}{1 + \sqrt{1 - K \cdot (C \cdot \rho)^2}} + \sum_{i=3}^{10} ai \cdot \rho^i \quad \cdots\cdots \quad (A)$$

In the above formula (A), the coefficients are defined as follows:

Z: length of perpendicular that extends from a point on non-spherical surface at height p from optical axis (mm) to tangent plane at vertex of non-spherical surface or plane vertical to optical axis;
p: distance from optical axis (mm);
K: coefficient for circular conic;
C: paraxial curvature (1/r, r: radius of paraxial curvature);
ai: "i" st non-spherical coefficient (i = 3 to 10).

For example, "1.0E-02" means "1.0 X $10^{-2}$".
FIG. 26 shows the optical quantity distribution of illumination light obtained by a pair of combined lenses shown in Table 1 and Table 2. The abscissa axis represents the distance from the optical axis, the ordinate axis represents the proportion of optical quantity (%). FIG. 25 shows the optical quantity distribution (Gaussian distribution) of illumination light without the compensation.
As is apparent from FIGS. 25 and 26, the compensation by means of the optical system to compensate the optical quantity distribution brings about an approximately uniform optical quantity distribution significantly exceeding the optical quantity distribution obtained without the compensation, thus uniform exposing may be achieved by means of uniform laser beam without decreasing the optical utilization efficiency.
Next, fiber array light source 66 as a light irradiation unit will be explained below.
FIG. 27A (A) is an exemplary perspective view that shows a constitution of a fiber array laser source.
FIG. 27A (B) is a partially enlarged view of FIG. 27A (A). FIG. 27A (C) is an exemplary plan view that shows an arrangement of emitting sites of laser output. FIG. 27A (D) is an exemplary plan view that shows another arrangement of laser emitting sites. FIG. 27B is an exemplary front view that shows an arrangement of laser emitting sites in the laser emitting part in a fiber array laser source.
Fiber array laser source 66 is equipped with plural (e.g. fourteen) laser modules 64 as shown in FIG. 27A. One end of each multimode optical fiber 30 is connected to each laser module 64. The other end of each multimode optical fiber 30 is connected to optical fiber 31 of which the core diameter is the same as that of multimode optical fiber 30 and of which the clad diameter is smaller than that of multimode optical fiber 30. As shown in FIG. 27B specifically, the ends of multimode optical fibers 31 at the opposite end of multimode optical fiber 30 are aligned as seven ends along the main scanning direction perpendicular to the sub-scanning direction, and the seven ends are aligned as two rows, thereby laser output portion 68 is constructed.
The laser output portion 68, formed of the ends of multimode optical fibers 31, is fixed by being interposed between two flat support plates 65 as shown in FIG. 27B. Preferably, a transparent protective plate such as a glass plate is disposed on the output end surface of multimode optical fibers 31 in order to protect the output end surface. The output end surface of multimode optical fibers 31 tends to bear dust and to degrade due to its higher optical density; the protective plate set forth above may prevent the dust deposition on the end surface and may retard the degradation.
In this example, in order to align optical fibers 31 having a lower clad diameter into an array without a space, multimode optical fiber 30 is stacked between two multimode optical fibers 30 that contact at the larger clad diameter, and the output end of optical fiber 31 connected to the stacked multimode optical fiber 30 is interposed between two output ends of optical fibers 31 connected to two multimode optical fibers 30 that contact at the larger clad diameter.
Such optical fibers may be produced by connecting concentrically optical fibers 31 having a length of 1 cm to

30 cm and a smaller clad diameter to the tip portions of laser beam output side of multimode optical fiber 30 having a larger clad diameter, for example, as shown in FIG. 28. Two optical fibers are connected such that the input end surface of optical fiber 31 is fused to the output end surface of multimode optical fiber 30 so as to coincide the center axes of the two optical fibers. The diameter of core 31a of optical fiber 31 is the same as the diameter of core 30a of multimode optical fiber 30 as set forth above.

Further, a shorter optical fiber produced by fusing an optical fiber having a smaller clad diameter to an optical fiber having a shorter length and a larger clad diameter may be connected to the output end of multimode optical fiber through a ferrule, optical connector or the like. The connection through a connector and the like in an attachable and detachable manner may bring about easy exchange of the output end portion when the optical fibers having a smaller clad diameter are partially damaged for example, resulting advantageously in lower maintenance cost for the exposing head. Optical fiber 31 is sometimes referred to as "output end portion" of multimode optical fiber 30.

Multimode optical fiber 30 and optical fiber 31 may be any one of step index type optical fibers, grated index type optical fibers, and combined type optical fibers. For example, step index type optical fibers produced by Mitsubishi Cable Industries, Ltd. are available. In one of the best mode according to the present invention, multimode optical fiber 30 and optical fiber 31 are step index type optical fibers; in the multimode optical fiber 30, clad diameter = 125 μm, core diameter = 50 μm, NA = 0.2, transmittance = 99.5 % or more (at coating on input end surface); and in the optical fiber 31, clad diameter = 60 μm, core diameter = 50 μm, NA = 0.2.

Laser beams at infrared region typically increase the propagation loss while the clad diameter of optical fibers decreases. Accordingly, a proper clad diameter is defined usually depending on the wavelength region of the laser beam. However, the shorter is the wavelength, the less is the propagation loss; for example, in the laser beam of wavelength 405 nm applied from GaN semiconductor laser, even when the clad thickness (clad diameter - core diameter)/2 is made into about 1/2 of the clad thickness at which infrared beam of wavelength 800 nm is typically propagated, or made into about 1/4 of the clad thickness at which infrared beam of wavelength 1.5 μm for communication is typically propagated, the propagation loss does not increase significantly. Therefore, the clad diameter is possible to be as small as 60 μm.

Needless to say, the clad diameter of optical fiber 31 should not be limited to 60 μm. The clad diameter of optical fiber utilized for conventional fiber array laser sources is 125 μm; the smaller is the clad diameter, the deeper is the focal depth; therefore, the clad diameter of the multimode optical fiber is preferably 80 μm or less, more preferably 60 μm or less, still more preferably 40 μm or less. In the meanwhile, since the core diameter is appropriately at least 3 to 4 μm, the clad diameter of optical fiber 31 is preferably 10 um or more.

Laser module 64 is constructed from the combined laser source or the fiber array laser source as shown in FIG. 29. The combined laser source is constructed from plural (e.g. seven) multimode or single mode GaN semiconductor lasers LD1, LD2, LD3, LD4, LD5, LD6 and LD7 disposed and fixed on heat block 10, collimator lenses 11, 12, 13, 14, 15, 16, and 17, one collecting lens 20, and one multimode optical fiber 30. Needless to say, the number of semiconductor lasers is not limited to seven. For example, with respect to the multimode optical fiber having clad diameter = 60 μm, core diameter = 50 μm, NA = 0.2, as much as twenty semiconductor lasers may be input, thus the number of optical fibers may be reduced while attaining the necessary optical quantity of the exposing head.

GaN semiconductor lasers LD1 to LD7 have a common oscillating wavelength e.g. 405 nm, and a common maximum output e.g. 100 mW as for multimode lasers and 30 mW as for single mode lasers. The GaN semiconductor lasers LD1 to LD7 may be those having an oscillating wavelength of other than 405 nm as long as within the wavelength of 350 to 450 nm.

The combined laser source is housed into a box package 40 having an upper opening with other optical elements as shown in FIGS. 30 and 31. The package 40 is equipped with package lid 41 for shutting the opening. Introduction of sealing gas after evacuating procedure and shutting the opening of package 40 by means of package lid 41 presents a closed space or sealed volume constructed by package 40 and package lid 41, and the combined laser source is disposed in a sealed condition.

Base plate 42 is fixed on the bottom of package 40; the heat block 10, collective lens holder 45 to support collective lens 20, and fiber holder 46 to support the input end of multimode optical fiber 30 are mounted to the upper surface of the base plate 42. The output end of multimode optical fiber 30 is drawn out of the package from the aperture provided at the wall of package 40.

Collimator lens holder 44 is attached to the side wall of heat block 10, and collimator lenses 11 to 17 are supported thereby. An aperture is provided at the side wall of package 40, and interconnection 47 that supplies driving power to GaN semiconductor lasers LD1 to LD7 is directed through the aperture out of the package.

In FIG. 31, only the GaN semiconductor laser LD7 is indicated with a reference mark among plural GaN semiconductor laser, and only the collimator lens 17 is indicated with a reference number among plural collimators, in order not to make the figure excessively complicated.

FIG. 32 shows a front shape of attaching part for collimator lenses 11 to 17. Each of collimator lenses 11 to 17 is formed into a shape that a circle lens containing a non-spherical surface is cut into an elongated piece with parallel planes at the region containing the optical axis. The collimator lens with the elongated shape may be produced by a

molding process. The collimator lenses 11 to 17 are closely disposed in the aligning direction of emitting points such that the elongated direction is perpendicular to the alignment of the emitting points of GaN semiconductor lasers LD1 to LD7.

In the meanwhile, as for GaN semiconductor lasers LD1 to LD7, the following laser may be employed which contains an active layer having an emitting width of 2 μm and emits the respective laser beams B1 to B7 under the condition that the divergence angle is 10 degrees and 30 degrees for the parallel and perpendicular directions against the active layer. The GaN semiconductor lasers LD1 to LD7 are disposed such that the emitting sites align as one line in parallel to the active layer.

Accordingly, laser beams B1 to B7 emitted from the respective emitting sites enter into the elongated collimator lenses 11 to 17 in a condition that the direction having a larger divergence angle coincides with the length direction of each collimator lens and the direction having a less divergence angle coincides with the width direction of each collimator lens. Namely, the width is 1.1 mm and the length is 4.6 mm with respect to respective collimator lenses 11 to 17, and the beam diameter is 0.9 mm in the horizontal direction and is 2.6 mm in the vertical direction with respect to laser beams B1 to B7 that enter into the collimator lenses. As for the respective collimator lenses 11 to 17, focal length f1 = 3 mm, NA = 0.6, pitch of disposed lenses = 1.25 mm.

Collective lens 20 formed into a shape that a part of circle lens containing the optical axis and non-spherical surface is cut into an elongated piece with parallel planes and is arranged such that the elongated piece is longer in the direction of disposing collimator lens 11 to 17 i.e. horizontal direction, and is shorter in the perpendicular direction. As for the collective lens, focal length f2 = 23 mm, NA = 0.2. The collective lens 20 may be produced by molding a resin or optical glass, for example.

Further, since a high luminous fiber array laser source is employed that is arrayed at the output ends of optical fibers in the combined laser source for the illumination unit to illuminate the DMD, a pattern forming apparatus that exhibits a higher output and a deeper focal depth may be attained. In addition, the higher output of the respective fiber array laser sources may lead to less number of fiber array laser sources required to take a necessary output as well as a lower cost of the pattern forming apparatus.

In addition, the clad diameter at the output ends of the optical fibers is smaller than the clad diameter at the input ends, therefore, the diameter at emitting sites is reduced still, resulting in higher luminance of the fiber array laser source. Consequently, pattern forming apparatuses provided with a deeper focal depth may be achieved. For example, a sufficient focal depth may be obtained even for the extremely high resolution exposure such that the beam diameter is 1 μm or less and the resolution is 0.1 μm or less, thereby enabling rapid and precise exposure. Accordingly, the pattern forming apparatus is appropriate for the exposure of thin film transistor (TFT) that requires high resolution.

The illumination unit is not limited to the fiber array laser source that is equipped with plural combined laser sources; for example, such a fiber array laser source may be employed that is equipped with one fiber laser source, and the fiber laser source is constructed by one arrayed optical fiber that outputs a laser beam from one semiconductor laser having an emitting site.

Further, as for the illumination unit having plural emitting sites, such a laser array may be employed that contains plural (e.g. seven) tip-like semiconductor lasers LD1 to LD7 disposed on heat block 100 as shown in FIG. 33. In addition, multi cavity laser 110 is known which contains plural (e.g. five) emitting sites 110a disposed in a certain direction as shown in FIG. 34A. In the multi cavity laser 110, the emitting sites can be arrayed with higher dimensional accuracy as compared to arraying tip-like semiconductor lasers, thus laser beams emitted from the respective emitting sites can be easily combined. Preferably, the number of emitting sites 110a is five or less because deflection tends to arise on multi cavity laser 110 at the laser production process when the number increases.

Concerning the illumination unit, the multi cavity laser 110 set forth above, or the multi cavity array disposed such that plural multi cavity lasers 110 are arrayed in the same direction as emitting sites 110a of each tip as shown in FIG. 34B may be employed for the laser source.

The combined laser source is not limited to the types that combine plural laser beams emitted from plural tip-like semiconductor lasers. For example, such a combined laser source is available that contains tip-like multi cavity laser 110 having plural (e.g. three) emitting sites 110a as shown in FIG. 21. The combined laser source is equipped with multi cavity laser 110, one multimode optical fiber 130, and collecting lens 120. The multi cavity laser 110 may be constructed from GaN laser diodes having an oscillating wavelength of 405 nm, for example.

In the above noted construction, each laser beam B emitted from each of plural emitting sites 110a of multi cavity laser 110 is collected by collective lens 120 and enters into core 130a of multimode optical fiber 130. The laser beams entered into core 130a propagate inside the optical fiber and combine as one laser beam then output from the optical fiber.

The connection efficiency of laser beam B to multimode optical fiber 130 may be enhanced by way of arraying plural emitting sites 110a of multi cavity laser 110 into a width that is approximately the same as the core diameter of multimode optical fiber 130, and employing a convex lens having a focal length of approximately the same as the core diameter of multimode optical fiber 130, and also employing a rod lens that collimates the output beam from multi cavity

laser 110 at only within the surface perpendicular to the active layer.

In addition, as shown in FIG. 35, a combined laser source may be employed which is equipped with laser array 140 formed by arraying on heat block 111 plural (e.g. nine) multi cavity lasers 110 with an identical space between them by employing multi cavity lasers 110 equipped with plural (e.g. three) emitting sites. The plural multi cavity lasers 110 are arrayed and fixed in the same direction as emitting sites 110a of the respective tips.

The combined laser source is equipped with laser array 140, plural lens arrays 114 that are disposed correspondingly to the respective multi cavity lasers 110, one rod lens 113 that is disposed between laser array 140 and plural lens arrays 114, one multimode optical fiber 130, and collective lens 120. Lens arrays 114 are equipped with plural microlenses each corresponding to emitting sites of multi cavity lasers 110.

In the above noted construction, laser beams B that are emitted from plural emitting sites 110a of plural multi cavity lasers 110 are collected in a certain direction by rod lens 113, then are paralleled by the respective microlenses of microlens arrays 114. The paralleled laser beams L are collected by collective lens 120 and are input into core 130a of multimode optical fiber 130. The laser beams entered into core 130a propagate inside the optical fiber and combine as one beam then output from the optical fiber.

Another combined laser source will be exemplified in the following. In the combined laser source, heat block 182 having a cross section of L-shape in the optical axis direction is installed on rectangular heat block 180 as shown in FIGS. 36A and 36B, and a housing space is formed between the two heat blocks. On the upper surface of L-shape heat block 182, plural (e.g. two) multi cavity lasers 110, in which plural (e.g. five) emitting sites are arrayed, are disposed and fixed with an identical space between them in the same direction as the aligning direction of respective tip-like emitting sites.

A concave portion is provided on the substantially rectangular heat block 180; plural (e.g. two) multi cavity lasers 110 are disposed on the upper surface of heat block 180, plural emitting sites (e.g. five) are arrayed in each multi cavity laser 110, and the emitting sites are situated at the same vertical surface as the surface where the emitting sites of the laser tip disposed on the heat block 182 are situated.

At the laser beam output side of multi cavity laser 110, collimate lens arrays 184 are disposed such that collimate lenses are arrayed correspondingly with the emitting sites 110a of the respective tips. In the collimate lens arrays 184, the length direction of each collimate lens coincides with the direction at which the laser beam represents wider divergence angle or the fast axis direction, and the width direction of each collimate lens coincides with the direction at which the laser beam represents less divergence angle or the slow axis direction. The integration by arraying the collimate lenses may increase the space efficiency of laser beam, thus the output power of the combined laser source may be enhanced, and also the number of parts may be reduced, resulting advantageously in lower production cost.

At the laser beam output side of collimate lens arrays 184, disposed are one multimode optical fiber 130 and collective lens 120 that collects laser beams at the input end of multimode optical fiber 130 and combines them.

In the above noted construction, the respective laser beams B emitted from the respective emitting sites 110a of plural multi cavity lasers 110 disposed on laser blocks 180, 182 are paralleled by collimate lens array, are collected by collective lens 120, then entered into core 130a of multimode optical fiber 130. The laser beams entered into core 130a propagate inside the optical fiber and combine as one beam then output from the optical fiber.

The combined laser source may be made into a higher output power source by multiple arrangement of the multi cavity lasers and the array of collimate lenses in particular. The combined laser source allows to construct a fiber array laser source and a bundle fiber laser source, thus is appropriate for the fiber laser source to construct the laser source of the pattern forming apparatus in the present invention.

A laser module may be constructed by housing the respective combined laser sources into a casing, and drawing out the output end of multimode optical fiber 130.

In the explanations set forth above, the higher luminance of fiber array laser source is exemplified which the output end of the multimode optical fiber of the combined laser source is connected to another optical fiber that has the same core diameter as that of the multimode optical fiber and a clad diameter smaller than that of the multimode optical fiber; alternatively a multimode optical fiber having a clad diameter of 125 μm, 80 μm, 60 μm or the like may be utilized without connecting another optical fiber at the output end, for example.

In each exposing head 166 of scanner 162, the respective laser beams B1, B2, B3, B4, B5, B6, and B7, emitted from GaN semiconductor lasers LD1 to LD 7 that constitute the combined laser source of fiber array laser source 66, are paralleled by the corresponding collimator lenses 11 to 17. The paralleled laser beams B1 to B7 are collected by collective lens 20 and converge at the input end surface of core 30a of multimode optical fiber 30.

In this example, the collective optical system is constructed from collimator lenses 11 to 17 and collective lens 20, and the combined optical system is constructed from the collective optical system and multimode optical fiber 30. Namely, laser beams B1 to B7 that are collected by collective lens 20 enter into core 30a of multimode optical fiber 30 and propagate inside the optical fiber, combine into one laser beam B, then output from optical fiber 31 that is connected at the output end of multimode optical fiber 30.

In each laser module, when the coupling efficiency of laser beams B1 to B7 with multimode optical fiber 30 is

0.85 and each output of GaN semiconductor lasers LD1 to LD7 is 30 mW, each optical fiber disposed in an array can take combined laser beam B of output 180 mW (= 30 mW $\times$ 0.85 $\times$7). Accordingly, the output is about 1 W (= 180 mW $\times$ 6) at laser emitting portion 68 of the array of six optical fibers 31.

Laser emitting portions 68 of fiber array source 66 are arrayed such that the higher luminous emitting sites are aligned along the main scanning direction. The conventional fiber laser source that connects laser beam from one semiconductor laser to one optical fiber is of lower output, therefore, a desirable output cannot be attained unless many lasers are arrayed: whereas the combined laser source of lower number (e.g. one) array can produce the desirable output because the combined laser source may generate a higher output.

For example, in the conventional fiber where one semiconductor laser and one optical fiber are connected, a semiconductor laser of about 30 mW output is usually employed, and a multimode optical fiber that has a core diameter of 50 $\mu$m, a clad diameter of 125 $\mu$m, and a numerical aperture of 0.2 is employed as the optical fiber. Therefore, in order to take an output of about 1 W (Watt), 48 (8 $\times$ 6) multimode optical fibers are necessary; since the area of emitting region is 0.62 $mm^2$ (0.675 mm $\times$ 0.925 mm), the luminance at laser emitting portion 68 is 1.6 $\times$ $10^6$ ($W/m^2$), and the luminance per one optical fiber is 3.2 $\times$ $10^6$ ($W/m^2$).

In contrast, when the laser emitting unit is one capable of emitting the combined laser, six multimode optical fibers can produce the output of about 1 W. Since the area of the emitting region in laser emitting portion 68 is 0.0081 $mm^2$ (0.325 mm $\times$ 0.025 mm), the luminance at laser emitting portion 68 is 123 $\times$ $10^6$ ($W/m^2$), which corresponds to about 80 times the luminance of conventional units. The luminance per one optical fiber is 90 $\times$ $10^6$ ($W/m^2$), which corresponds to about 28 times the luminance of conventional unit.

The difference of focal depth between the conventional exposing head and the exposing head in the present invention will be explained with reference to FIGS. 37A and 37B. For example, the diameter of exposing head is 0.675 mm in the sub-scanning direction of the emitting region of the bundle-like fiber laser source, and the diameter of exposing head is 0.025 mm in the sub-scanning direction of the emitting region of the fiber array laser source. As shown in FIG. 37A, in the conventional exposing head, the emitting region of illuminating unit or bundle-like fiber laser source 1 is larger, therefore, the angle of laser bundle that enters into DMD3 is larger, resulting in larger angle of laser bundle that enters into scanning surface 5. Therefore, the beam diameter tends to increase in the collecting direction, resulting in a deviation in focus direction.

In the meanwhile, as shown in FIG. 37B, the exposing head of the pattern forming apparatus in the present invention has a smaller diameter of the emitting region of fiber array laser source 66 in the sub-scanning direction, therefore, the angle of laser bundle that enters into DMD50 through lens system 67 is smaller, resulting in lower angle of laser bundle that enters into scanning surface 56, i.e. larger focal depth. In this example, the diameter of the emitting region is about 30 times the diameter of prior art in the sub-scanning direction, thus the focal depth approximately corresponding to the limited diffraction may be obtained, which is appropriate for the exposing at extremely small spots. The effect on the focal depth is more significant as the optical quantity required at the exposing head comes to larger. In this example, the size of one imaging portion projected on the exposing surface is 10 $\mu$m $\times$ 10 $\mu$m. The DMD is a spatial light modulator of reflected type; in FIGS. 37A and 37B, it is shown as developed views to explain the optical relation.

Next, the pattern forming process of the present invention using the pattern forming apparatus will be described below.

The pattern information corresponding to the exposing pattern is input into a controller (not shown) connected to DMD50, and is memorized once to a flame memory within the controller. The pattern information is the data that expresses the concentration of each imaging portion that constitutes the pixels by means of binary i.e. presence or absence of the dot recording.

Next, stage 152 that absorbs pattern forming material 150 on the surface is conveyed from upstream to downstream of gate 160 along guide 158 at a constant velocity by a driving device (not shown). When the tip of pattern forming material 150 is detected by detecting sensor 164 installed at gate 160 while stage 152 passes under gate 160, the pattern information memorized at the flame memory is read plural lines by plural lines sequentially, and controlling signals are generated for each exposing head 166 based on the pattern information read by the data processing portion. Then, each micromirror of DMD50 is subjected to on-off control for each exposing head 166 based on the generated controlling signals.

When a laser beam is applied from fiber array laser source 66 onto DMD50, the laser beam reflected by the micromirror of DMD50 at on-condition is imaged on exposed surface 56 of pattern forming material 150 by means of lens systems 54, 58. As such, the laser beams emitted from fiber array laser source 66 are -subjected to on-off control for each imaging portion, and pattern forming material 150 is exposed by imaging portions or exposing area 168 of which the number is approximately the same as that of imaging portions employed in DMD50. Further, through moving the pattern forming material 150 at a constant velocity along with stage 152, pattern forming material 150 is subjected to sub-scanning in the direction opposite to the stage moving direction by means of scanner 162, and band-like exposed region 170 is formed for each exposing head 166.

Examples of the developing step include a step in which unhardened regions of the photosensitive layer which

has been exposed in the exposure step are removed to thereby develop the photosensitive layer.

The method of removing unhardened regions is not particularly limited and may be suitably selected in accordance with the intended use, and examples thereof include a method of removing unhardened regions using a developer.

The developer is not particularly limited and may be suitably selected in accordance with the intended use; examples of the developers include alkaline aqueous solutions, aqueous developing liquids, and organic solvents; among these, weak alkali aqueous solutions are preferable. The basic components of the weak alkali aqueous solutions are exemplified by lithium hydroxide, sodium hydroxide, potassium hydroxide, lithium carbonate, sodium carbonate, potassium carbonate, lithium hydrogencarbonate, sodium hydrogencarbonate, potassium hydrogencarbonate, sodium phosphate, potassium phosphate, sodium pyrophosphate, potassium pyrophosphate, and borax.

The weak alkali aqueous solution preferably exhibits a pH of about 8 to 12, more preferably about 9 to 11. Examples of such a solution are aqueous solutions of sodium carbonate and potassium carbonate at a concentration of 0.1% by mass to 5 % by mass. The temperature of the developer may be properly selected depending on the developing ability of the developer; for example, the temperature of the developer is about 25 °C to 40 °C.

The developer may be combined with surfactants, defoamers; organic bases such as ethylene diamine, ethanol amine, tetramethylene ammonium hydroxide, diethylene triamine, triethylene pentamine, morpholine, and triethanol amine; organic solvents to promote developing such as alcohols, ketones, esters, ethers, amides, and lactones. The developer set forth above may be an aqueous developer selected from aqueous solutions, aqueous alkali solutions, combined solutions of aqueous solutions and organic solvents, or an organic developer.

[Other Steps]

The other steps are not particularly limited and may be suitably selected from among the steps in known pattern forming steps, and examples thereof include curing treatment, etching, and plating. Each of these steps may be used alone or may be combined with two or more.

- Hardening Treatment -

When the pattern forming process of the present invention is a process of forming a pattern of a protective film, interlayer insulation film, and the like, the pattern forming process is preferably provided with a curing treatment to harden the photosensitive layer after the developing step.

The curing treatment is not particularly limited and may be suitably selected in accordance with the intended use, and preferred examples thereof include entire surface exposing treatment, and entire surface heating treatment.

For the entire surface exposing treatment, a method is exemplified in which after the developing step, the entire surface of the laminate with the pattern formed thereon is exposed. By exposing the entire surface of the laminate, hardening of resins in the photosensitive composition forming the photosensitive layer is accelerated, and the surface of the pattern can be hardened.

The apparatus used for exposing the entire surface is not particularly limited and may be suitably selected in accordance with the intended use, however, a UV-ray exposer such as ultrahigh pressure mercury lamp is preferably exemplified.

For the method of performing the entire surface heating treatment, a method is exemplified in which after the developing step, the entire surface of the laminate with the pattern formed thereon is heated. By heating the entire surface of the laminate, the film strength of the pattern surface can be increased.

The heating temperature in the entire surface heating treatment is preferable 120°C to 250°C and more preferably 120°C to 200°C. When the heating temperature is less than 120°C, the film strength of the pattern surface may not be increased. When the heating temperature is more than 50°C, resins in the photosensitive composition may be decomposed, and the film may be weak and brittle.

The heating time of the entire surface heating treatment is preferably 10 minutes to 120 minutes, and more preferably 15 minutes to 60 minutes.

The apparatus used for performing the entire surface heating is not particularly limited and may be suitably selected in accordance with the intended use, and examples thereof include dry ovens, hot plates, and IR heaters.

- Etching Step -

The etching may be carried out by a method selected properly from conventional etching methods.

The etching liquid used in the etching method is not particularly limited and may be suitably selected in accordance with the intended use; when the metal layer set forth above is formed of copper, exemplified are cupric chloride solution, ferric chloride solution, alkali etching solution, and hydrogen peroxide solution for the etching liquid; among these, ferric chloride solution is preferred in light of the etching factor.

The etching treatment and the removal of the pattern forming material may form a permanent pattern on the substrate.
The permanent pattern is not particularly limited and may be suitably selected in accordance with the intended use; for example, the pattern is of interconnection.

- Plating Step -

The plating step may be performed by a method selected from conventional plating treatment methods.
Examples of the plating treatment include copper plating such as copper sulfate plating and copper pyrophosphate plating; solder plating such as high flow solder plating; nickel plating such as watt bath (nickel sulfate-nickel chloride) plating and nickel sulfamate plating; and gold plating such as hard gold plating and soft gold plating.
A pattern can be formed on the substrate surface by performing a plating treatment in the plating step, followed by removing the pattern forming material and optional etching treatment on unnecessary portions.

- Method of forming a protective film and an interlayer insulation film -

When the pattern forming process of the present invention is a process of forming any one of a protective film and an interlayer insulation film using a so-called solder resist, a permanent pattern can be formed on a printed wiring board according to the pattern forming process of the present invention, and the printed wiring board surface can be further soldered as follows.
Namely, a hardened layer which is of the permanent pattern is formed in the developing step, and a metal layer is exposed on the surface of the printed wiring board. Sites of the exposed metal layer formed on the printed wiring board surface are plated with gold, and then the printed wiring board surface is soldered. Then, a semiconductor, components and the like are mounted on the soldered sites of the metal layer. The permanent pattern made of the hardened layer exerts functions as a protective layer or an insulation layer (interlayer insulation layer) to thereby prevent external impacts and conduction between adjacent electrodes.
In the pattern forming process of the present invention, when the permanent pattern formed by the permanent pattern forming process is the protective film or the interlayer insulation film, the interconnection can be prevented from external impacts and bending; particularly when the interconnection pattern is the interlayer insulation layer, it is useful, for example, in highly closely mounting a semiconductor and components on a multilayered interconnection substrate, a build-up interconnection substrate, or the like.

- Method of Forming Printed Interconnection Pattern -

When the pattern forming process of the present invention is a process of forming a printed interconnection pattern, the pattern forming process can be widely used in forming various patterns because a pattern can be formed with high speed. The pattern forming process can be preferably applied to the production of printed wiring boards, particularly preferably in the production of printed wiring boards having through holes or via holes.
In process for producing printed wiring boards having through holes and/or via holes according to the pattern forming process of the present invention, a pattern may be formed by (1) laminating the pattern forming material on a substrate of a printed wiring board having holes such that the photosensitive layer faces the substrate thereby to form a laminate, (2) irradiating a light onto the regions for forming interconnection patterns and holes from the opposite side of the substrate of the laminate thereby to harden the photosensitive layer, (3) removing the support of the pattern forming material from the laminate, and (4) developing the photosensitive layer of the laminate to remove unhardened regions in the laminate.
Thereafter, to yield a printed wiring board, using the formed pattern, the substrate for forming the printed wiring board may be processed by an etching treatment or a plating treatment (by means of conventional subtractive or additive method e.g. semi-additive or full-additive method). Among these methods, the subtractive method is preferable in order to form printed wiring boards by industrially advantageous tenting. After the treatment, the hardened resin remaining on the substrate of the printed wiring board is peeled off, or copper thin film is etched after the peeling in the case of semi-additive process, thereafter the intended printed wiring board is obtained. In the case of multi-layer printed wiring board, the similar process with the printed wiring board may be applicable.
The process for producing printed wiring boards having through holes by means of the pattern forming material will be explained in the following.
Initially, the substrate of printed wiring board is prepared in which the surface of the substrate is covered with a metal plating layer. The substrate of printed wiring board may be a copper-laminated layer substrate, a substrate that is produced by forming a copper plating layer on an insulating substrate such as glass or epoxy resin, or a substrate that is laminated on these substrate and formed into a copper plating layer.

In a case where a protective layer exists on the pattern forming material, the protective film is peeled, and the photosensitive layer of the pattern forming material is contact bonded to the surface of the printed wiring board by means a pressure roller as a laminating process, thereby a laminate may be obtained which contains the substrate of the printed wiring board and the laminate in this order.

The laminating temperature of the pattern forming material may be properly selected without particular limitations; the temperature may be about room temperature such as 15°C to 30 °C, or higher temperature such as 30°C to 180°C, preferably it is substantially warm temperature such as 60°C to 140°C.

The roll pressure of the contact bonding roll may be properly selected without particular limitations; preferably the pressure is 0.1 MPa to 1 MPa.

The rate of the contact bonding may be properly selected without particular limitations, preferably, the velocity is 1 meter/m to 3 meters/m.

The substrate of the printed wiring board may be pre-heated before the contact bonding; and the substrate may be laminated under a reduced pressure.

The laminate may be formed by laminating the pattern forming material on the substrate of the printed wiring board; alternatively by coating the solution of the photosensitive resin composition for pattern forming material directly on the substrate of the printed wiring board, followed by drying the solution, thereby laminating the photosensitive layer and the support on the substrate of the printed wiring board.

Next, the photosensitive layer is hardened by applying a light beam in inert atmosphere from the opposite surface of the substrate surface of the laminate. In the process, when the support is of a material of lamination transfer type, the support is peeled off from the laminate and then the photosensitive layer is exposed (step of peeling-off a support).

Next, the unhardened regions of the photosensitive layer on the substrate of the printed wiring board are dissolved away by means of an appropriate developer, a pattern is formed that contains a hardened layer for forming an interconnection pattern and a hardened layer for protecting a metal layer of through holes, and the metal layer is exposed at the substrate surface of the printed wiring board (developing step).

Additional treatments to promote the hardening reaction, for example, may be performed by means of post-heating or post-exposing optionally. The developing may be of a wet method set forth above or a dry developing method.

Then, the metal layer exposed on the substrate surface of the printed wiring board is dissolved away by an etching liquid as an etching process. The apertures of the through holes are covered by hardened resin or tent film, therefore, the etching liquid does not infiltrate into the through holes to corrode the metal plating within the through holes, and the metal plating may maintain the specific shape, thus an interconnection pattern may be formed on the substrate of the printed wiring board.

The etching liquid is not particularly limited and may be suitably selected depending on the application; cupric chloride solution, ferric chloride solution, alkali etching solution, and hydrogen peroxide solution are exemplified for the etching liquid when the metal layer set forth above is formed of copper; among these, ferric chloride solution is preferred in light of the etching factor.

Then, the hardened layer is removed from the substrate of the printed wiring board by means of a strong alkali aqueous solution for example as the removing step of hardened material.

The basic component of the strong alkali aqueous solution may be properly selected without particular limitations, examples of the basic component include sodium hydroxide and potassium hydroxide. The pH of the strong alkali aqueous solution may be about 12 to 14 for example, preferably about 13 to 14.

The strong alkali aqueous solution may be an aqueous solution of sodium hydroxide or potassium hydroxide at a concentration of 1 to 10 % by mass.

The printed wiring board may be of multi-layer construction or may be a flexible substrate. The pattern forming material set forth above may be applied to plating processes instead of the etching process set forth above. The plating method may be copper plating such as copper sulfate plating and copper pyrophosphate plating; solder plating such as high flow solder plating; nickel plating such as watt bath (nickel sulfate-nickel chloride) plating and nickel sulfamate plating; and gold plating such as hard gold plating and soft gold plating.

- Color Filter Forming Process -

When the pattern forming process of the present invention is a process of forming a color filter using the color resist layer, pixels in three primary colors can be arranged into a mosaic-like or stripe shape on a transparent substrate such as glass substrate according to the pattern forming process of the present invention.

The size of respective pixels is not particularly limited and may be suitably selected in accordance with the intended use. For example, pixels of 40 μm to 200 μm in width are preferably exemplified. When the pixels in three colors are arranged into a stripe shape, pixels of 40 μm to 200 μm in width are commonly used.

For the color filter forming process, a process is exemplified in which a photosensitive layer colored in black is used on a transparent substrate, the photosensitive layer is exposed and developed to form a black matrix, then,

photosensitive layers each colored in any one of three primary colors of RGB are used, the photosensitive layers are sequentially exposed and developed in a repeated manner for each color with a predetermined configuration relative to the black matrix, to thereby form a color filter in which three primary colors of RGB are arranged in a mosaic-like or stripe shape on the transparent substrate.

The color filter formed by the color filter forming process described above can be preferably used for video cameras, monitors, liquid crystal color television sets, and the like.

Hereafter, the present invention will be further described in detail referring to specific Examples and Comparative Examples, however, the present invention is not limited to the disclosed Examples.

(Example 1)

- Preparation of Photosensitive Transfer Material -

A composition for oxygen insulation layer containing of the following composition was applied over a surface of a polyethylene terephthalate (PET) film having a thickness of 20 μm, and the surface of the polyethylene terephthalate (PET) film was dried to form an oxygen insulation layer having a film thickness of 1.5 μm. With respect to the absorption properties of the obtained oxygen insulation layer, it had an absorbance at a wavelength of 405 nm of 0.04 and an absorbance at a wavelength of 500 nm of 2.8.

| < Composition of Oxygen Insulation Layer Composition> | |
|---|---|
| Polyvinyl alcohol (PVA205, manufactured by KURARAY Co., Ltd.) | 13 parts by mass |
| Polyvinyl pyrrolidone | 6 parts by mass |
| Methyl Violet 2B | 0.285 parts by mass |
| Water | 200 parts by mass |
| Methanol | 180 parts by mass |

A photosensitive composition containing of the following composition was applied over a surface of the oxygen insulation layer, and the surface of the oxygen insulation layer was dried to form a photosensitive layer having a film thickness of 35 μm on the oxygen insulation layer.

| < Composition of Photosensitive Layer Composition > | |
|---|---|
| Barium sulfate dispersion | 24.75 parts by mass |
| Methylethylketone solution (35% by mass) of a styrene/ maleic acid/ butyl acrylate copolymer (molar ratio: 40/32/28,100% modified product with benzylamine) | 13.36 parts by mass |
| R712 (bifunctional acryl monomer manufactured by Nippon Kayaku Co., Ltd.) | 3.06 parts by mass |
| Dipentaerythritol hexaacrylate | 4.59 parts by mass |
| IRGACURE819 (manufactured by Chiba Specialty Chemicals K.K.) | 1.98 parts by mass |
| Methylethylketone solution (30% by mass) of F780F (manufactured by Dainippon Ink and Chemicals, Inc.) | 0.066 parts by mass |
| Hydroquinone monomethylether | 0.024 parts by mass |
| Methylethylketone | 8.6 parts by mass |

The barium sulfate dispersion was prepared by preliminarily mixing 30 parts by mass of a barium sulfate (B30, manufactured by Sakai Chemical Industry Co., Ltd.), 34.29 parts by mass of a 35% by mass methylethylketone solution of a styrene/maleic acid/butyl acrylate copolymer (molar ratio: 40/32/28, 100% modified product with benzylamine), and 35.71 parts by mass of 1-methoxy-2-propylacetate, and then dispersing the mixture in MOTOR MILL M-200 (manufactured by Eiger Co.) at a circumferential speed of 9 m/s for 3.5 hours using zirconia beads having a diameter of 1.0mm.

Next, a polypropylene having a thickness of 12 μm as a protective film was laminated on the photosensitive layer to thereby form a photosensitive transfer material.

The polypropylene film was peeled off from the obtained photosensitive transfer material, a laminate substrate on which an interconnection having a copper thickness of 12 μm had been formed was chemically polished, and then the photosensitive transfer material was laminated on the laminate under the conditions of application of pressure of 0.4 MPa and heating temperature of 90°C to thereby form a solder resist film on the laminate substrate. At that point of peeling off the polypropylene film from the photosensitive transfer material, the photosensitive layer did not have so strong tucking property, and it was possible to smoothly peel off the polypropylene film.

< Exposure Step >

The PET film having a thickness of 20 μm was peeled off from the photosensitive transfer material, and the photosensitive layer formed on the substrate was applied with a laser beam having a wavelength of 405 nm and exposed using a pattern forming apparatus, which will be hereinafter described, such that a 15-step wedge pattern (ΔlogE (OD) = 0.15) and a desired interconnection pattern could be obtained, thereby hardening part of regions of the photosensitive layer.

- Pattern Forming Apparatus -

A pattern forming apparatus was used which has a combined laser source as the light irradiation unit shown in FIGS. 27A to 32; DMD 50 which is controlled to drive only 1,024 micromirror arrays x 256 micromirror arrays within the above noted light modulating unit where 1,024 micromirror arrays are arrayed in the main-scanning direction shown in FIGS. 4A and 4B and 768 micromirror arrays are arrayed in the sub-scanning direction therein; microlens array 472 in which microlenses each having a toric surface on one surface thereof shown in FIG. 13A are arrayed; and optical systems 480 and 482 which form laser beams passed through the microlens array into an image on the photosensitive layer.

For the microlens, toric lens 55a was used as shown in FIGS. 17A, 17B, 18A, and 18B, and the curvature radius of optical X direction Rx is - 0.125 mm, and the curvature radius of optical Y direction Ry is - 0.1 mm.

Aperture array 59 disposed near the focal point of the microlens array 55 is arranged such that only laser beams passes through the microlenses 55a corresponding to respective apertures 59a are incident into the respective apertures 59a.

Next, a 1% by mass sodium carbonate aqueous solution used as an alkali developer, and the photosensitive transfer material was subjected to shower developing with the sodium carbonate aqueous solution at 30°C for 60 seconds, washed with water, and then dried. The exposure sensitivity of the photosensitive transfer material was about 30 $mJ/cm^2$, and the resolution was 50 μmϕ.

Subsequently, the photosensitive transfer material was heated at 160°C for 30 minutes to thereby obtain a desired pattern formed solder resist film. The solder resist film was visually checked, and there were no air bubbles observed.

The obtained the photosensitive transfer material substrate with solder resist formed thereon was acid-washed, treated with a water soluble flux, followed by immersing the substrate in a solder bath at 260°C for 5 seconds three times, and then the flux was removed by washing it with water. The pencil hardness of the photosensitive transfer material was checked according to JIS K5400, and the substrate had a pencil hardness of 3H to 4H. In the visual check, no exfoliated portion, blistered portion, or discoloration was observed in the photosensitive transfer material.

The photosensitive transfer material was left for six months under the conditions of 23° and 65% RH, and thereafter evaluated. The photosensitivity of the photosensitive transfer material was 20 mJ/cm2 and the resolution was 50 μmϕ.

Then, the photosensitive transfer material was located in a place under yellow fluorescent lamp of 100 lux for a given length of time such that the oxygen insulation layer faced to the fluorescent lamp, and the photosensitive transfer material was laminated on a copper substrate to thereby form a copper substrate laminate sample. A change in photosensitivity of the laminate sample was checked by exposing and developing the laminate sample to determine the allowed time of which the laminate could be left under yellow fluorescent lamp. As the result, no change in photosensitivity was recognized even when the laminate sample was left for 120 minutes or more. Table 3 shows the results. (Comparative Example 1)

A photosensitive transfer material was prepared in the same manner as in Example except that the dye (Methyl Violet 2B) was not added in the oxygen insulation layer. With respect to the absorption properties of the obtained oxygen insulation layer, the absorbance of the oxygen insulation layer was zero at both wavelengths of 405 nm and 500 nm.

The photosensitive transfer material was evaluated in the same manner as in Example 1. The exposure sensitively of the photosensitive transfer material was 25 $mJ/cm^2$, and the resolution was 50 μmϕ.

Then, the photosensitive transfer material was evaluated as to safety under yellow fluorescent lamp. As the result, the photosensitive transfer material was photosensitive to the yellow fluorescent lamp in 20 minutes. Table 3 shows the results.

Table 3

| | Photosensitivity | Resolution | Safety in a case of using yellow light (Change in safety value of 120 minutes later) | | |
|---|---|---|---|---|---|
| | At the initial stage | | Developing | Photosensitivity | Change in property line width |
| | $mJ/cm^2$ | μmϕ | Second | $mJ/cm^2$ | μm/100μm line |
| Ex.1 | 30 | 50 | Not photosensitive to yellow light | 30 | ±0 |
| Compara. Ex.1 | 25 | 50 | Photosensitive to yellow light | - | - |

(Example 2)

A composition for oxygen insulation layer containing of the following composition was applied over a surface of a polyethylene terephthalate (PET) film having a thickness of 16 μm, and the surface of the polyethylene terephthalate (PET) film was dried to form an oxygen insulation layer having a film thickness of 1.5 μm. With respect to the absorption properties of the obtained oxygen insulation layer, it had an absorbance at a wavelength of 405 nm of 0.04 and an absorbance at a wavelength of 500 nm of 2.8.

< Composition of Oxygen Insulation Layer Composition>

| | |
|---|---|
| Polyvinyl alcohol (PVA205, manufactured by KURARAY Co., Ltd.) | 13 parts by mass |
| Polyvinyl pyrrolidone | 6 parts by mass |
| Methyl Violet 2B | 0.285 parts by mass |
| Water | 200 parts by mass |
| Methanol | 180 parts by mass |

A photosensitive composition containing the following composition was applied over the surface of the oxygen insulation layer, and the surface of the oxygen insulation layer was dried to form a photosensitive layer having a film thickness of 35 μm on the oxygen insulation layer.

< Composition of Photosensitive Layer Composition >

| | |
|---|---|
| Methylmethacrylate/2-ethylhexyl acrylate/benzyl methacrylate/ methacrylic acid copolymer (copolymer composition ratio (molar ratio): 40/26.7/4.5/28.8; mass average molecular mass: 90,000; Tg: 50°C) | 15 parts by mass |
| Polypropylene glycol diacrylate | 6.5 parts by mass |
| Tetraethylene glycol dimethacrylate | 1.5 parts by mass |
| 4,4'-bis (diethylamino)benzophenone | 0.4 parts by mass |
| Benzophenone | 3.0 parts by mass |
| p-toluenesulfoneamide | 0.5 parts by mass |
| Malachite green oxalate | 0.02 parts by mass |
| 3-morpholinomethyl-1-phenyltriazole-2-thion | 0.01 parts by mass |
| Leucocrystal violet | 0.2 parts by mass |
| Tribromomethylphenylsulfone | 0.1 parts by mass |
| Methylethylketone | 30 parts by mass |

Next, a polyethylene film having a thickness of 20 μm was laminated on the photosensitive layer to thereby prepare a photosensitive transfer material.

The obtained photosensitive transfer material was evaluated in the same manner as in Example 1. The exposure sensitivity of the photosensitive transfer material was about 30 $mJ/cm^2$, the resolution was 50 μmϕ. The optical quantity required to harden the photosensitive transfer material was 4 $mJ/cm^2$.

The photosensitive transfer material was left under the conditions of 23°C and 65% RH for six months and

thereafter evaluated. The photosensitivity of the photosensitive transfer material was 20 mJ/cm$^2$, and the resolution was 50 μmφ. Then, the photosensitive transfer material was located in a place under yellow fluorescent lamp of 100 lux for a given length of time such that the oxygen insulation layer faced to the fluorescent lamp, and the photosensitive transfer material was laminated on a copper substrate to thereby form a copper substrate laminate sample. A change in photosensitivity of the laminate sample was checked by exposing and developing the laminate sample to determine the allowed time of which the laminate could be left under yellow fluorescent lamp. As the result, no change in photosensitivity was recognized even when the laminate sample was left for 120 minutes or more.

(Example 3)

- Preparation of Cushion Layer Material -

The materials shown in Table 4 were blended to prepare a solution of a cushion layer material (I).

First, as a support of a photosensitive transfer material for forming a circuit, a polyethylene terephthalate film having a thickness of 16 μm (trade name: G2-16, manufactured by TEIJIN Ltd.) was used. The solution of cushion layer material (I) was uniformly applied over a surface of the polyethylene terephthalate film such that the dried thickness of the work could be 10 μm, and the work was dried in a hot air convection drier heated at 100°C for 10 minutes to thereby form a cushion layer on the support. With respect to the absorption properties of the obtained cushion layer, it had an absorbance at a wavelength of 405 nm of 0.04 and an absorbance at a wavelength of 500 nm of 2.8.

Table 4

| Item | Material | Ethylene component (% by mass) | Blended quantity (parts by mass) |
|---|---|---|---|
| Cushion layer (I) | Toluene | - | 83 |
| | EVA FLEX EEA709 (manufactured by DuPont-Mitsui Polychemicals Co., Ltd) | 65 | 17 |
| | 10% by mass n-butanol solution of METHYL VIOLET 2B | - | 2.55 |

Next, a solution of photosensitive layer material (I) was prepared using the materials shown in Table 5.

The solution of photosensitive layer material (I) was uniformly applied over the surface of the cushion layer such that the dried thickness of the work could be 4 μm, and the work was dried in a hot air convection drier heated at 100°C for 10 minutes to thereby form a photosensitive layer on the cushion layer.

Table 5

| Item | Material | Blended quantity |
|---|---|---|
| Components (A) | 40% by mass methylcellosolve/toluene (mass ratio: 60/40) solution of a copolymer of methacrylic acid/methylmethacrylate/styrene (mass ratio: 20/60/20; mass average molecular mass: 60,000) | 137.5 parts by mass (Solid content 55 parts by mass) |
| Components (B) | 2,2'-bis ((4-methacryloxypentaethoxy) phenyl) propane | 30 parts by mass |
| | γ-chloro-β-hydroxypropyl-β-methacryloyl Methoxymethyl-o-phthalate | 15 parts by mass |
| Components (C) | 2-(o-chlorophenyl)-4,5-diphenylimidazole dimer | 3.0 parts by mass |
| | 4,4'-bisdiethylaminobenzophenone | 0.2 parts by mass |
| Color coupler | Leucocrystal violet | 0.5 parts by mass |

(continued)

| Item | Material | Blended quantity |
|---|---|---|
| Dye | Malachite green | 0.05 parts by mass |
| Solvent | Acetone | 10 parts by mass |
| | Toluene | 10 parts by mass |
| | Methanol | 3 parts by mass |
| | N,N-dimethylformamide | 3 parts by mass |

Next, the photosensitive layer surface was protected with a biaxially drawn polypropylene film having a thickness of 20 μm (trade name: E-200H, manufactured by OJI Paper Co.) as a secondary film, thereby a photosensitive transfer material for forming a circuit was prepared. The obtained photosensitive transfer material for forming a circuit was rewound such that the support could appear at the outermost.

The obtained photosensitive transfer material was evaluated in the same manner as in Example 1.

A sample of the photosensitive transfer material that was located in a place under yellow fluorescent lamp of 100 lux for a given length of time such that the oxygen insulation layer faced to the fluorescent lamp, and a change in photosensitivity of the sample was checked by exposing and developing the sample to determine the allowed time of which the laminate could be left under yellow fluorescent lamp. As the result, no change in photosensitivity was recognized even when the sample was left for 120 minutes or more.

(Example 4)

A coating solution for cushion layer containing the following composition was applied over a surface of a provisional support of a polyethylene terephthalate film having a thickness of 100 μm, and the surface of the provisional support was dried to thereby form a cushion layer having a dried thickness of 20 μm on the provisional support.

< Composition for Cushion Layer >

| | |
|---|---|
| Methylmethacrylate/2-ethylhexyl acrylate/benzyl methacrylate/ methacrylic acid copolymer (copolymer composition ratio (molar ratio): 55/28.8/11.7/4.5; mass average molecular mass: 90,000) | 15 parts by mass |
| Polypropylene glycol diacrylate (average molecular mass 822) | = 6.5 parts by mass |
| Tetraethylene glycol dimethacrylate | 1.5 parts by mass |
| p-toluenesulfoneamide | 0.5 parts by mass |
| Benzophenone | 1.0 parts by mass |
| Methylethylketone | 30 parts by mass |

Next, a coating solution for oxygen insulation layer containing the following composition was applied over the surface of the cushion layer, and the surface of the cushion layer was dried to form an oxygen insulation layer having a dried thickness of 1.6 μm. With respect to the absorption properties of the obtained oxygen insulation layer, it had an absorbance at a wavelength of 405 nm of 0.04 and an absorbance at a wavelength of 500 nm of 2.8.

< Composition of Coating Solution for Oxygen Insulation Layer >

| | |
|---|---|
| Polyvinyl alcohol (PVA205, manufactured by KURARAY Co., Ltd.; saponification rate = 80%) | 130 parts by mass |
| Polyvinyl pyrrolidone (PVP K-90, manufactured by GAF Corporation) | 60 parts by mass |
| Methyl Violet 2B | 3 parts by mass |
| Fluorochemical surfactant (SURFLON-S131, manufactured by Asahi Glass Co.) | 10 parts by mass |
| Distilled water | 3,350 parts by mass |

Next, four color photosensitive solutions for black color (for K layer), red color (for R layer), green color (for G layer), and blue color (for B layer) each containing the formulation shown in Table 6 were respectively applied over each surface of four sheets of provisional supports respectively having the cushion layer and the oxygen insulation layer set

forth above, and each of the provisional supports surfaces was dried to thereby form four colored photosensitive layers each having a dried thickness of 2 μm.

Table 6

| | R layer (g) | B layer (g) | G layer (g) | K layer (g) |
|---|---|---|---|---|
| Benzyl methacrylate/methacrylic acid copolymer (molar ratio = 73/27, Viscosity = 0.12 | 60 | 60 | 60 | 60 |
| Pentaerythritol tetraacrylate | 43.2 | 43.2 | 43.2 | 43.2 |
| Michler's ketone | 2.4 | 2.4 | 2.4 | 2.4 |
| 2-(o-chlorophenyl)-4.5-diphenyl imidazole dimer | 2.5 | 2.5 | 2.5 | 2.5 |
| Irgazin Red BPT (Red) | 5.4 | - | - | - |
| Sudan Blue (Blue) | - | 5.2 | - | - |
| Copper phthalocyanine (Green) | - | - | 5.6 | - |
| Carbon black (Black) | - | - | | 5.6 |
| Methylcellosolve acetate | 560 | 560 | 560 | 560 |
| Methylethylketone | 280 | 280 | 280 | 280 |

Next, on each of the photosensitive layers, a film sheet of polypropylene having a thickness of 12 μm was contact bonded, thereby photosensitive transfer materials in red color, blue color, green color, and black color were prepared.

Then, the photosensitive transfer material was located in a place under yellow fluorescent lamp of 100 lux for a given length of time such that the oxygen insulation layer faced to the fluorescent lamp, and the photosensitive transfer material was laminated on a copper substrate to thereby form a copper substrate laminate sample. A change in photosensitivity of the laminate sample was checked by exposing and developing the laminate sample to determine the allowed time of which the laminate could be left under yellow fluorescent lamp. As the result, no change in photosensitivity was recognized even when the laminate sample was left for 120 minutes or more.

< Preparation of Color Filter >

A color filter was prepared using the obtained four sheets of photosensitive transfer materials according to the following method.

The film sheet of the red colored photosensitive transfer material was peeled off from the photosensitive transfer material, and the photosensitive transfer material was pressurized at 0.8 kgf/cm$^2$ on a surface of a transparent glass substrate (thickness: 1.1 mm) so as to make the photosensitive layer surface contact with the glass substrate surface using a laminator (VP-II, manufactured by Taisei Laminator Co., Ltd.); the photosensitive transfer material and the glass substrate were heated at 130°C and laminated each other, followed by separating the provisional support from the photosensitive transfer material at a boundary face with the cushion layer to remove the provisional support. Next, a laser beam incorporating information of a predetermined pattern was applied to the photosensitive transfer material in the same manner as in Example 1, and the cushion layer and the oxygen insulation layer were removed using a 1% by mass triethanolamine aqueous solution. At that time, the photosensitive layer was not actually developed.

Subsequently, the photosensitive layer was developed using a 1 % by mass sodium carbonate aqueous solution to remove unnecessary portions, thereby a red colored pixel pattern was formed on the glass substrate. Next, on the glass substrate with the red colored pixel pattern formed thereon, the green colored photosensitive transfer material was laminated in the same manner as described above, the photosensitive transfer material was subjected to exfoliation, exposure, and developing steps to thereby form a green colored pixel pattern. The same processes were repeatedly performed for the blue photosensitive transfer material and the black photosensitive transfer material, thereby a color filter was formed on the transparent glass substrate. In these processes described above, the provisional support was excellently exfoliated from the cushion layer, the obtained color filter showed no sign of missing pixels, exhibited excellent adhesiveness with the substrate, and had no contamination.

(Example 5)

On a two-sided copper clad laminate having a copper layer of 18 μm in length on both surfaces thereof, an interconnection pattern (a first interconnection pattern) of 100 μm in width and 120 μm in space was prepared by a conventional subtractive method, and the copper surface was blackened by a conventional method. After peeling off the protective film from the photosensitive transfer material of Example 1, two photosensitive layers were individually laminated on both surfaces of the substrate to form to form a photosensitive interlayer insulation layer.

Next, a laser beam incorporating a pattern for forming a via hole (pore for connecting the respective layers) was applied to the photosensitive interlayer insulation layer using the pattern forming apparatus of Example 1 at an exposure dose of 50 mJ/cm$^2$, and exposing speed of 40 mm/sec, and then the photosensitive interlayer insulation layer was subjected to shower developing for 60 seconds using a 1 % by mass sodium carbonate aqueous solution of 30°C. As the result, a via hole having a diameter of about 65 μm was formed in the photosensitive interlayer insulation layer. Thereafter, the entire surface of the photosensitive interlayer insulation layer was exposed using a diffusion exposer under the condition of 1,900 mJ/cm$^2$. Next, the photosensitive interlayer insulation layer was heated at 160°C for 60 minutes to subject it to a post-hardening treatment. The substrate having the photosensitive interlayer insulation layer was subjected to a surface treatment at a temperature of 180°C using a unit for atmospheric pressure ozone surface treatment, CDO-201 (manufactured by k-tech Co.) to remove developing scum. The photosensitive interlayer insulation layer was immersed in a 2.5% by mass diluted sulfuric acid aqueous solution at 24°C for 2 minutes, and then an electroless plating layer was formed using the following treatment agent according to the following steps of I to V.

(I) The substrate set forth above was immersed in a pre-treatment agent (PC206, manufactured by Meltex Inc.) at 25°C for 2 minutes, and then the substrate was washed with purified water for 2 minutes.
(II) The substrate was immersed in a catalyst activator (ACTIVATOR 444, manufactured by Meltex Inc.) at 25°C for 6 minutes, and then the substrate was washed with purified water for 2 minutes.
(III) The substrate was immersed in an activation treatment agent (PA491, manufactured by Meltex Inc.) at 25°C for 10 minutes, and then the substrate was washed with purified water for 2 minutes.
(IV) The substrate was immersed in an electroless plating solution (CU390, manufactured by Meltex Inc.) under the conditions of 25°C, and pH12.8 for 20 minutes, and then the substrate was washed with purified water for 5 minutes.
(V) The substrate was died at 100°C for 15 minutes.

As the results, an electroless copper plating layer having a film thickness of 0.3 μm was formed on the insulation layer.

Then, the substrate was immersed in a degreasing treatment liquid (PC455) manufactured by Meltex Inc. at 25°C for 30 seconds and washed with water for 2 minutes, thereby performing electrolytic copper plating. The substrate was plated using an electrolytic copper plating solution having a composition of 75g/L of copper sulfate, 190g/L of sulfuric acid, about 50 ppm of chloride ion, and 5mL/L of COPPER GLEAM PCM manufactured by Meltex Inc. under the conditions of 2.4A/100 cm$^2$ for 40 minutes. As the result, copper having a thickness of about 20 μm was deposited. Next, the substrate having the obtained plating layer was put in an oven and left at 170°C for 60 minutes to thereby anneal the substrate.

Next, the substrate was imagewisely exposed using a dry film photo resist, and then developed. Then, the exposed plating layer (copper) was subjected to an etching treatment, thereby a secondary interconnection pattern and an interlayer connecting region were formed.

The substrate on which the interconnection pattern and the interlayer connecting region were formed on the obtained insulation layer was tested as to solder dip resistance of 260°C for 20 seconds, and no exfoliated portion and blistered portion was observed on the substrate. In addition, the substrate marked 10 points in evaluation of cross-cut adhesion test with grid intervals of 5 mm based on JIS K5400, and the adhesion between the interconnection pattern and the insulation resin layer was excellent. In addition, the substrate was cut into 100 mm width, and 90 degrees peeling test was performed on the substrate using a Tensilon tension tester to measure the peeling strength. As the result, the substrate had a peeling strength of 0.6 kg/cm or more.

Further, the photosensitive composition coating solution set forth above was applied again over the surface of the substrate, and the substrate surface was dried to thereby form an interconnection pattern of a third layer was formed in a similar manner as described above. However, there was no problem caused in the solder dip resistance test. The substrate marked 10 points in evaluation of cross-cut adhesion test with grid intervals of 5 mm based on JIS K5400, and the adhesion between the interconnection pattern and the insulation resin layer was excellent. In addition, the substrate was cut into 100 mm width, and 90 degrees peeling test was performed on the substrate using a Tensilon tension tester to measure the peeling strength. As the result, the substrate had a peeling strength of 0.6 kg/ cm or more.

The photosensitive transfer material was located in a place under yellow fluorescent lamp of 100 lux for a given length of time such that the oxygen insulation layer faced to the fluorescent lamp, and a change in photosensitivity of

the laminate sample was checked by exposing and developing the laminate sample to determine the allowed time of which the laminate could be left under yellow fluorescent lamp. As the result, no change in photosensitivity was recognized even when the laminate sample was left for 120 minutes or more.

Industrial Applicability

The photosensitive transfer material of the present invention has at least any one of an oxygen insulation layer and a cushion layer having light absorbing properties of which the absorbance at a wavelength ranging from 500 nm to 600 nm is 1 or more and the absorbance at a wavelength ranging from 350 nm to 450 nm is 0.3 or less, on a support, allows for preventing light fog under safelight even when the photosensitive transfer material has a highly sensitive photosensitive layer, and is particularly preferably used in producing printed circuit boards and color filters for liquid crystal displays (LCDs).

## Claims

**1.** A photosensitive transfer material, comprising:

a support,
an oxygen insulation layer, and
a photosensitive layer,
the oxygen insulation layer being formed on the support, and the photosensitive layer being formed on the oxygen insulation layer,

wherein the oxygen insulation layer has light absorbing properties of which the absorbance at a wavelength ranging from 500 nm to 600 nm is 1 or more and the absorbance at a wavelength ranging from 350 nm to 450 nm is 0.3 or less.

**2.** A photosensitive transfer material, comprising:

a support,
a cushion layer, and
a photosensitive layer,
the cushion layer being formed on the support, and the photosensitive layer being formed on the photosensitive layer,

wherein the cushion layer has light absorbing properties of which the absorbance at a wavelength ranging from 500 nm to 600 nm is 1 or more and the absorbance at a wavelength ranging from 350 nm to 450 nm is 0.3 or less.

**3.** A photosensitive transfer material, comprising:

a support,
a cushion layer,
an oxygen insulation layer, and
a photosensitive layer,
the cushion layer, the oxygen insulation layer, and the photosensitive layer being formed on or above the support in this order,

wherein at least any one of the cushion layer and the oxygen insulation layer has light absorbing properties of which the absorbance at a wavelength ranging from 500 nm to 600 nm is 1 or more and the absorbance at a wavelength ranging from 350 nm to 450 nm is 0.3 or less.

**4.** The photosensitive transfer material according to any one of claims 1 and 3, wherein the oxygen insulation layer comprises a water soluble polymer and a dye.

**5.** The photosensitive transfer material according to any one of claims 2 and 3, wherein the cushion layer comprises a dye.

**6.** The photosensitive transfer material according to any one of claims 1 to 5 being formed in a roll configuration such

that the photosensitive layer faces inward.

**7.** The photosensitive transfer material according to any one of claims 1 to 5 being formed in a laminate sheet configuration.

**8.** The photosensitive transfer material according to any one of claims 1 to 7, wherein after a light beam from a light irradiation unit is modulated by a light modulating unit having "n" imaging portions which can receive the laser beam from the light irradiating unit and can output the laser beam, the photosensitive layer is exposed with the light beam passed through a microlens array having an array of microlenses each having a non-spherical surface capable of compensating the aberration due to distortion at irradiating surfaces of the imaging portions.

**9.** A pattern forming process, comprising:

forming a photosensitive layer by transferring a photosensitive transfer material according to any one of claims 1 to 8 onto a surface of a substrate under at least any one of heating and pressurizing conditions and laminating the photosensitive transfer material on the substrate surface, and
exposing and developing the photosensitive layer.

**10.** The pattern forming process according to claim 9 used for forming an interconnection pattern.

**11.** The pattern forming process according to claim 9 used for forming a solder resist pattern.

**12.** The pattern forming process according to claim 9 used for forming an interlayer insulation film pattern.

**13.** The pattern forming process according to claim 9, wherein photosensitive compositions respectively colored in at least primary three colors of R, G, and B are used at a predetermined configuration on the substrate surface, and the photosensitive compositions are respectively subjected to formation of a photosensitive layer, exposing, and developing sequentially in a repeated manner for each color to thereby form a color filter.

**14.** The pattern forming process according to any one of claims 9 to 13, wherein the photosensitive layer is exposed using a light irradiation unit configured to irradiate a target with a light beam, and a light modulating unit configured to modulate the light beam emitted from the light irradiation unit.

**15.** The pattern forming process according to claim 14, wherein the light modulating unit further comprises a pattern signal generating unit configured to generate control signals based on the information of a pattern to be formed to thereby modulate the light beam emitted from the light irradiating unit according to the control signals generated by the pattern signal generating unit.

**16.** The pattern forming process according to any one of claims 14 to 15, wherein the light modulating unit is able to control any imaging portions of less than arbitrarily selected "n" imaging portions disposed successively from among the "n" imaging portions depending on the information of a pattern to be formed.

**17.** The pattern forming process according to any one of claims 14 to 16, wherein the light modulating unit is a spatial light modulator.

**18.** The pattern forming process according to claim 17, wherein the spatial light modulator is a digital micromirror device (DMD).

**19.** A pattern formed by a pattern forming process according to any one of claims 9 to 18.

FIG. 1

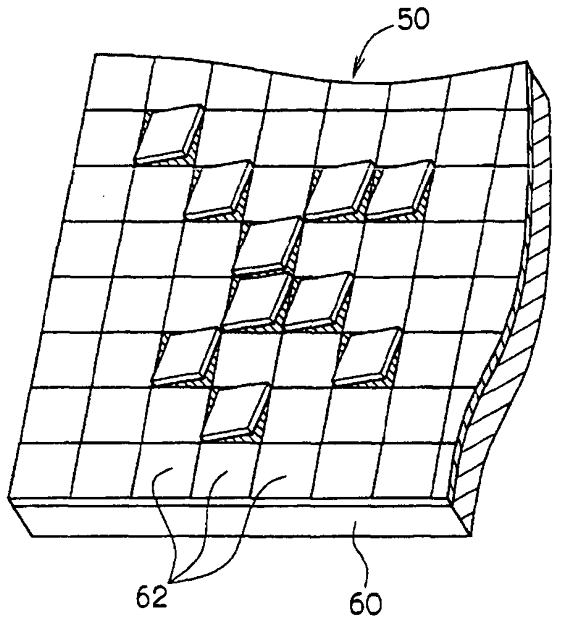


FIG. 2A

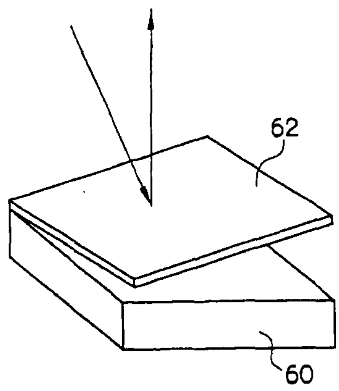


FIG. 2B

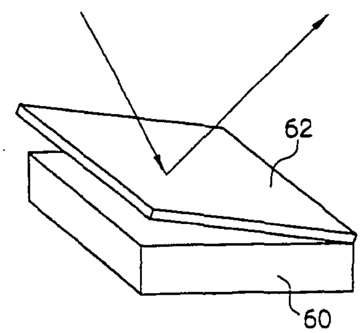

FIG.3A

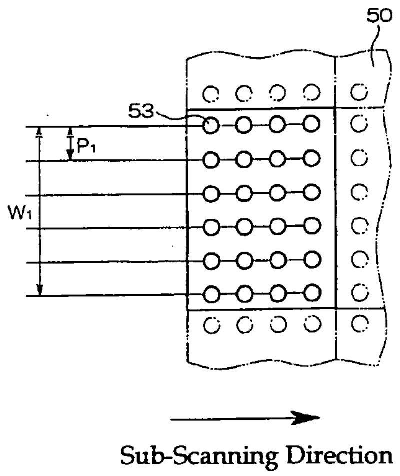


FIG.3B

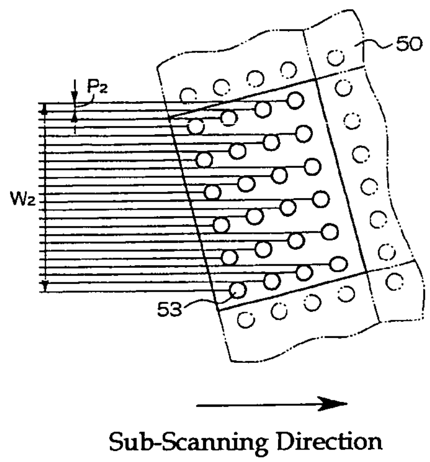


FIG.4A

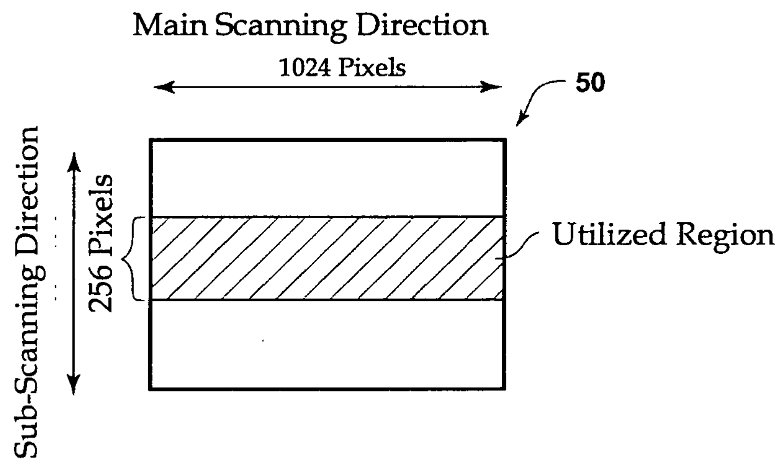


FIG.4B

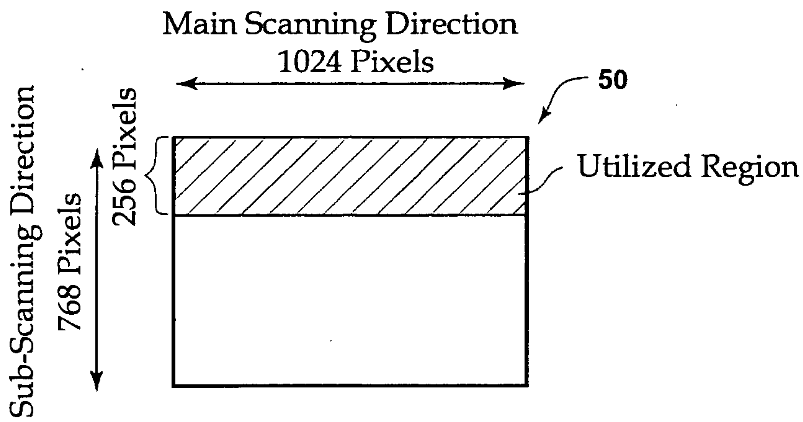

FIG. 5

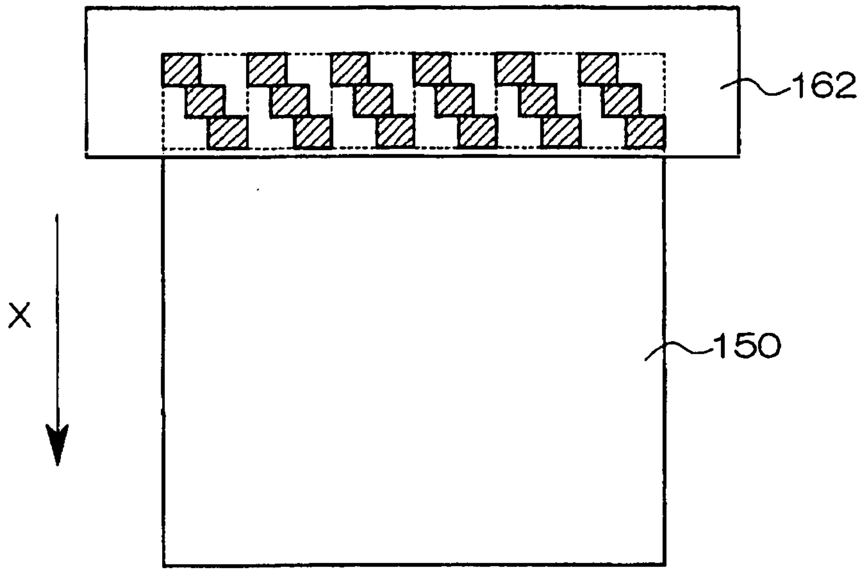

FIG.6A

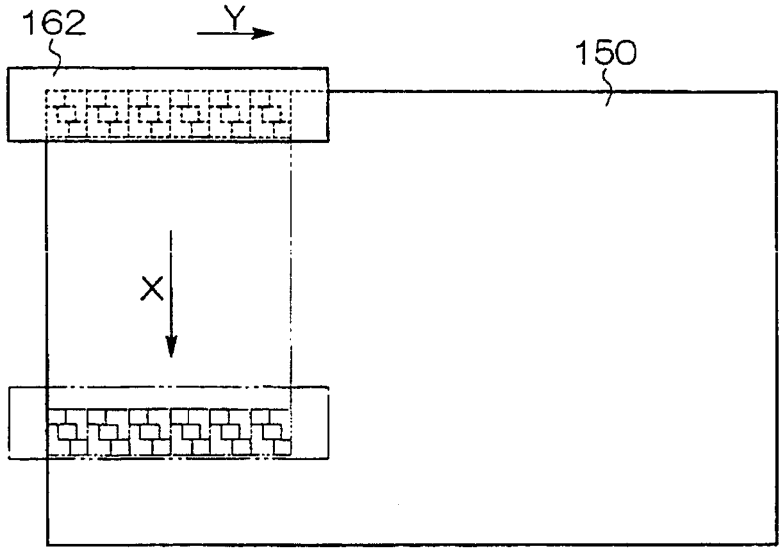


FIG.6B

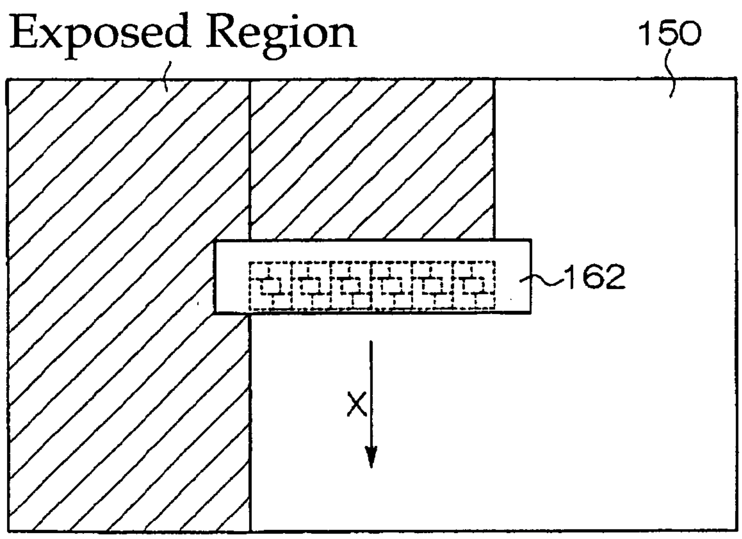

FIG. 7

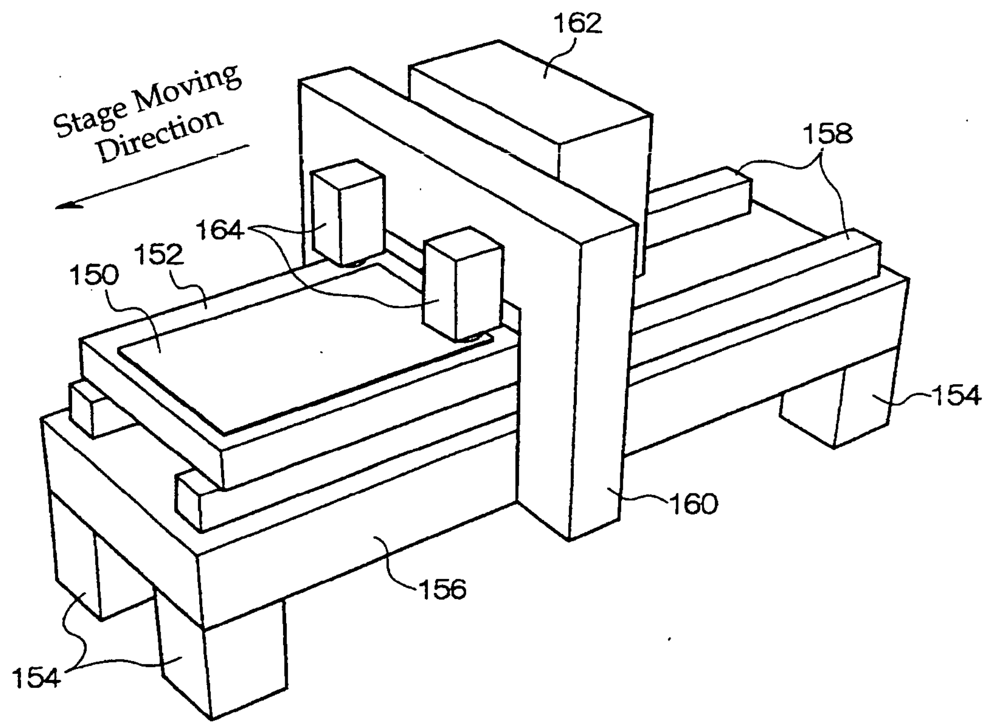
162
Stage Moving Direction
158
164
150
152
154
160
156
154

FIG. 8

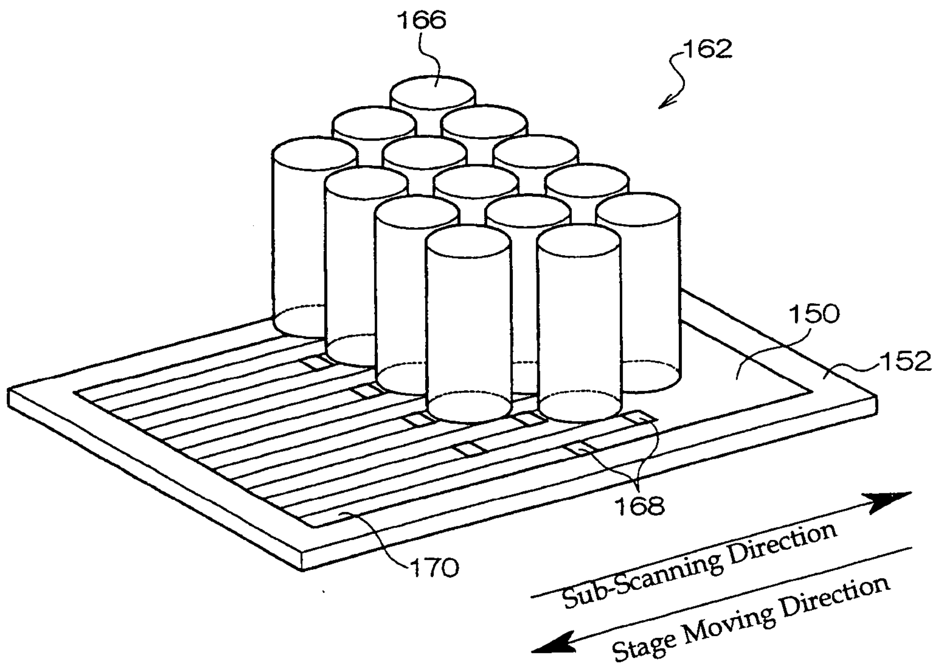
166
162
150
152
168
170
Sub-Scanning Direction
Stage Moving Direction

FIG.9A

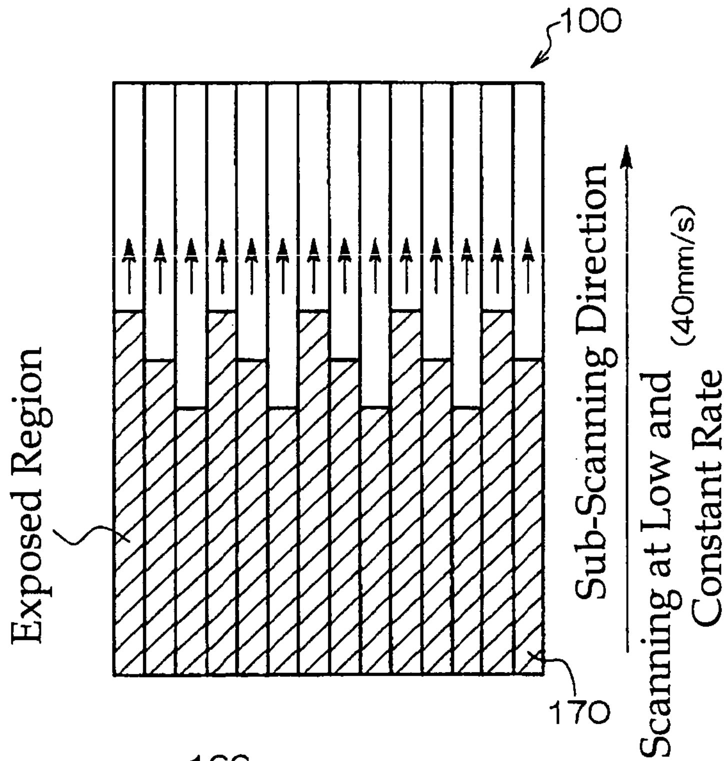
100
Exposed Region
Sub-Scanning Direction
Scanning at Low and Constant Rate
(40mm/s)
170

FIG.9B

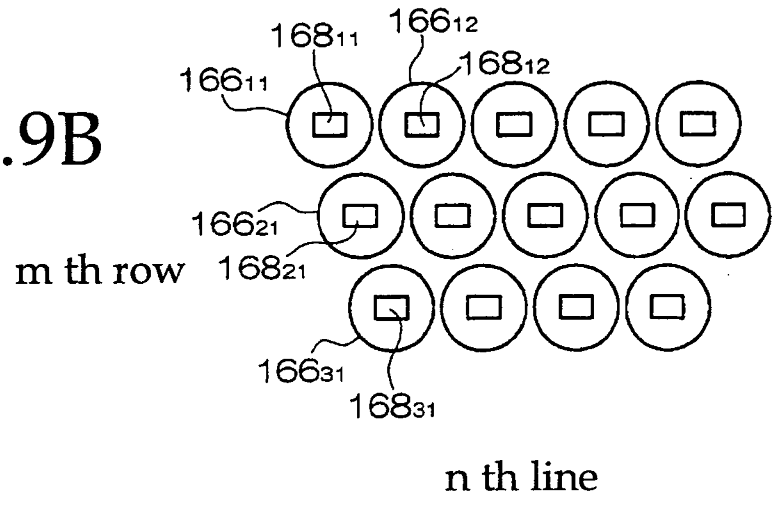
$168_{11}$
$166_{12}$
$168_{12}$
$166_{11}$
$166_{21}$
m th row
$168_{21}$
$166_{31}$
$168_{31}$
n th line

FIG. 10

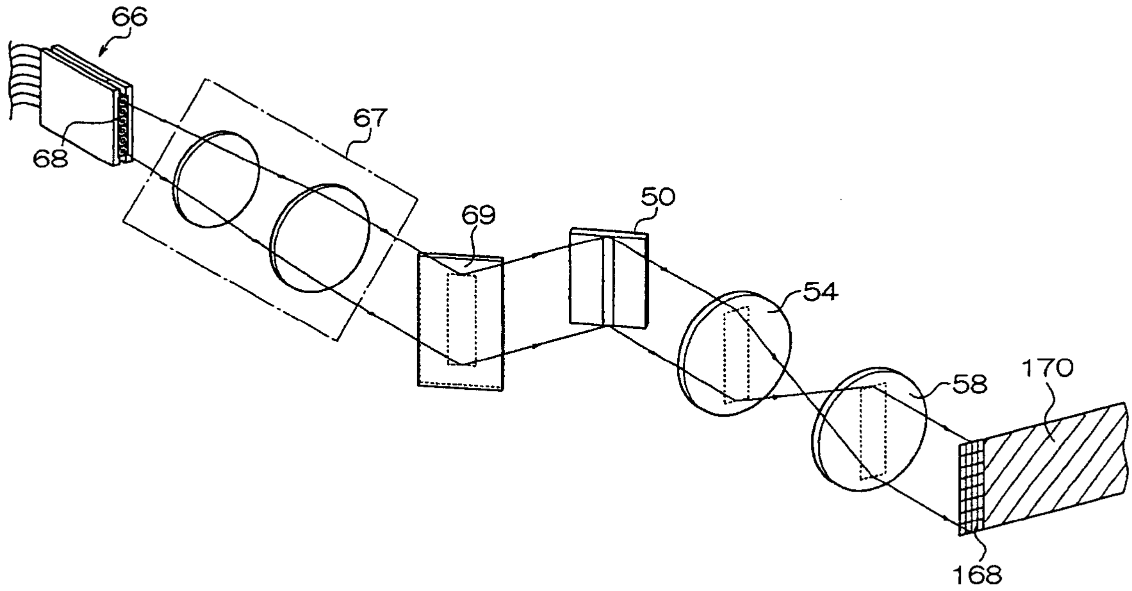

FIG. 11

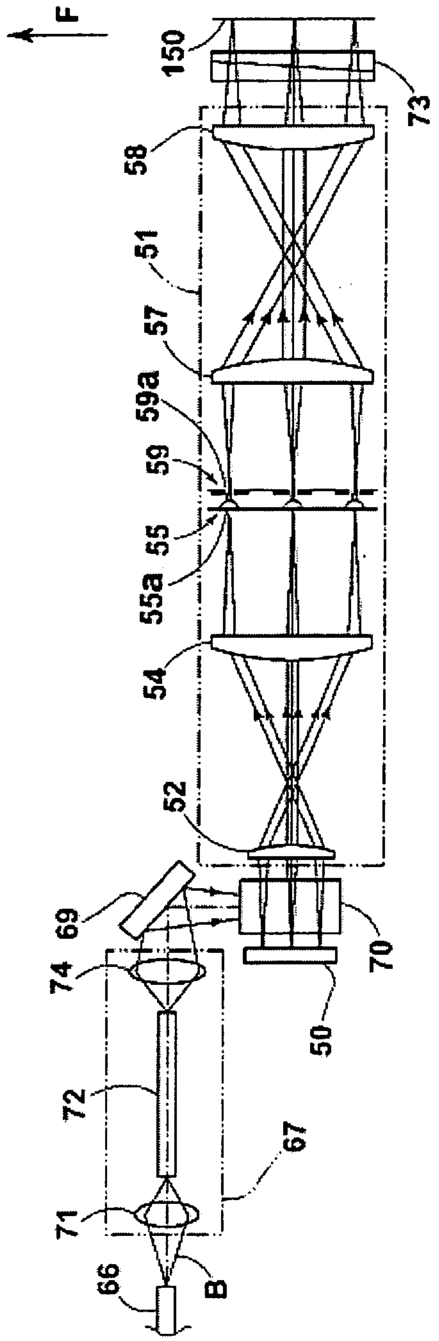

FIG. 12

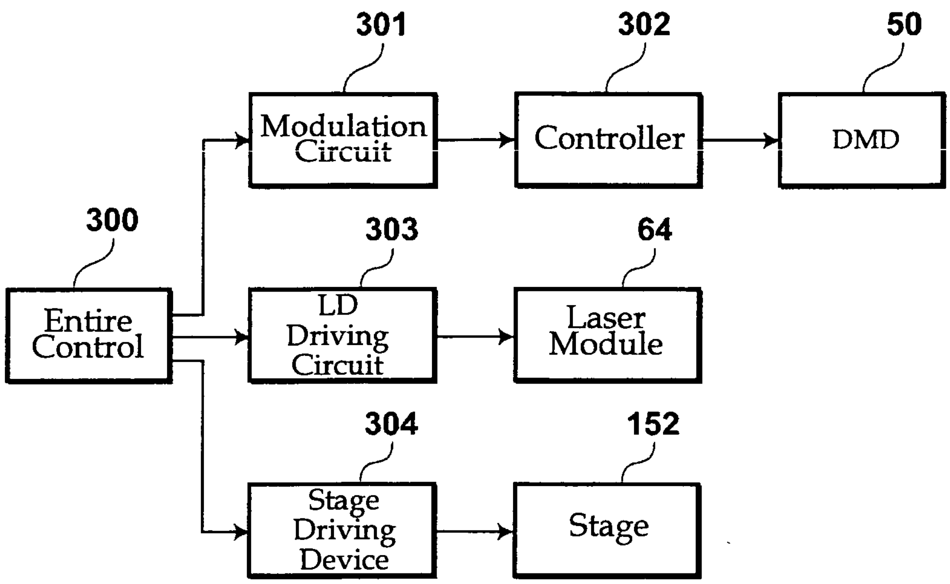


FIG.13A

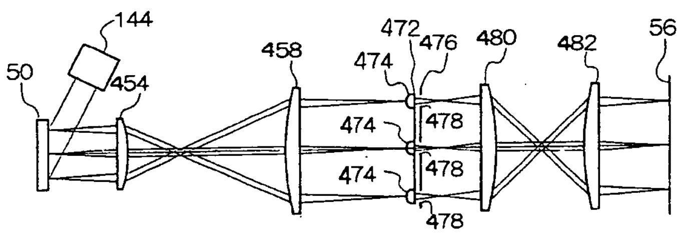


FIG.13B

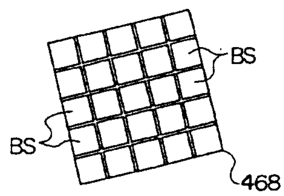


FIG.13C

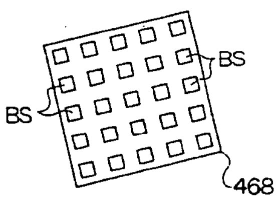

FIG. 14

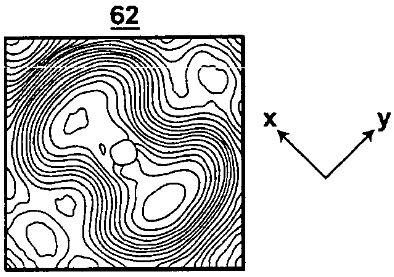


FIG. 15A

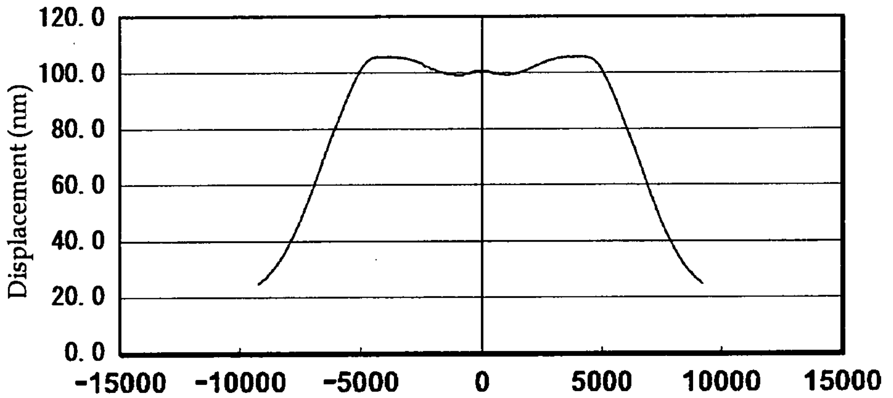


Cross Section in X Direction
(Rotating Direction)

FIG. 15B

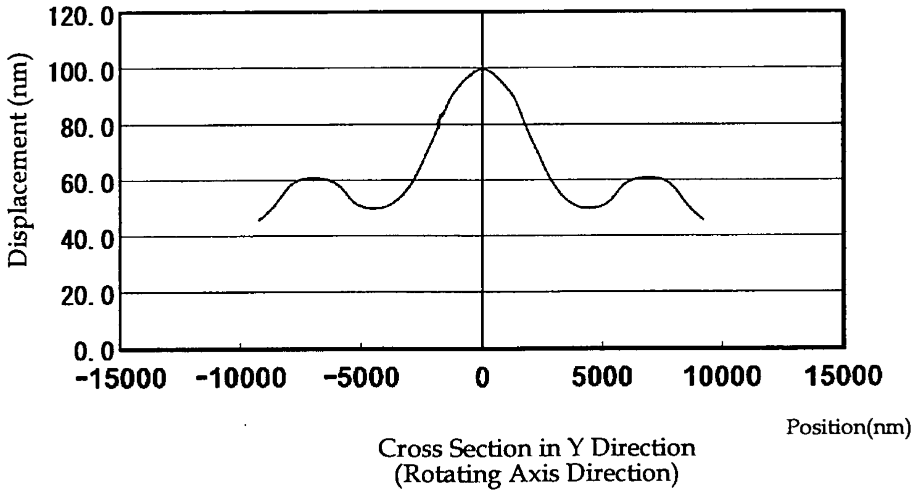


Cross Section in Y Direction
(Rotating Axis Direction)

FIG. 16A

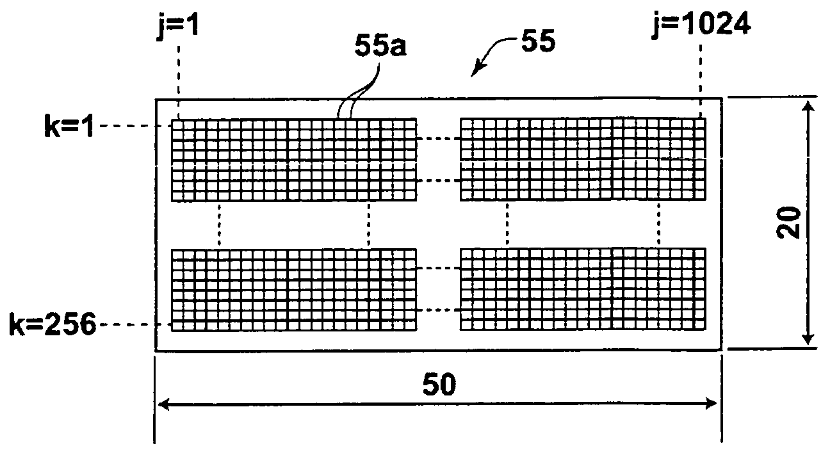


FIG. 16B

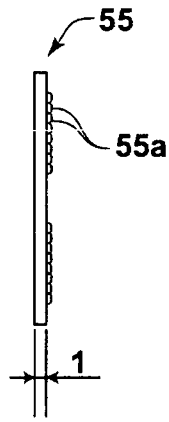


FIG. 17A

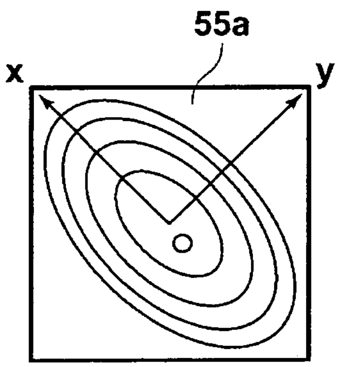


FIG. 17B

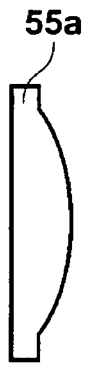

FIG. 18A

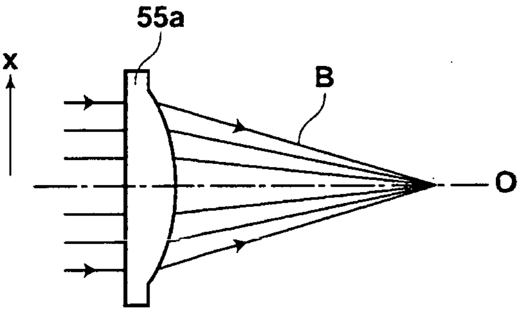


FIG. 18B

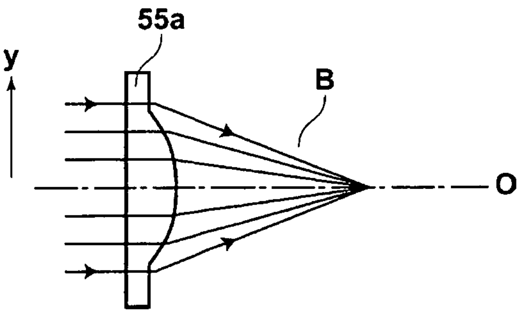


FIG. 19A

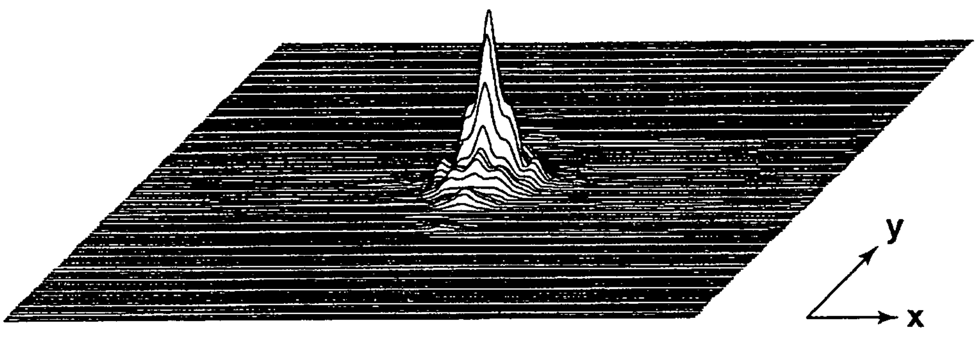


z=0.18mm

FIG. 19B

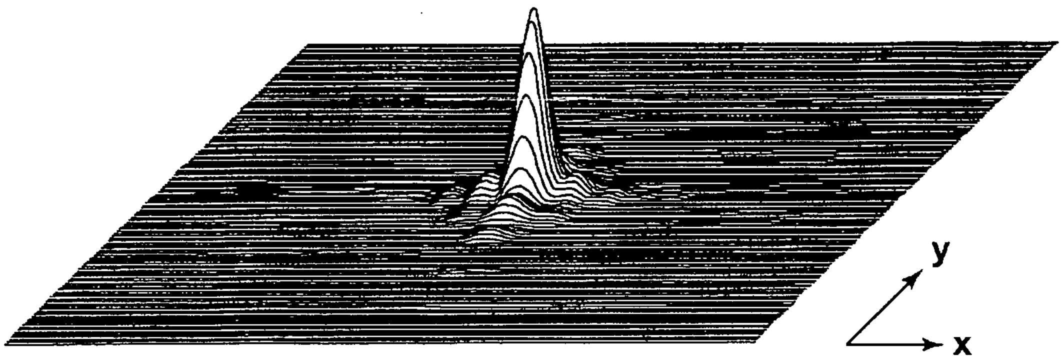


z=0.2mm

FIG. 19C

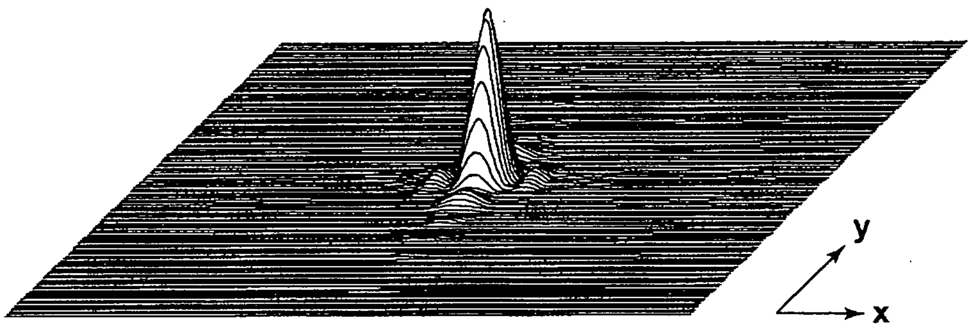


z=0.22mm

FIG. 19D

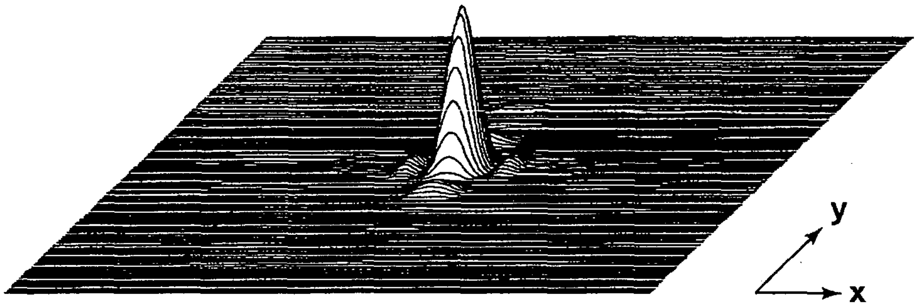


z=0.24mm

FIG. 20A

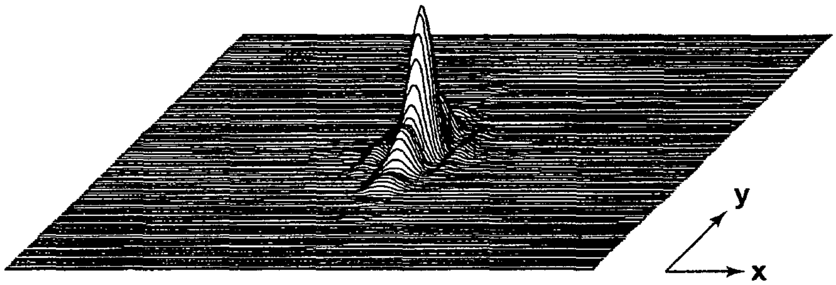


z=0.18mm

FIG. 20B

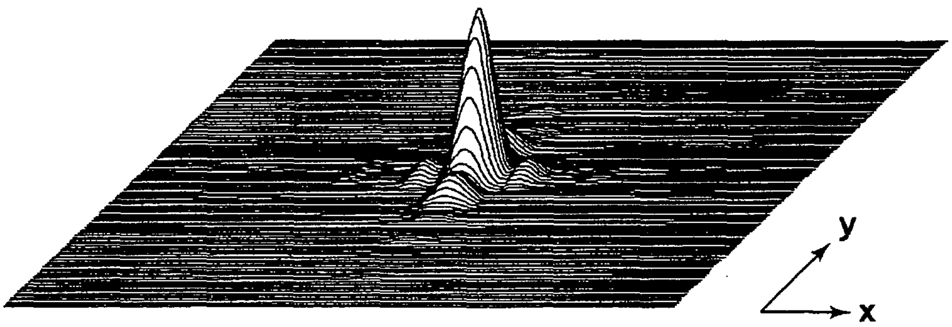


z=0.2mm

FIG. 20C

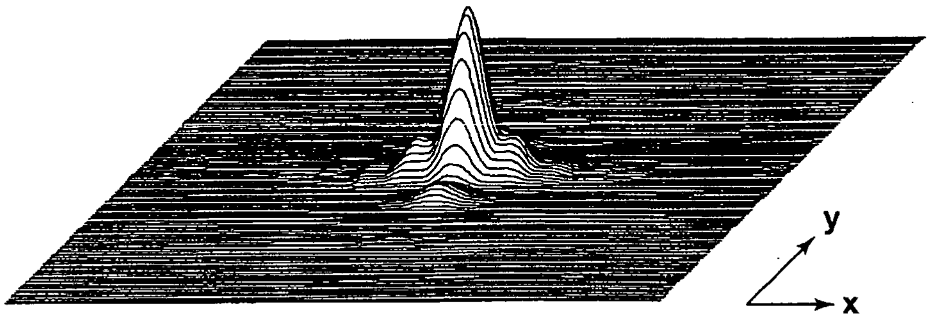


z=0.22mm

FIG. 20D

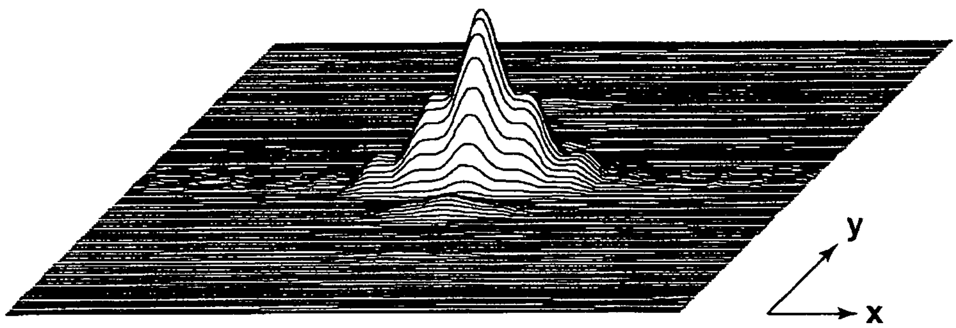


z=0.24mm

FIG. 21

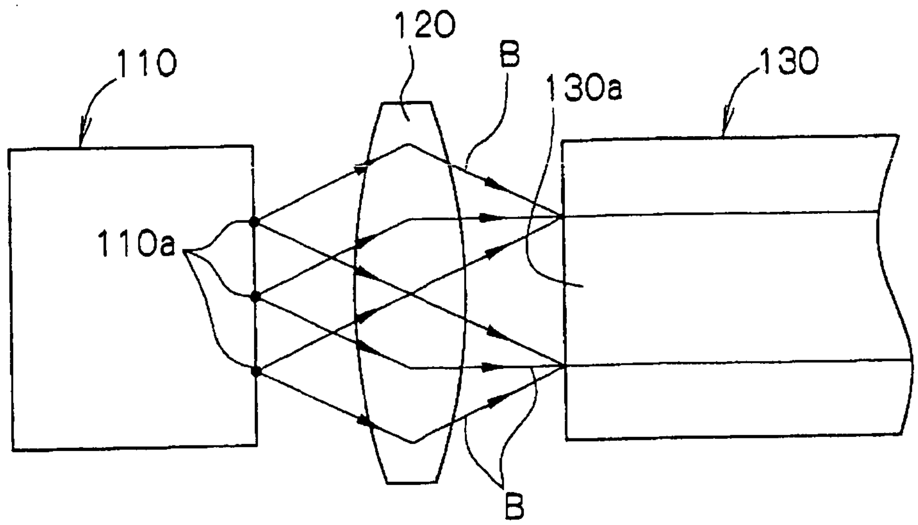


FIG. 22A

FIG. 22B

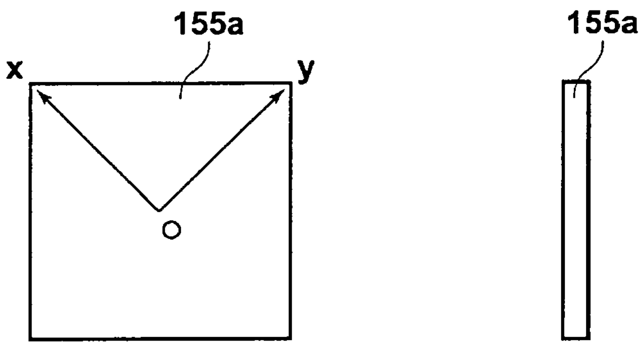

FIG. 23A

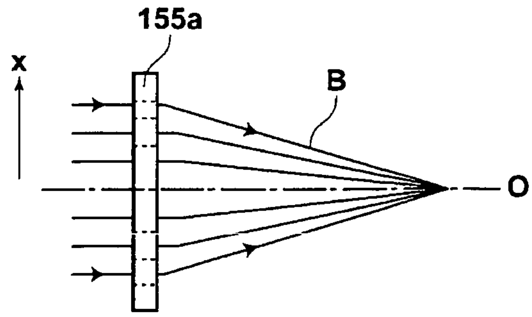


FIG. 23B

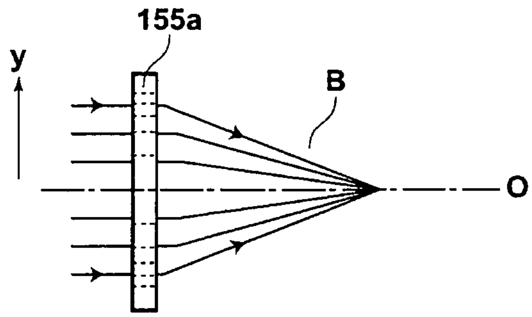

FIG. 24A

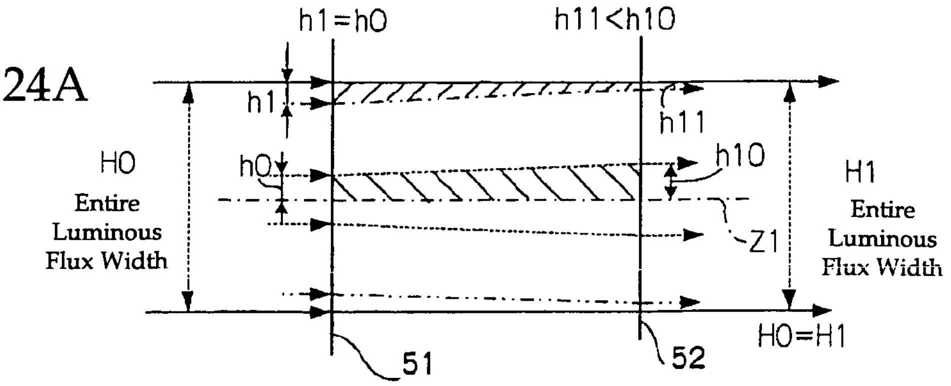


FIG. 24B

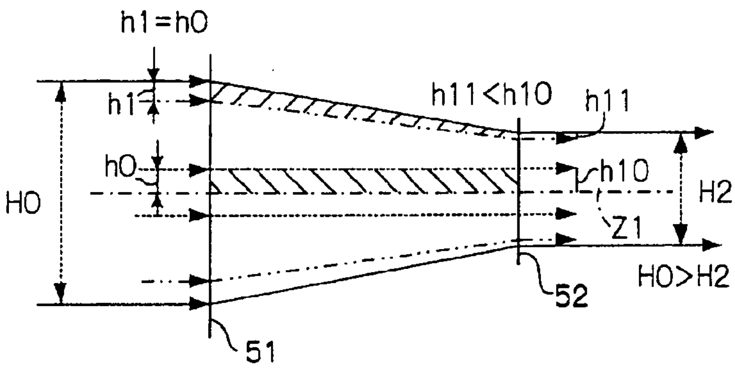


FIG. 24C

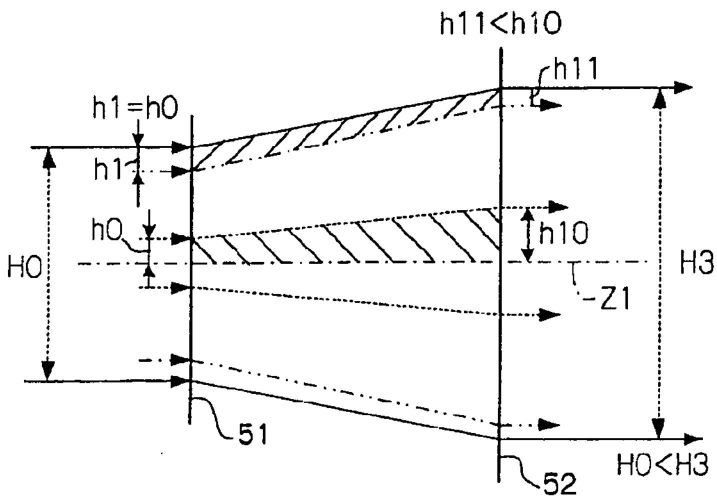

FIG. 25

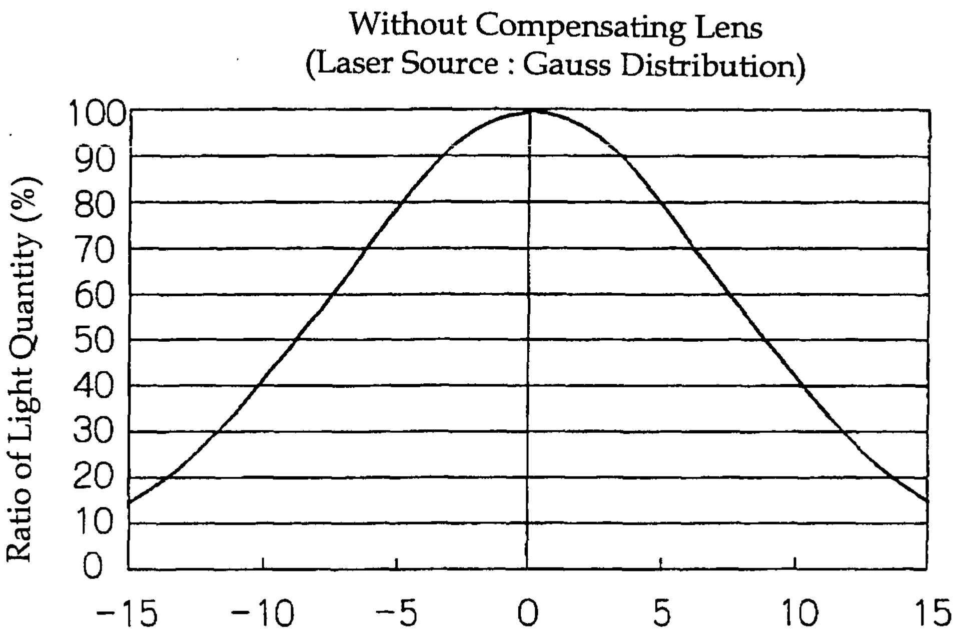
Without Compensating Lens
(Laser Source : Gauss Distribution)
Ratio of Light Quantity (%)
100
90
80
70
60
50
40
30
20
10
0
-15
-10
-5
0
5
10
15

FIG. 26

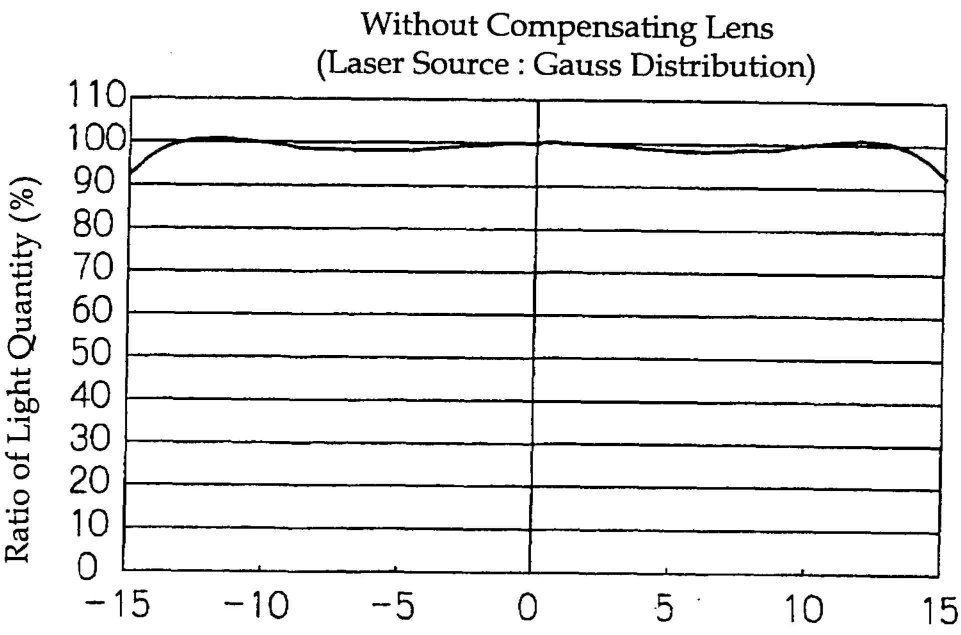
Without Compensating Lens
(Laser Source : Gauss Distribution)
Ratio of Light Quantity (%)
110
100
90
80
70
60
50
40
30
20
10
0
-15
-10
-5
0
5
10
15

FIG. 27A

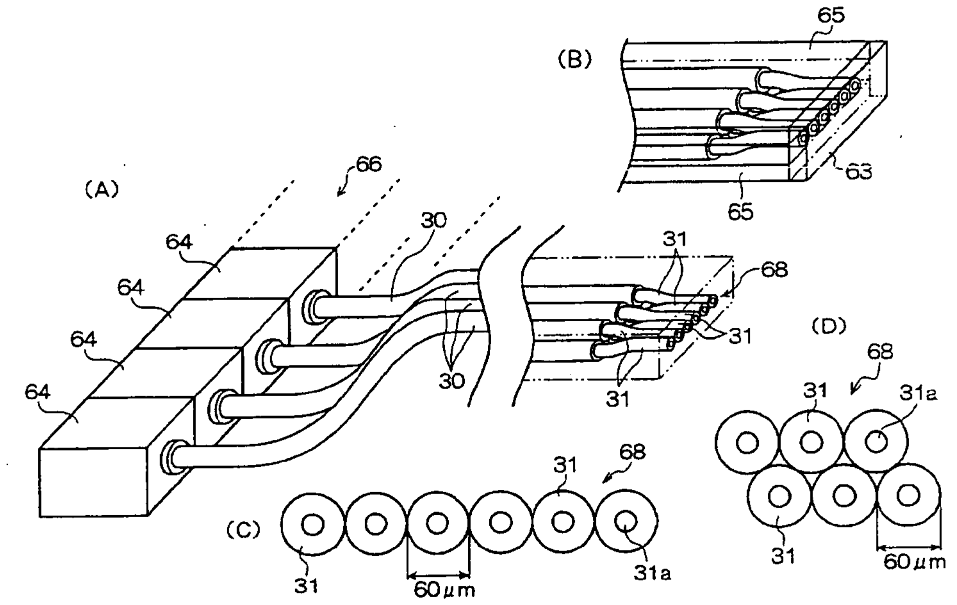


FIG. 27B

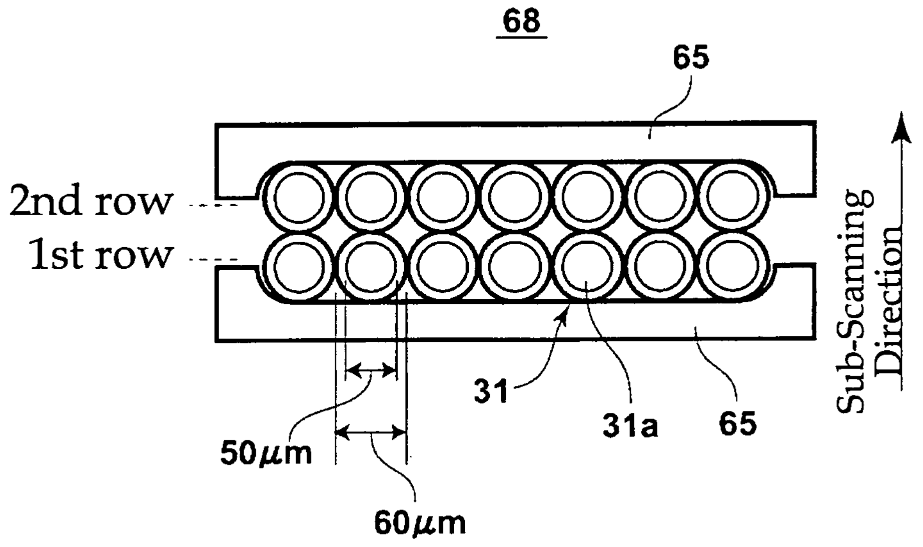

FIG. 28

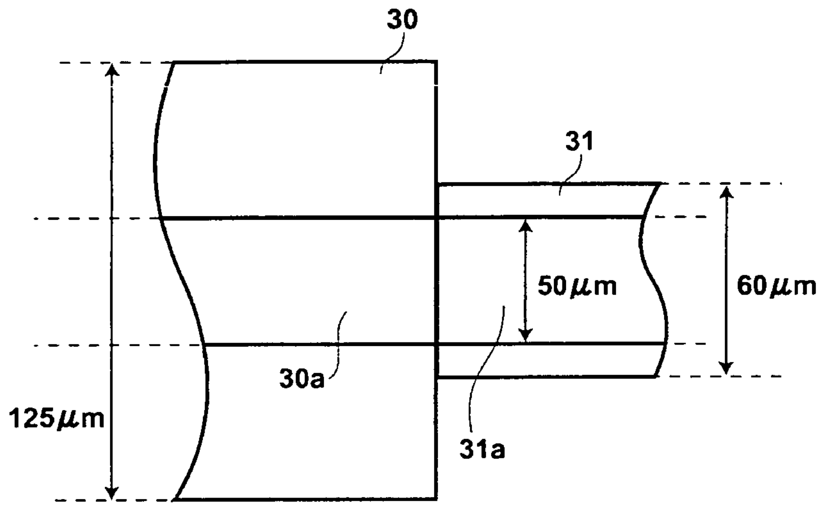
30
31
50μm
60μm
30a
125μm
31a

FIG. 29

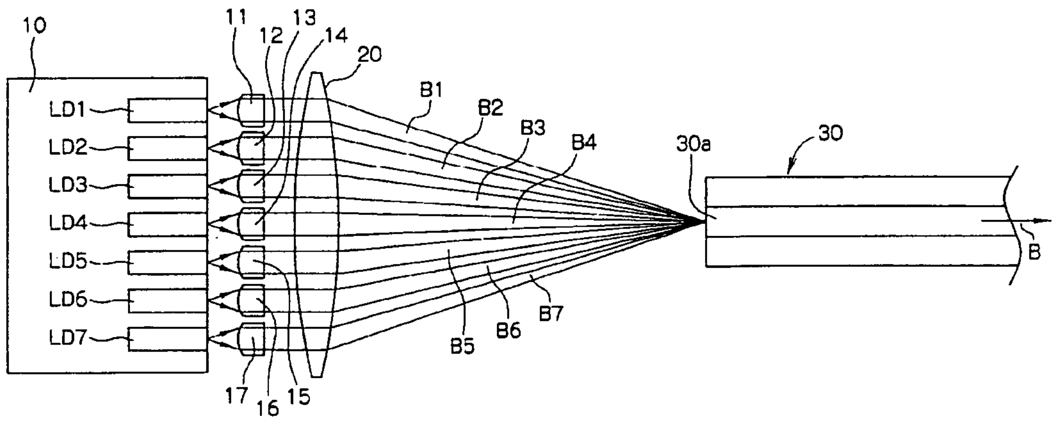
10
11
12
13
14
20
LD1
LD2
LD3
LD4
LD5
LD6
LD7
B1
B2
B3
B4
30a
30
B
B5
B6
B7
17
16
15

FIG. 30

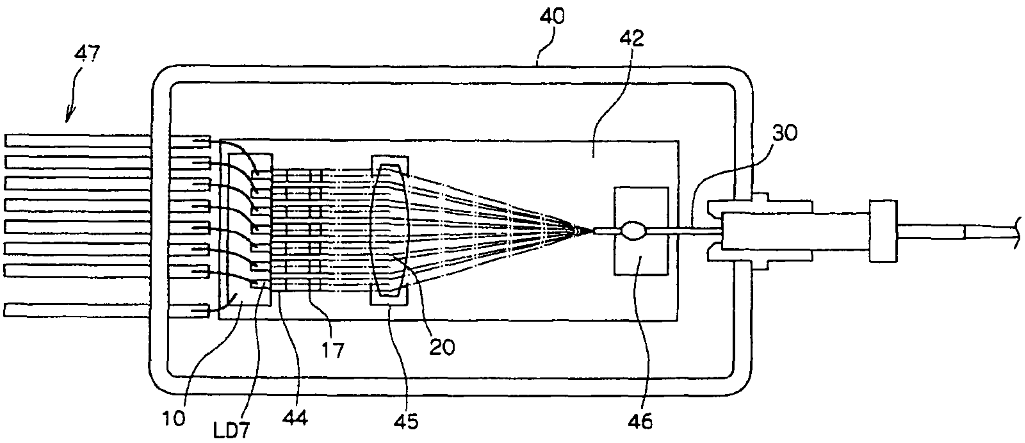
47
40
42
30
10
LD7
44
17
45
20
46

FIG. 31

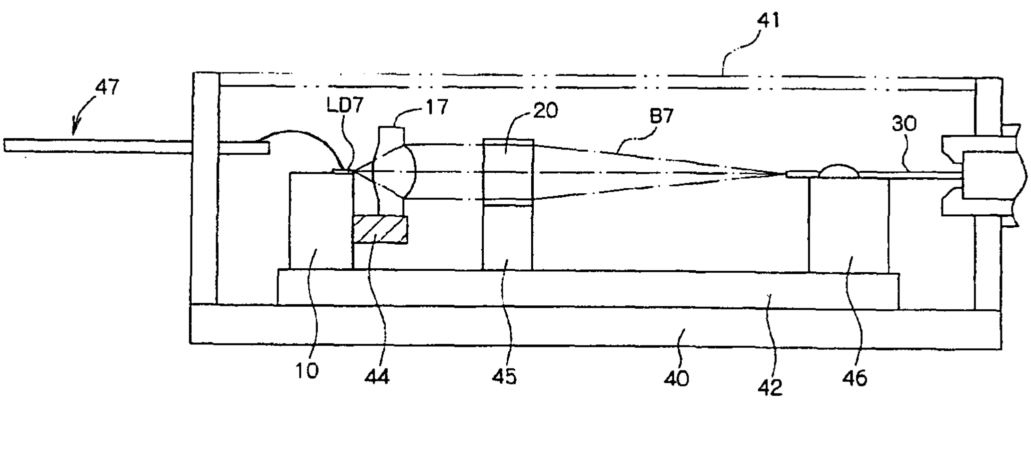
41
47
LD7
17
20
B7
30
10
44
45
40
42
46

# FIG. 32

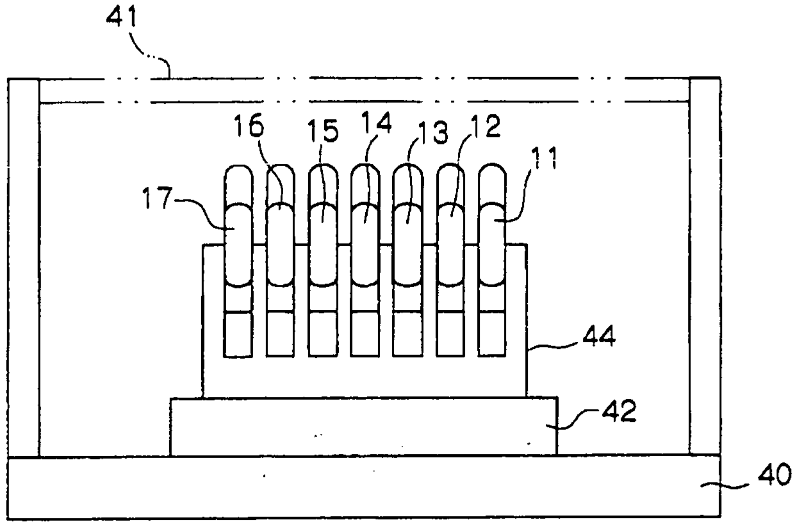


# FIG. 33

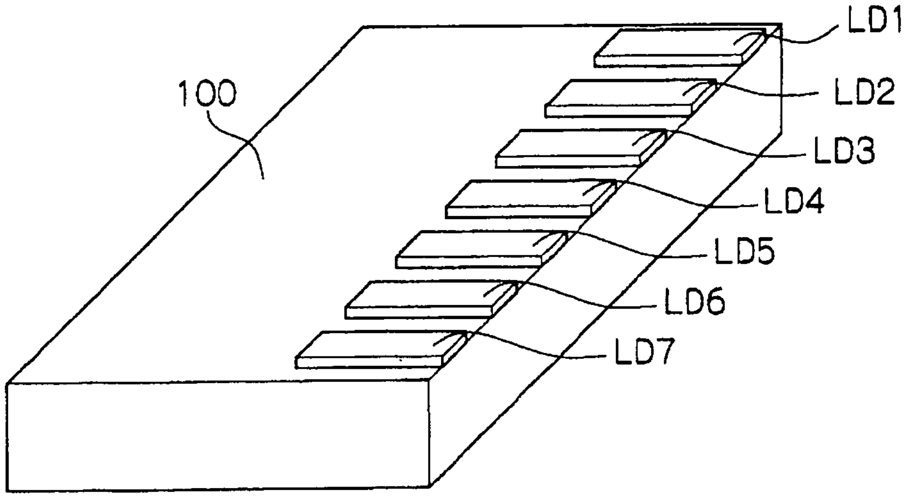

FIG. 34A

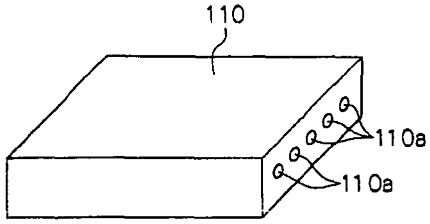


FIG. 34B

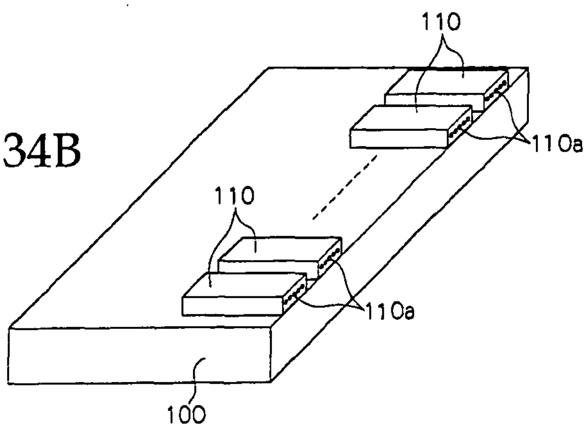


FIG. 35

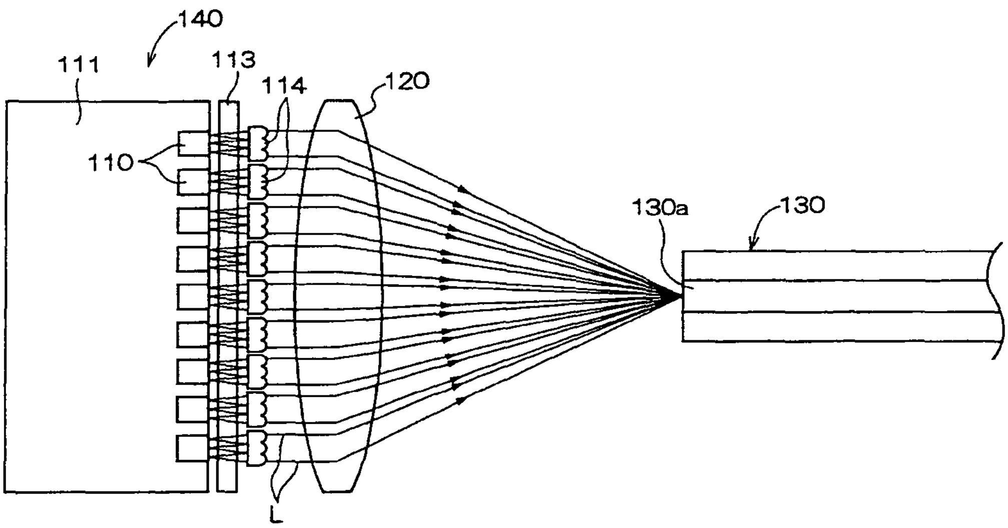

FIG. 36A

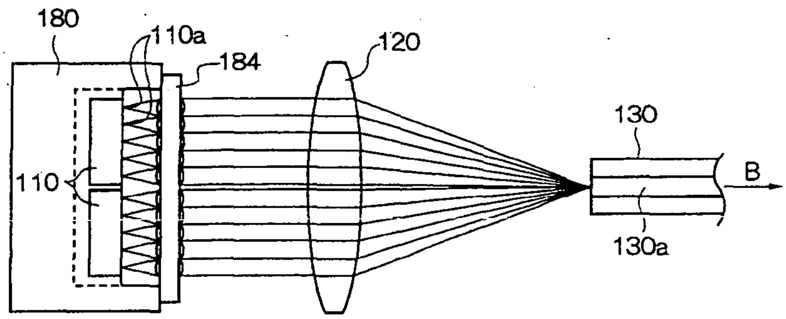


FIG. 36B

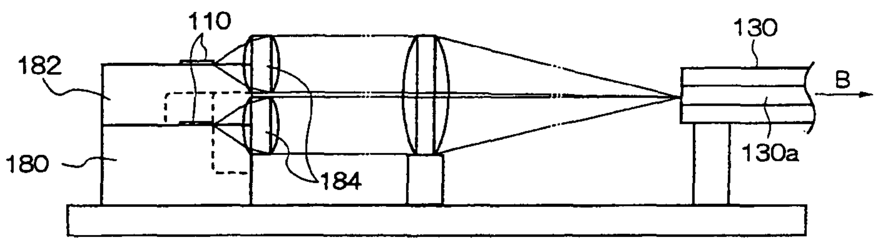


FIG. 37A

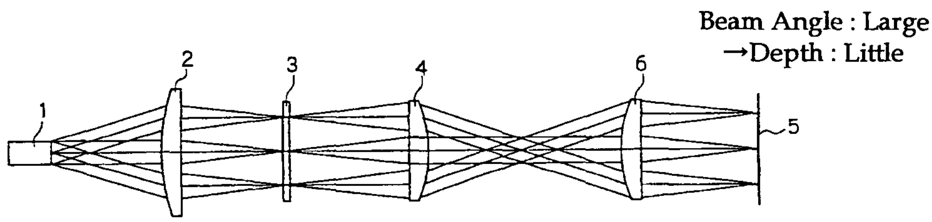


FIG. 37B

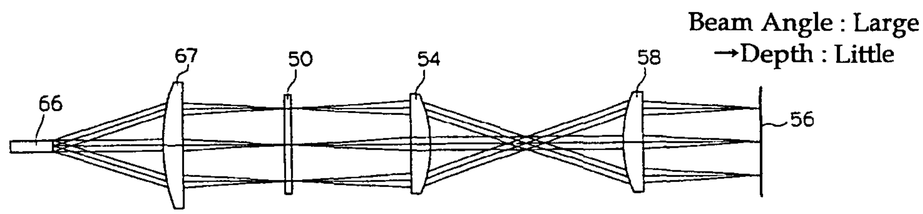

FIG. 38

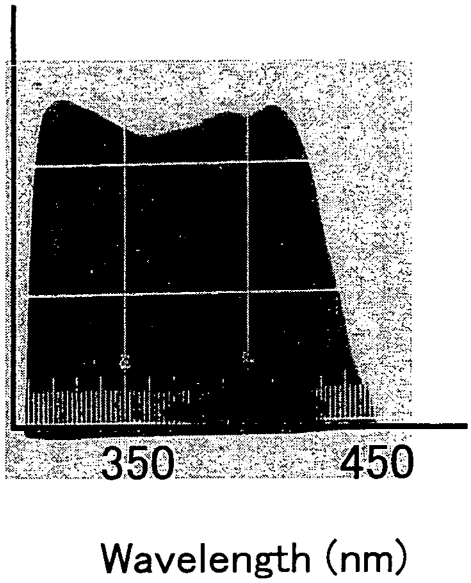
350
450
Wavelength (nm)

FIG. 39

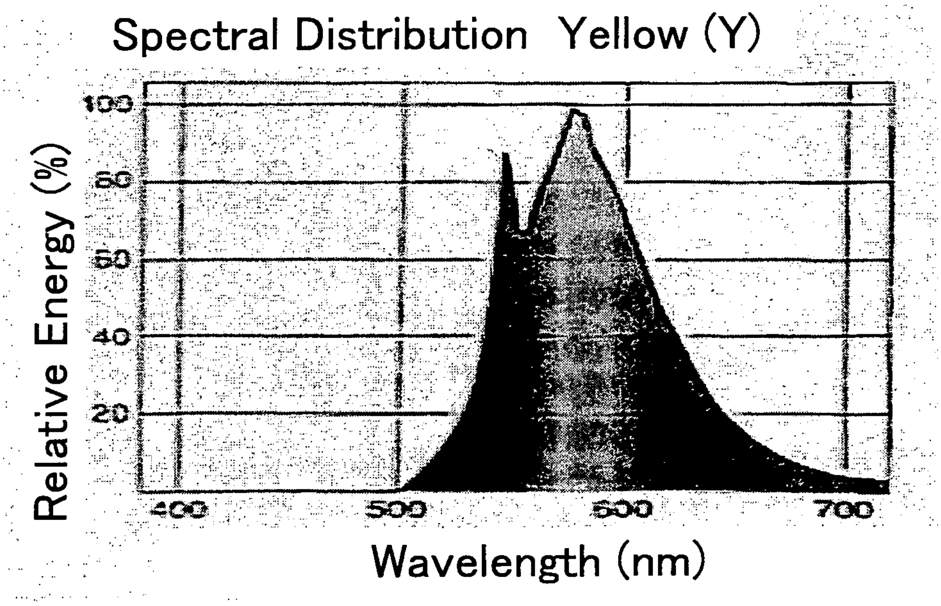
Spectral Distribution Yellow (Y)
Relative Energy (%)
100
80
60
40
20
400
500
600
700
Wavelength (nm)

**INTERNATIONAL SEARCH REPORT**

International application No.
PCT/JP2005/014937

A. CLASSIFICATION OF SUBJECT MATTER
*G03F7/004*(2006.01), *G03F7/11*(2006.01), *G03F7/20*(2006.01), *G02B5/20*(2006.01), *H01L21/027*(2006.01)

According to International Patent Classification (IPC) or to both national classification and IPC

B. FIELDS SEARCHED

Minimum documentation searched (classification system followed by classification symbols)
*G03F7/004*(2006.01), *G03F7/11*(2006.01), *G03F7/20*(2006.01), *G02B5/20*(2006.01), *H01L21/027*(2006.01)

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2001-13682 A (Hitachi Chemical Co., Ltd.), 19 January, 2001 (19.01.01), Full text (Family: none) | 1,2,6-9,13, 19 |
| X | JP 11-109617 A (Hitachi Chemical Co., Ltd.), 23 April, 1999 (23.04.99), Full text (Family: none) | 1,2,6-9,13, 19 |
| A | JP 10-333327 A (Hitachi Chemical Co., Ltd.), 18 December, 1998 (18.12.98), Full text (Family: none) | 1-19 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 19 October, 2005 (19.10.05) | 01 November, 2005 (01.11.05) |
| Name and mailing address of the ISA/ Japanese Patent Office | Authorized officer |
| Facsimile No. | Telephone No. |

Form PCT/ISA/210 (second sheet) (January 2005)

**INTERNATIONAL SEARCH REPORT**

International application No.
PCT/JP2005/014937

C (Continuation). DOCUMENTS CONSIDERED TO BE RELEVANT

| Category* | Citation of document, with indication, where appropriate, of the relevant passages | Relevant to claim No. |
|---|---|---|
| A | JP 10-198050 A (Konica Corp.), 31 July, 1998 (31.07.98), Full text (Family: none) | 1-19 |
| A | JP 7-175211 A (Konica Corp., Mitsubishi Chemical Corp.), 14 July, 1995 (14.07.95), Full text & EP 655653 A1 & US 5723256 A | 1-19 |
| A | JP 2004-1244 A (Fuji Photo Film Co., Ltd., Fuji Photo Optical Co., Ltd.), 08 January, 2004 (08.01.04), Full text & WO 2003/085457 A1 & US 2003/214571 A1 | 14-18 |
| A | JP 2001-305663 A (Noritsu Koki Co., Ltd.), 02 November, 2001 (02.11.01), Full text (Family: none) | 14-18 |

Form PCT/ISA/210 (continuation of second sheet) (January 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004001244 A
- JP 2001305663 A
- JP 2001500628 A
- JP 4208940 A
- JP 5080503 A
- JP 5173320 A
- JP 5072724 A
- JP 61285444 A
- JP 7020309 A
- JP 11072908 A
- JP 11109124 A
- JP 11174220 A
- JP 11338133 A
- JP 2000250222 A
- JP 2000250221 A
- JP 2000266925 A
- JP 2001142223 A
- JP 2003005364 A
- JP 2873889 B
- JP 51131706 A
- JP 52094388 A
- JP 61243869 A
- JP 6462375 A
- JP 2097513 A
- JP 3289656 A
- JP 2002296776 A
- JP 6295060 A
- JP 50059315 A
- JP 5070528 A
- JP 11288087 A
- JP 2097502 A
- JP 2003020310 A
- JP 11282155 A
- JP 48041708 B
- JP 50006034 B
- JP 51037193 A
- GB 1388492 A
- JP 53133428 A
- DD 3337024
- JP 62058241 A
- JP 5281728 A
- JP 5034920 A
- US 4212976 A
- JP 5019475 A
- JP 7271028 A
- JP 2002363206 A
- JP 2002363207 A
- JP 2002363208 A
- JP 2002363209 A
- JP 57001819 B
- JP 096 B
- US 3615455 A
- JP 2002263209 A
- JP 2001305734 A
- JP 5011439 A
- JP 5341532 A
- JP 6043638 A


### Non-patent literature cited in the description


- Shortening Developing Time and Application of Mass Production by means of Maskless Exposure. Electronics Implementation Technology. Gicho Publishing & Advertising Co., Ltd, 2002, vol. 18, 74-79
- **WAKABAYASHI.** *Bulletin of the Chemical Society of Japan,* 1969, vol. 42, 2924
- **F.C. SCHAEFER et al.** *Journal of Organic Chemistry,* 1964, vol. 29, 1527
- *Bulletin of the Chemical Society of Japan,* 1969, vol. 42, 2924